# EUROPÄISCHE PATENTSCHRIFT

(11) **EP 2 393 819 B1**
(45) Veröffentlichungstag und Bekanntmachung des Hinweises auf die Patenterteilung: **25.01.2017**
(21) Anmeldenummer: 09795397.0
(22) Anmeldetag: 14.12.2009
(51) Int. Cl.: C07F 7/08, C07F 9/572, C07F 9/655, C07F 9/6553, H01L 51/50, C09K 11/06

(54) **SILYL- UND HETEROATOM-SUBSTITUIERTE VERBINDUNGEN AUSGEWÄHLT AUS CARBAZOLEN, DIBENZOFURANEN, DIBENZOTHIOPHENEN UND DIBENZOPHOSPHOLEN UND IHRE ANWENDUNG IN DER ORGANISCHEN ELEKTRONIK**
SILYL AND HETEROATOM SUBSTITUTED COMPOUNDS SELECTED FROM CARBAZOLES, DIBENZOFURANS, DIBENZOTHIOPHENES AND DIBENZO PHOSPHOLES AND THE APPLICATION THEREOF IN ORGANIC ELECTRONICS
COMPOSÉS À SUBSTITUTION SILYLE ET HÉTÉROATOME SÉLECTIONNÉS PARMI LES CARBAZOLES, DIBENZOFURANES, DIBENZOTHIOPHÈNES ET DIBENZOPHOSPHOLES, ET LEUR UTILISATION DANS L'ÉLECTRONIQUE ORGANIQUE

(30) Priorität: 07.01.2009 EP 09150176; 07.01.2009 EP 09150181
(43) Veröffentlichungstag der Anmeldung: 14.12.2011
(73) Patentinhaber: BASF SE, 67056 Ludwigshafen am Rhein (DE); OSRAM Opto Semiconductors GmbH, 93055 Regensburg (DE); OLEDWorks GmbH, 52068 Aachen (DE); Philips Intellectual Property & Standards GmbH, 52066 Aachen (DE)
(72) Erfinder: LANGER, Nicolle, 64646 Heppenheim (DE); SCHILDKNECHT, Christian, 68305 Mannheim (DE); Dr.-Ing. WATANABE, Soichi, 68165 Mannheim (DE); Dr. FUCHS, Evelyn, 68199 Mannheim (DE); WAGENBLAST, Gerhard, 67157 Wachenheim (DE); LENNARTZ, Christian, 67105 Schifferstadt (DE); Dr. MOLT, Oliver, 69469 Wienheim (DE); DORMANN, Korinna, 67098 Bad Duerkheim (DE); LOH, Chuanjie, 67227 Frankenthal (DE); HUNZE, Arvid, 91056 Erlangen (DE); KRAUSE, Ralf, 91058 Erlangen (DE); SCHMID, Günter, 91334 Hemhofen (DE); HEUSER, Karsten, 91056 Erlangen (DE); ELSBERGEN, VAN, Volker, 52080 Aachen (DE); BOERNER, Herbert, Friedrich, 52076 Aachen (DE); KIRSCH, Stefan, 80639 München (DE)
(74) Vertreter: Hollah, Dorothee
(86) Internationale Anmeldenummer: PCT/EP2009/067120
(87) Internationale Veröffentlichungsnummer: WO 2010/079051

(56) Entgegenhaltungen:
- US-A1- 2007 224 446
- US-A1- 2007 262 704

## Beschreibung

Die vorliegende Erfindung betrifft Silyl- und Heteroatom-substituierte Verbindungen, ausgewählt aus Carbazolen, Dibenzofuranen, Dibenzothiophenen und Disilylbenzophospholen der Formeln (I) oder (I*), die Verwendung der Verbindungen der Formeln (I) oder (I*) in organisch-elektronischen Anwendungen, bevorzugt in organischen Leuchtdioden, eine organische Leuchtdiode enthaltend mindestens eine Verbindung der Formel (I) oder (I*), eine Licht-emittierende Schicht enthaltend mindestens eine Verbindung der Formel (I) oder (I*), eine Blockschicht für Löcher/Excitonen enthaltend mindestens eine Verbindung der Formel (I) oder (I*) sowie eine Vorrichtung ausgewählt aus der Gruppe bestehend aus stationären Bildschirmen, mobilen Bildschirmen, Beleuchtungseinheiten, Tastaturen, Kleidungsstücken, Möbeln und Tapeten, enthaltend mindestens eine erfindungsgemäße organische Leuchtdiode.

Die organische Elektronik ist ein Teilgebiet der Elektronik, das elektronische Schaltungen verwendet, die Polymere oder kleinere organische Verbindungen aufweisen. Anwendungsbereiche der organischen Elektronik sind der Einsatz von Polymeren oder kleineren organischen Verbindungen in organischen Leuchtdioden (OLEDs), die Anwendung in organischen Solarzellen (organische Photovoltaik), sowie in schaltenden Elementen wie organischen Transistoren, z. B. organischen FET und organischen TFT.

Durch den Einsatz geeigneter neuartiger organischer Materialien können somit verschiedene neuartige Bauelemente, die auf organischer Elektronik basieren, wie Displays, Sensoren, Transistoren, Datenspeicher oder Photovoltaik-Zellen bereitgestellt werden. Dadurch ist die Entwicklung neuer Anwendungen, die dünn, leicht, flexibel und zu niedrigen Kosten herstellbar sind, möglich.

Ein bevorzugter Anwendungsbereich gemäß der vorliegenden Anmeldung ist der Einsatz von kleineren organischen Verbindungen in organischen Leuchtdioden.

In organischen Leuchtdioden (OLED) wird die Eigenschaft von Materialien ausgenutzt, Licht zu emittieren, wenn sie durch elektrischen Strom angeregt werden. OLEDs sind insbesondere interessant als Alternative zu Katodenstrahlröhren und Flüssigkristalldisplays zur Herstellung von Flachbildschirmen. Aufgrund der sehr kompakten Bauweise und des intrinsisch niedrigen Stromverbrauchs eignen sich die Vorrichtungen enthaltend OLEDs insbesondere für mobile Anwendungen, z. B. für Anwendungen in Handys, Laptops usw. sowie zur Beleuchtung.

Die Grundprinzipien der Funktionsweise von OLEDs sowie geeignete Aufbauten (Schichten) von OLEDs sind z. B. in WO 2005/113704 und der darin zitierten Literatur genannt.

Als Licht-emittierende Materialien (Emitter) können neben fluoreszierenden Materialien (Fluoreszenz-Emitter) phosphoreszierende Materialien (Phosphoreszenz-Emitter) eingesetzt werden. Bei den Phosphoreszenz-Emittern handelt es sich üblicherweise um metallorganische Komplexe, die im Gegensatz zu den Fluoreszenz-Emittern, die eine Singulett-Emission zeigen, eine Triplett-Emission zeigen (M. A. Baldow et al., Appl. Phys. Lett. 1999, 75, 4 bis 6). Aus quantenmechanischen Gründen ist bei Verwendung der Phosphoreszenz-Emitter eine bis zu vierfache Quanten-, Energie- und Leistungseffizienz möglich.

Von besonderem Interesse sind organische Leuchtdioden mit langer operativer Lebensdauer, guter Effizienz, hoher Stabilität gegenüber Temperaturbelastung sowie einer niedrigen Einsatz- und Betriebsspannung.

Um die vorstehend erwähnten Eigenschaften in die Praxis umzusetzen, ist es nicht nur erforderlich, geeignete Emittermaterialien bereitzustellen, sondern auch die anderen Komponenten der OLED (Komplementärmaterialien) müssen in geeigneten Device-Kompositionen aufeinander abgestimmt sein. Solche Device-Kompositionen können z. B. spezielle Matrixmaterialien enthalten, in denen der eigentliche Lichtemitter in verteilter Form vorliegt. Des Weiteren können die Kompositionen Blockermaterialien enthaltnen, wobei Loch-, Excitonen- und/oder Elektronenblocker in den Device-Kompositionen vorliegen können. Daneben oder alternativ können die Device-Kompositionen des Weiteren Loch-Injektionsmaterialien und/oder Elektronen-Injektionsmaterialien und/oder Ladungstransportmaterialien wie Lochleitermaterialien und/oder Elektronenleitermaterialien aufweisen. Dabei hat die Auswahl der vorstehend genannten Materialien, die in Kombination mit dem eigentlichen Lichtemitter eingesetzt werden, einen wesentlichen Einfluss u. a. auf die Effizienz sowie die Lebensdauer und die Einsatz- und Betriebsspannung der OLEDs.

Im Stand der Technik werden zahlreiche verschiedene Materialien für den Einsatz in verschiedenen Schichten von OLEDs vorgeschlagen.

US 2008/0171227 A1 betrifft eine Silanylamin-basierte Verbindung der Formel (I) sowie eine OLED enthaltend die Silanylamin-basierte Verbindung.

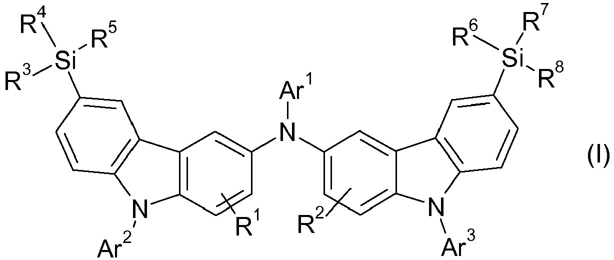

Die Silanylamin-basierte Verbindung, die zwei Silangruppen und zwei oder mehr Carbazolgruppen aufweist, weist elektrische Stabilität, gute Ladungstransportfähigkeiten und eine hohe Glasübergangstemperatur auf und kann als Lochinjektionsmaterial, Lochtransportmaterial und/oder emittierendes Material verwendet werden.

EP 1 921 082 A1 betrifft eine Silanylamin-basierte Verbindung der Formel (I) sowie organische Leuchtdioden, die eine Silanylamin-basierte Verbindung der Formel (I) enthalten.

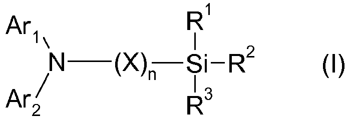

Die Silanylamin-basierte Verbindung der Formel (I) kann als Lochinjektionsschicht, Lochtransportschicht oder als eine einzige Schicht, die sowohl Lochinjektions- als auch Lochtransport-Eigenschaften aufweist, eingesetzt werden. Des Weiteren kann die Silanylamin-basierte Verbindung der Formel (I) in einer emittierenden Schicht eingesetzt werden, die zusätzlich phosphoreszierendes oder fluoreszierendes Material enthalten kann.

JP 2006-321750 A betrifft aromatische Verbindungen, z. B. Dibenzofuran-Derivate, Dibenzothiophen-Derivate oder Carbazol-Derivate der Formel (1-1)

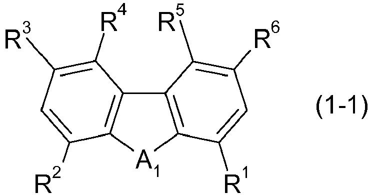

Die Verbindungen der Formel (1-1) können gemäß JP 2006-321750 A als Zwischenprodukte für Arzneimittel, Ladungstransportmaterial oder lumineszierendes Material eingesetzt werden.

US 2007/0224446 A1 betrifft Verbindungen, die für den Einsatz in organischen Leuchtdioden geeignet sind, wobei die Verbindungen die allgemeine Formel (I) aufweisen.

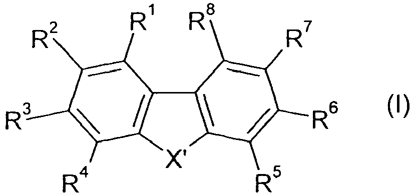

Bei den Resten R¹ bis R⁸ in Formel (I) kann es sich u. a. um Arylsilylgruppen mit 8 bis 40 Kohlenstoffatomen handeln. Gemäß den Beispielen in US 2007/0224446 A1 wird eine Verbindung der Formel (I) als Matrixmaterial in einer Licht-emittierenden Schicht eingesetzt.

US 2007/262704 A1 betrifft Silylverbindungen und ihre Anwendung in der Elektronik. Unter anderem sind in US 2007/262704 A1 Carbazol-Derivate offenbart, die mit einer Silylgruppe substituiert sein können.

Aus dem Stand der Technik ergibt sich somit, dass Carbazol-, Dibenzofuran- sowie Dibenzothiophen-Derivate bekannt sind, die insbesondere als Lochinjektionsmaterial, Lochtransportmaterial sowie gegebenenfalls als Matrixmaterial in einer Licht-emittierenden Schicht eingesetzt werden.

Aufgabe der vorliegenden Erfindung gegenüber dem vorstehend genannten Stand der Technik ist die Bereitstellung von weiteren, für den Einsatz in OLEDs und weiteren Anwendungen in der organischen Elektronik geeigneten Materialien. Insbesondere sollen Loch-/Excitonenblockermaterialien sowie Matrixmaterialien für den Einsatz in OLEDs bereitgestellt werden. Die Materialien sollen insbesondere für OLEDs geeignet sein, die mindestens einen Phosphoreszenz-Emitter, insbesondere mindestens einen Grün- oder mindestens einen Blauemitter, enthalten. Des Weiteren sollen die Materialien zur Bereitstellung von OLEDs geeignet sein, die gute Effizienzen, gute operative Lebensdauern sowie eine hohe Stabilität gegenüber Temperaturbelastung und eine niedrige Einsatz- und Betriebsspannung der OLEDs gewährleisten.

Diese Aufgabe wird gelöst durch die Bereitstellung von Verbindungen der Formel (I) oder (I*) 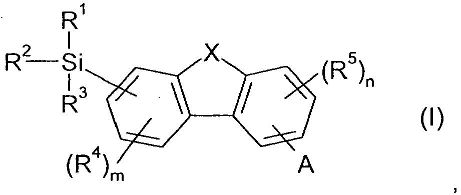 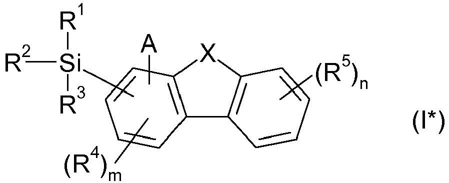 worin bedeuten
- X: NR, S, O oder PR;
- R: Aryl, Heteroaryl, Alkyl, Cycloalkyl oder Heterocycloalkyl;
- A: -NR⁶R⁷, -P(O)R⁸R⁹, -PR¹⁰R¹¹, -S(O)₂R¹², -S(_{O})R¹³, -SR¹⁴ oder -OR¹⁵;
- R¹, R², R³: unabhängig voneinander Aryl, Heteroaryl, Alkyl, Cycloalkyl, Heterocycloalkyl, über einen Spacer angebundene vernetzbare oder polymerisierbare Gruppe, wobei wenigstens einer der Reste R¹, R², R³ mindestens zwei Kohlenstoffatome enthält, oder OR²²,
- R⁴, R⁵: unabhängig voneinander Alkyl, Cycloalkyl, Heterocycloalkyl, Aryl, Heteroaryl, über einen Spacer angebundene vernetzbare oder polymerisierbare Gruppe, eine Gruppe A oder eine Gruppe mit Donor- oder Akzeptorwirkung;
- n, m: unabhängig voneinander 0, 1, 2, 3;
- R⁶, R⁷: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, über einen Spacer angebundene vernetzbare oder polymerisierbare Gruppe, und einer Gruppe mit Donor- oder Akzeptorwirkung substituiert sein können;
- R²²: unabhängig voneinander SiR²³R²⁴R²⁵, Aryl, Heteroaryl, Alkyl, Cycloalkyl oder Heterocycloalkyl, über einen Spacer angebundene vernetzbare oder polymerisierbare Gruppe, gegebenenfalls substituiert mit einer Gruppe OR²⁸,
- R²⁸: unabhängig voneinander SiR²³R²⁴R²⁵, Heteroaryl, Alkyl, Cycloalkyl oder Heterocycloalkyl, über einen Spacer angebundene vernetzbare oder polymerisierbare Gruppe,
- R⁸ R⁹, R¹⁰, R¹¹, R¹², R¹³, R¹⁴, R¹⁵, R²³, R²⁴, R²⁵: unabhängig voneinander Aryl, Heteroaryl, Alkyl, Cycloalkyl oder Heterocycloalkyl, über einen Spacer angebundene vernetzbare oder polymerisierbare Gruppe
oder
zwei Einheiten der allgemeinen Formeln (I) und/oder (I*) sind über eine lineare oder verzweigte, gesättigte oder ungesättigte, gegebenenfalls durch wenigstens ein Heteroatom unterbrochene Verbrückung oder über O miteinander verbrückt, wobei diese Verbrückung in den allgemeinen Formeln (I) und/oder (I*) jeweils anstelle von R² an die Si-Atome angebunden ist.

Die erfindungsgemäße Aufgabe wird auch gelöst durch Verbindungen der Formel (I) 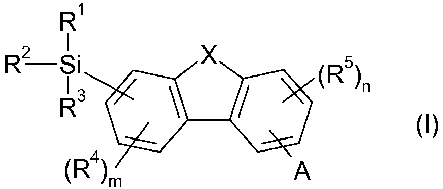 worin bedeuten
- X: NR, S, O oder PR;
- R: Aryl, Heteroaryl, Alkyl, Cycloalkyl oder Heterocycloalkyl;
- A: -NR⁶R⁷, -P(O)R⁸R⁹, -PR¹⁰R¹¹, -S(O)₂R¹², -S(O)R¹³, -SR¹⁴ oder -OR¹⁵;
- R¹, R², R³: unabhängig voneinander Aryl, Heteroaryl, Alkyl, Cycloalkyl oder Heterocycloalkyl, wobei mindestens einer der Reste R¹, R² oder R³ Aryl oder Heteroaryl bedeutet;
- R⁴, R⁵: unabhängig voneinander Alkyl, Cycloalkyl, Heterocycloalkyl, Aryl, Heteroaryl, eine Gruppe A oder eine Gruppe mit Donor- oder Akzeptorwirkung;
- n, m: unabhängig voneinander 0, 1, 2, 3;
- R⁶, R⁷: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können;
- R⁸, R⁹, R¹⁰, R¹¹, R¹², R¹³, R¹⁴, und R¹⁵,: unabhängig voneinander Aryl, Heteroaryl, Alkyl, Cycloalkyl oder Heterocycloalkyl.

Es wurde gefunden, dass die speziellen Silyl- und Heteroatom-substituierten Verbindungen der Formel (I) oder (I*) besonders gut für den Einsatz in Anwendungen geeignet sind, bei denen eine Ladungsträgerleitfähigkeit erforderlich ist, insbesondere für den Einsatz in organisch-elektronischen Anwendungen, z. B. ausgewählt aus schaltenden Elementen wie organischen Transistoren, z. B. organischen FET und organischen TFT, organischen Solarzellen und organischen Leuchtdioden (OLED), wobei die Verbindungen der Formel (I) oder (I*) in OLEDs für den Einsatz als Matrixmaterial in einer Licht-emittierenden Schicht und/oder als Loch- und/oder Excitonenblockermaterial und/oder als Elektronen- und/oder Excitonenblockermaterial besonders geeignet sind, insbesondere in Kombination mit einem Phosphoreszenz-Emitter. Bei Einsatz der erfindungsgemäßen Verbindungen der Formel (I) oder (I*) in OLEDs werden OLEDs erhalten, die gute Effizienzen und eine lange Lebensdauer aufweisen und die insbesondere bei einer niedrigen Einsatz- und Betriebsspannung betrieben werden können. Die erfindungsgemäßen Verbindungen der Formel (I) oder (I*) sind insbesondere für den Einsatz als Matrix- und/oder Loch-/Excitonenblockermaterialien für Blau- und Grünemitter, beispielsweise hellblaue oder tiefblaue Emitter, wobei diese insbesondere Phosphoreszenz-Emitter sind, geeignet. Weiterhin können die Verbindungen der Formel (I) oder (I*) als Leiter/Komplementärmaterialien in organisch-elektronischen Anwendungen ausgewählt aus schaltenden Elementen und organischen Solarzellen eingesetzt werden.

Im Sinne der vorliegenden Anmeldung haben die Begriffe Arylrest oder -gruppe, Heteroarylrest oder -gruppe, Alkylrest oder -gruppe, Cycloalkylrest oder -gruppe, Heterocycloalkylrest oder -gruppe, Alkenylrest oder -gruppe, Alkinylrest oder -gruppe, Aralkylrest oder-gruppe, und Gruppen mit Donor- und/oder Akzeptorwirkung die folgenden Bedeutungen:
Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl, Indenyl oder Fluorenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein.

Geeignete Substituenten sind zum Beispiel Deuterium, Alkoxyreste, Aryloxyreste, Alkylaminogruppen, Arylaminogruppen, Carbazoylgruppen, Silylgruppen, SiR¹⁶R¹⁷R¹⁸, wobei geeignete Silylgruppen SiR¹⁶R¹⁷R¹⁸ nachstehend genannt sind, Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste und Carbazolylreste, Alkenylreste, bevorzugt Alkenylreste, die eine Doppelbindung tragen, besonders bevorzugt Alkenylreste mit einer Doppelbindung und 1 bis 8 Kohlenstoffatomen, Alkinylreste, bevorzugt Alkinylreste mit einer Dreifachbindung, besonders bevorzugt Alkinylreste mit einer Dreifachbindung und 1 bis 8 Kohlenstoffatomen oder Gruppen mit Donor- oder Akzeptorwirkung oder über einen Spacer angebundene vernetzbare oder polymerisierbare Gruppen. Geeignete Gruppen, mit Donor- oder Akzeptorwirkung sind nachstehend genannt. Ganz besonders bevorzugt tragen die substituierten Arylreste Substituenten ausgewählt aus der Gruppe bestehend aus Methyl, Ethyl, Isopropyl, Alkoxy, Heteroaryl, Halogen, Pseudohalogen und Amino, bevorzugt Arylamino. Bevorzugt ist der Arylrest oder die Arylgruppe ein C₆-C₁₈-Arylrest, besonders bevorzugt ein C₆-Arylrest, der gegebenenfalls mit mindestens einem oder mehreren der vorstehend genannten Substituenten substituiert ist. Besonders bevorzugt weist der C₆-C,₈-Arylrest, bevorzugt C₆-Arylrest, keinen, einen, zwei, drei oder vier, ganz besonders bevorzugt keinen, einen oder zwei der vorstehend genannten Substituenten auf.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist, sowie dadurch, dass das Grundgerüst der Heteroarylreste bevorzugt 5 bis 18 Ringatome aufweist. Bevorzugte Heteroatome sind N, O und S. Besonders bevorzugt geeignete Heteroarylreste sind stickstoffhaltige Heteroarylreste. Ganz besonders bevorzugt sind ein oder zwei Kohlenstoffatome des Grundgerüsts durch Heteroatome, bevorzugt Stickstoff, ersetzt. Insbesondere bevorzugt ist das Grundgerüst ausgewählt aus Systemen wie Pyridin, Pyrimidin und fünfgliedrigen Heteroaromaten wie Pyrrol, Furan, Pyrazol, Imidazol, Thiophen, Oxazol, Thiazol, Triazol. Des Weiteren kann es sich bei den Heteroarylresten um kondensierte Ringsysteme handeln, z. B. um Benzofuryl,- Benzothienyl-, Benzopyrrolyl-, Dibenzofuryl-, Dibenzothienyl-, Phenanthrolinyl-, Carbazolylreste, Azacarbazolylreste oder Diazacarbazoylreste. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8, ganz besonders bevorzugt 1 bis 4 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Des Weiteren können die erfindungsgemäß vorliegenden Alkylreste wenigstens ein Halogenatom, beispielsweise F, Cl, Br oder I, insbesondere F, aufweisen. In einer weiteren Ausführungsform können die erfindungsgemäß vorliegenden Alkyreste vollständig fluoriert sein. Es ist ebenfalls möglich, dass der Alkylrest eine oder mehrere (Hetero-)-Arylgruppen trägt. Im Sinne der vorliegenden Anmeldung stellen z. B. Benzylreste somit substituierte Alkylreste dar. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl und Ethyl.

Unter einem Cycloalkylrest oder einer Cycloalkylgruppe ist ein Rest mit 3 bis 20 Kohlenstoffatomen, bevorzugt 3 bis 10 Kohlenstoffatomen, besonders bevorzugt 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Es ist ebenfalls möglich, dass der Cycloalkylrest eine oder mehrere (Hetero-)Arylgruppen trägt. Beispiele für geeignete Cycloalkylreste sind Cyclopropyl, Cyclopentyl und Cyclohexyl.

Unter einem Heterocycloalkylrest oder einer Heterocycloalkylgruppe sind Reste zu verstehen, die sich von den vorstehend genannten Cycloalkylresten dadurch unterscheiden, dass in dem Grundgerüst der Cycloalkylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Cycloalkylreste durch Heteroatome ersetzt. Beispiele für geeignete Heterocycloalkylreste sind Reste abgeleitet von Pyrrolidin, Piperidin, Piperazin, Tetrahydrofuran, Dioxan.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Unter einer Gruppe SiR¹⁶R¹⁷R¹⁸ ist ein Silylrest zu verstehen, worin
- R¹⁶, R¹⁷ und R¹⁸: unabhängig voneinander Alkyl, Cycloalkyl, Heterocycloalkyl, Aryl, Heteroaryl oder OR²² bedeuten.

Unter einer Gruppe SiR²³R²⁴R²⁵ ist ein Silylrest zu verstehen, worin
- R²³, R²⁴ und R²⁵: unabhängig voneinander Alkyl, Cycloalkyl, Heterocycloalkyl, Aryl, Heteroaryl oder OR²² bedeuten.

Unter einer Gruppe oder einem Substituenten mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Bevorzugte geeignete Gruppen sind ausgewählt aus C₁-C₂₀-Alkoxy, C₆-C₃₀-Aryloxy, C₁-C₂₀-Alkylthio, C₆-C₃₀-Arylthio, SiR¹⁹R²⁰R²¹, OR²², Halogenresten, halogenierten C₁-C₂₀-Alkylresten, Carbonyl (-CO(R¹⁹)), Carbonylthio (- C = O (SR¹⁹)), Carbonyloxy (- C = O(OR¹⁹)), Oxycarbonyl (-OC = O(R¹⁹)), Thiocarbonyl (- SC = O(R¹⁹)), Amino (-NR¹⁹R²⁰), Pseudohalogenresten, Amido (- C = O (NR¹⁹)), -NR¹⁹C = O (R²¹), Phosphonat (- P(O) (OR¹⁹)₂, Phosphat (-OP(O) (OR¹⁹)₂), Phosphin (-PR¹⁹R²⁰), Phosphinoxid (-P(O)R¹⁹₂), Sulfat (-OS(O)₂OR¹⁹), Sulfoxid (-S(O)R¹⁹), Sulfonat (-S(O)₂OR¹⁹), Sulfonyl (-S(O)₂R¹⁹, Sulfonamid (-S(O)₂NR¹⁹R²⁰), NO₂, Boronsäureestern (-OB(OR¹⁹)₂), Imino (-C = NR¹⁹R²⁰)), Boranresten, Stannanresten, Hydrazinresten, Hydrazonresten, Oximresten, Nitroso-Gruppen, Diazo-Gruppen, Vinylgruppen, Sulfoximinen, Alanen, Germanen, Boroximen und Borazinen.

Die in den vorstehend genannten Gruppen mit Donor- oder Akzeptorwirkung erwähnten Reste R¹⁹, R²⁰ und R²¹ bedeuten unabhängig voneinander:
Substituiertes oder unsubstituiertes C₁-C₂₀-Alkyl oder substituiertes oder unsubstituiertes C₆-C₃₀-Aryl, oder OR²² wobei geeignete und bevorzugte Alkyl- und Arylreste vorstehend genannt sind. Besonders bevorzugt bedeuten die Reste R¹⁹, R²⁰ und R²¹ C₁-C₆-Alkyl, z. B. Methyl, Ethyl oder i-Propyl oder Phenyl. In einer bevorzugten Ausführungsform - im Falle von SiR¹⁹R²⁰R²¹ - bedeuten R¹⁹, R²⁰ und R²¹ bevorzugt unabhängig voneinander substituiertes oder unsubstituiertes C₁-C₂₀-Alkyl oder substituiertes oder unsubstituiertes Aryl, bevorzugt Phenyl.

Bevorzugte Substituenten mit Donor- oder Akzeptorwirkung sind ausgewählt aus der Gruppe bestehend aus:
C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR¹⁹R²⁰R²¹,wobei R¹⁹,R²⁰ und R²¹ bevorzugt unabhängig voneinander substituiertes oder unsubstituiertes Alkyl oder substituiertes oder unsubstituiertes Aryl. bevorzugt Phenyl, bedeuten; besonders bevorzugt ist mindenstens einer der Reste R¹⁹,R²⁰ oder R²¹ substituiertes oder unsubstituiertes Phenyl, wobei geeignete Substituenten vorstehend genannt sind; Halogenresten, bevorzugt F, Cl, besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diarylamino, besonders bevorzugt Diarylamino; Pseudohalogenresten, bevorzugt CN, -C(O)OC₁-C₄-Alkyl, bevorzugt -C(O)OMe, P(O)R₂, bevorzugt P(O)Ph₂.

Ganz besonders bevorzugte Substituenten mit Donor- oder Akzeptorwirkung sind ausgewählt aus der Gruppe bestehend aus Methoxy, Phenyloxy, halogeniertem C₁-C₄-Alkyl, bevorzugt CF₃, CH₂F, CHF₂, C₂F₅, Halogen, bevorzugt F, CN, SiR¹⁹R²⁰R²¹, wobei geeignete Reste R¹⁹, R²⁰ und R²¹ bereits genannt sind, Diarylamino (NR¹⁹R²⁰, wobei R¹⁹, R²⁰ jeweils C₆-C₃₀-Aryl bedeuten), -C(O)OC₁-C₄-Alkyl, bevorzugt -C(O)OMe, P(O)Ph₂.

Unter Halogengruppen sind bevorzugt F, Cl und Br, besonders bevorzugt F und Cl, ganz besonders bevorzugt F, zu verstehen.

Unter Pseudohalogengruppen sind bevorzugt CN, SCN und OCN, besonders bevorzugt CN, zu verstehen.

Die vorstehend genannten Gruppen mit Donor- oder Akzeptorwirkung schließen nicht aus, dass weitere der in der vorliegenden Anmeldung genannte Reste und Substituenten, die nicht in der vorstehenden Liste der Gruppen mit Donor- oder Akzeptorwirkung aufgeführt sind, eine Donor- oder Akzeptorwirkung aufweisen.

Die Arylreste oder-gruppen, Heteroarylreste oder-gruppen, Alkylreste oder-gruppen, Cycloalkylreste oder-gruppen, Heterocycloalkylreste oder-gruppen, Alkenylreste oder -gruppen und Gruppen mit Donor- und/oder Akzeptorwirkung können - wie vorstehend erwähnt - substituiert oder unsubstituiert sein. Unter einer unsubstituierten Gruppe ist im Sinne der vorliegenden Anmeldung eine Gruppe zu verstehen, worin die substituierbaren Atome der Gruppe Wasserstoffatome tragen. Unter einer substituierten Gruppe ist im Sinne der vorliegenden Anmeldung eine Gruppe zu verstehen, worin ein oder mehrere substituierbare Atom(e) mindestens an einer Position anstelle eines Wasserstoffatoms einen Substituenten tragen. Geeignete Substituenten sind die vorstehend bezüglich der Arylreste oder-gruppen genannten Substituenten.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Der Rest X in den Verbindungen der Formel (I) oder (I*) bedeutet NR, S, O oder PR, bevorzugt NR, S oder O, besonders bevorzugt O oder S, ganz besonders bevorzugt O.

Der Rest R bedeutet Aryl, Heteroaryl, Alkyl, Cycloalkyl oder Heterocycloalkyl, bevorzugt Aryl, Heteroaryl oder Alkyl, besonders bevorzugt Aryl, wobei die vorstehend genannten Reste unsubstituiert oder substituiert sein können. Geeignete Substituenten sind vorstehend genannt. Besonders bevorzugt bedeutet R Phenyl, das mit den vorstehend genannten Substituenten substituiert oder unsubstituiert sein kann. Ganz besonders bevorzugt bedeutet R unsubstituiertes Phenyl.

Die Gruppe A in den Verbindungen der Formel (I) oder (I*) bedeutet A -NR⁶R⁷, - P(O)R⁸R⁹, -PR¹⁰R¹¹, -S(O)₂R¹², -S(O)R¹³, -SR¹⁴ oder -OR¹⁵; bevorzugt NR⁶R⁷, - P(O)R⁸R⁹ oder - OR¹⁵, besonders bevorzugt -NR⁶R⁷.

Die Reste R⁶ bis R¹⁵ weisen dabei die folgenden Bedeutungen auf:
- R⁶, R⁷: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, über einen Spacer angebundene vernetzbare oder polymerisierbare Gruppe, und einer Gruppe mit Donor- oder Akzeptorwirkung substituiert sein können;
- R⁸, R⁹, R¹⁰, R¹¹, R¹², R¹³, R¹⁴, R¹⁵, R²³, R²⁴, R²⁵: unabhängig voneinander Aryl, Heteroaryl, Alkyl, Cycloalkyl oder Heterocycloalkyl, über einen Spacer angebundene vernetzbare oder polymerisierbare Gruppe, bevorzugt Aryl oder Heteroaryl, wobei die Reste unsubstituiert oder mit einem oder mehreren der Reste ausgewählt aus Alkyl, Cycloalkyl, Heterocycloalkyl, Aryl, Heteroaryl und einer Gruppe mit Donor oder Akzeptorwirkung substituiert sein können, besonders bevorzugt unsubstituiertes oder substituiertes Phenyl, wobei geeignete Substituenten vorstehend genannt sind, z.B. Tolyl oder eine Gruppe der Formel 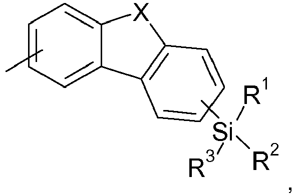 worin die Gruppe X und die Reste R¹, R² und R³ unabhängig voneinander die bezüglich der Verbindungen der Formel (I) oder (I*) genannten Bedeutungen aufweisen.

Ganz besonders bevorzugt bedeuten R⁸, R⁹, R¹⁰, R¹¹, R¹², R¹³, R¹⁴ und R¹⁵ unabhängig voneinander Phenyl, Tolyl oder eine Gruppe der Formel 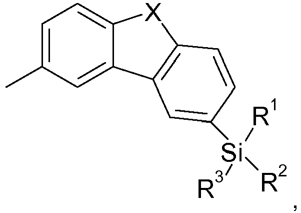 worin X NPh, S oder O bedeutet.

Beispiele für bevorzugt geeignete Gruppen -NR⁶R⁷ sind ausgewählt aus der Gruppe bestehend aus Pyrrolyl, 2,5-Dihydro-1-pyrrolyl, Pyrrolidinyl, Indolyl, Indolinyl, Isoindolinyl, Carbazolyl, Azacarbazolyl, Diazacarbazolyl, Imidazolyl, Imidazolinyl, Benzimidazolyl, Pyrazolyl, Indazolyl, 1,2,3-Triazolyl, Benzotriazolyl, 1,2,4-Triazolyl, Tetrazolyl, 1,3-Oxazolyl, 1,3-Thiazolyl, Piperidyl, Morpholinyl, 9,10-Dihydroacridinyl und 1,4-Oxazinyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bevorzugt ist die Gruppe -NR⁶R⁷ ausgewählt aus Carbazolyl, Pyrrolyl, Indolyl, Imidazolyl, Benzimidazolyl, Azacarbazolyl und Diazacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, besonders bevorzugt bedeutet die Gruppe -NR⁶R⁷ Carbazolyl, das unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann.

Besonders bevorzugte Gruppen -NR⁶R⁷ sind: 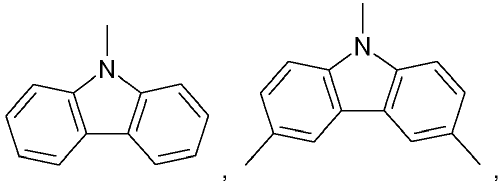 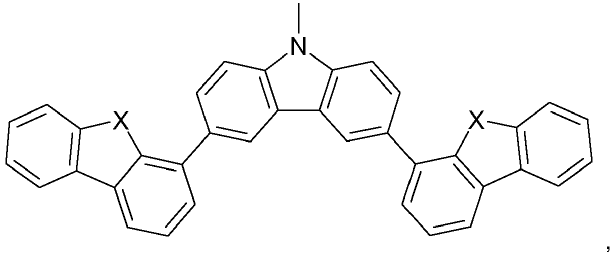 worin X NPh, S oder O bedeutet, 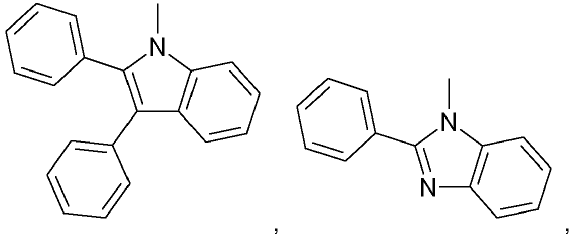 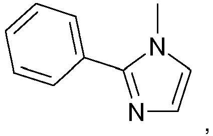 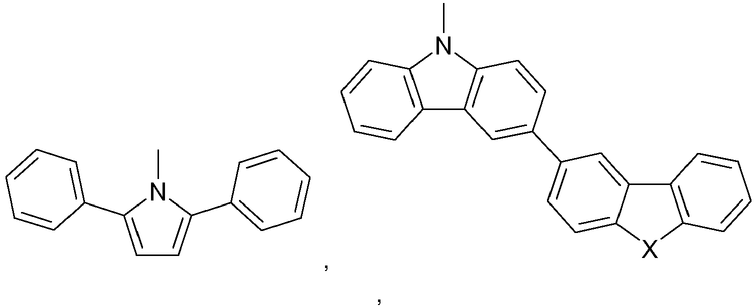 worin X NPh, S oder O bedeutet,

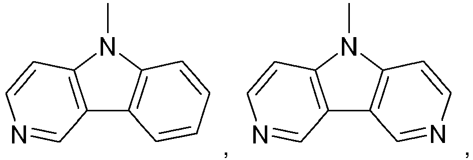

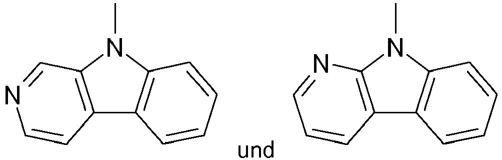

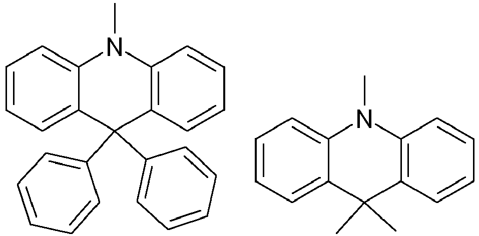

Besonders bevorzugte Gruppen -P(O)R⁸R⁹ sind: 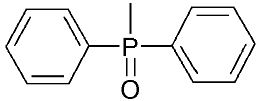 und

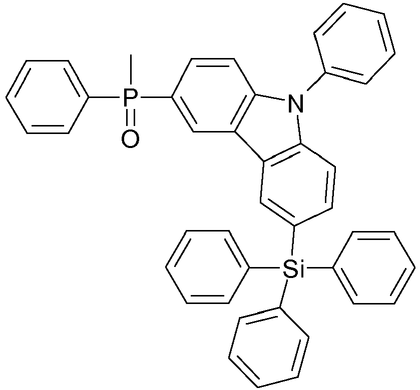

Eine besonders bevorzugte Gruppe PR¹⁰R¹¹ ist:

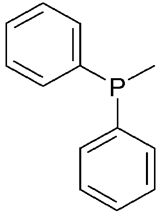

Besonders bevorzugte Gruppen -S(O)₂R¹² und -S(O)R¹³ sind:

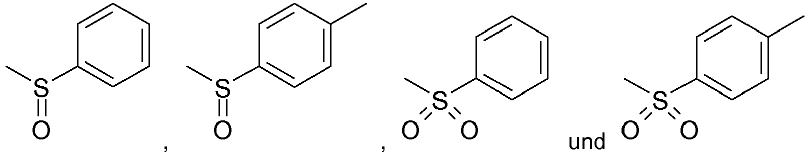

Besonders bevorzugte Gruppen -SR¹⁴ und -OR¹⁵ sind: 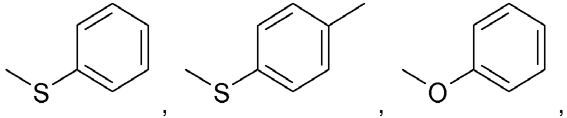 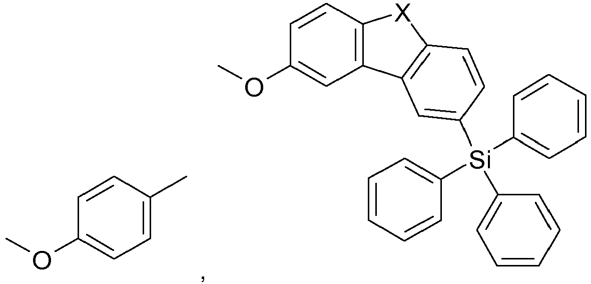 und 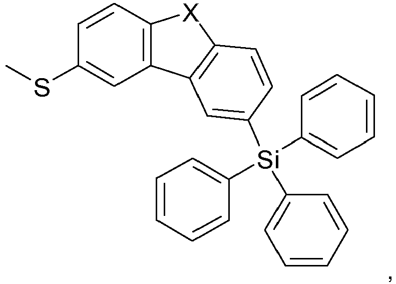 worin X jeweils NPh, S oder O bedeutet.

R⁴, R⁵ in den Verbindungen der Formel (I) oder (I*) bedeuten unabhängig voneinander Alkyl, Cycloalkyl, Heterocycloalkyl, Aryl, Heteroaryl, eine weitere Gruppe A, über einen Spacer angebundene vernetzbare oder polymerisierbare Gruppe oder eine Gruppe mit Donor- oder Akzeptorwirkung; bevorzugt unabhängig voneinander Alkyl, Aryl, Heteroaryl oder eine Gruppe mit Donor- oder Akzeptorwirkung. Beispielsweise können R⁴ oder R⁵ unabhängig voneinander bedeuten: 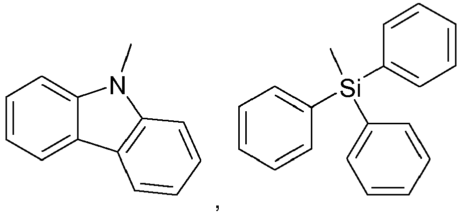 oder 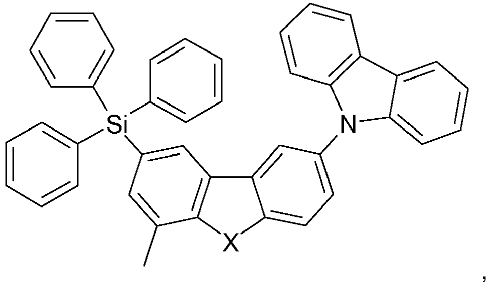 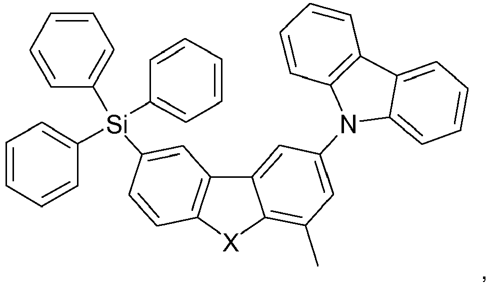 worin X NPh, S oder O bedeutet.

Dabei können in den Verbindungen der Formel (I) oder (I*) n Gruppen R⁴ und/oder m Gruppen R⁵ vorliegen, wobei n und m bedeuten:
- n, m: unabhängig voneinander 0, 1, 2 oder 3; bevorzugt unabhängig voneinander 0, 1 oder 2. Ganz besonders bevorzugt ist mindestens n oder m 0.

R²² bedeutet in den Verbindungen der allgemeinen Formel (I) oder (I*) im Allgemeinen unabhängig voneinander SiR²³R²⁴R²⁵, Aryl, Heteroaryl, Alkyl, Cycloalkyl oder Heterocycloalkyl, über einen Spacer angebundene vernetzbare oder polymerisierbare Gruppe, gegebenenfalls substituiert mit einer Gruppe OR²⁸, bevorzugt Aryl, Alkyl, gegebenenfalls substituiert mit einer Gruppe OR²⁸, besonders bevorzugt Aryl, Alkyl.

R²⁸ bedeutet in verbindungen der allgemeinen Formel (I) oder (I*) im Allgemeinen unabhängig SiR²³R²⁴R²⁵, unabhängig voneinander Aryl, Heteroaryl, Alkyl, Cycloalkyl oder Heterocycloalkyl, über einen Spacer angebundene vernetzbare oder polymerisierbare Gruppe.

Der gegebenenfalls vorliegende Substituent OR²⁸ kann in den genannten Resten im Allgemeinen an allen dem Fachmann für geeignet erscheinenden Stellen vorliegen.

In einer weiteren bevorzugten Ausführungsform der vorliegenden Erfindung sind zwei Einheiten der allgemeinen Formeln (I) und/oder (I*) sind über eine lineare oder verzweigte, gesättigte oder ungesättigte, gegebenenfalls durch wenigstens ein Heteroatom unterbrochene Verbrückung oder über O miteinander verbrückt, wobei diese Verbrückung in den allgemeinen Formeln (I) und/oder (I*) jeweils anstelle von R² an die Si-Atome angebunden ist.

Bevorzugt ist die Verbrückung ausgewählt aus der Gruppe bestehend aus -CH₂-, - C₂H₄-, -C₃H₆-, -C₄H₈-, -C₆H₁₂-, -C₈H₁₆-, -C₉H₁₈-, -CH(C₈H₁₇)CH₂-, -C₂H₄(CF₂)₈ C₂H₄-, - C=C-, -1,4-(CH₂)₂-Phenyl-(CH₂)₂-, 1,3-(CH₂)₂-Phenyl-(CH₂)₂-, -1,4-Phenyl-, -1,3-Phenyl-, -O-, -O-Si(CH₃)₂-O-, -O-Si(CH₃)₂-O- Si(CH₃)₂-O-, -O-

In einer bevorzugten Ausführungsform der vorliegenden Anmeldung weisen die Verbindungen der allgemeinen Formel (I) oder (I*) die allgemeine Formel (la), (Ib) oder (Ic) auf: 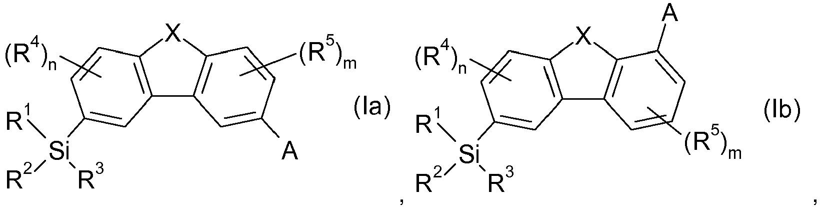 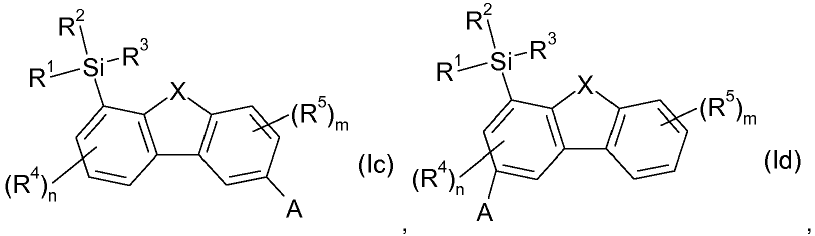 oder 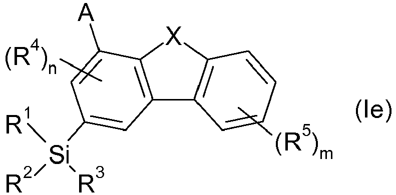 worin die Reste und Gruppen A, X, R¹, R², R³, R⁴ und R⁵ die vorstehend genannten Bedeutungen aufweisen.

In einer weiteren bevorzugten Ausführungsform der vorliegenden Erfindung bedeuten R¹ und/oder R² und/oder R³ aromatische Einheiten der allgemeinen Formeln (Ii) und/oder (Ii*) 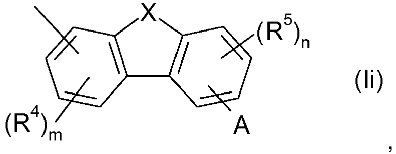 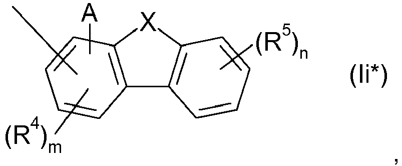 wobei R⁴, R⁵, A und X die gleichen Bedeutungen aufweisen wie oben genannt.

Geeignete Verbindungen der Formel (I) oder (I*) sind z.B.: 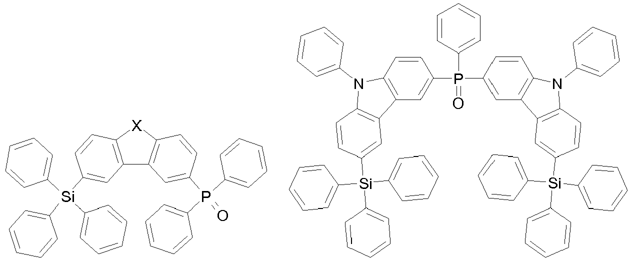 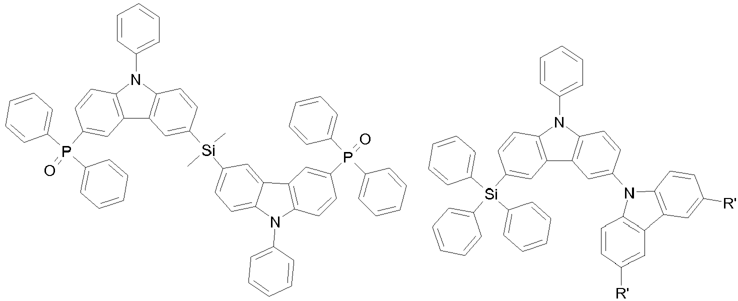 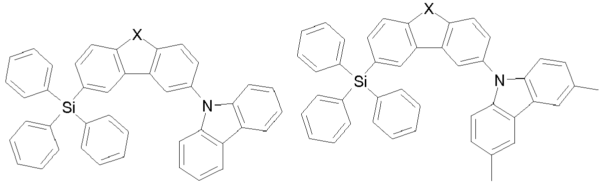 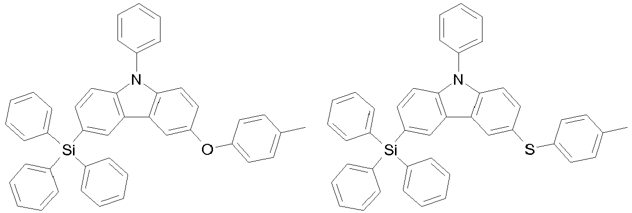 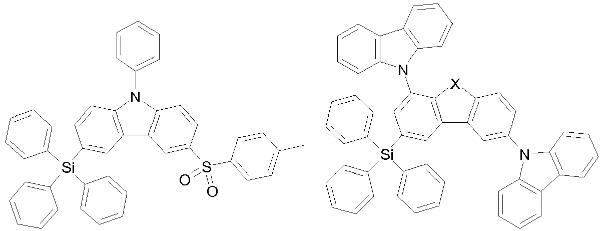 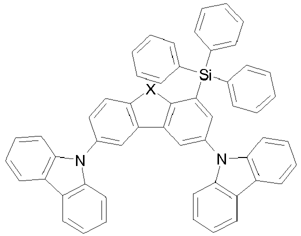 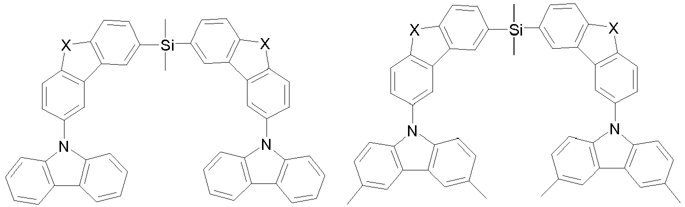 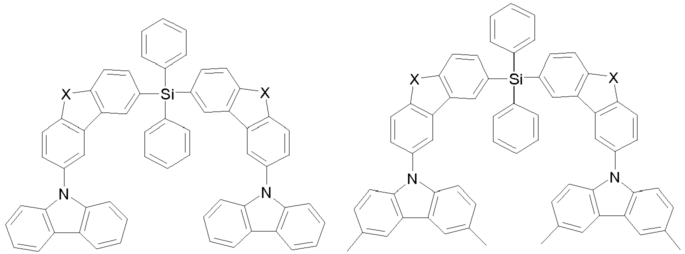 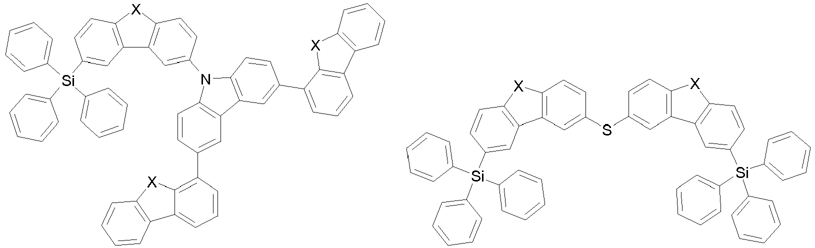 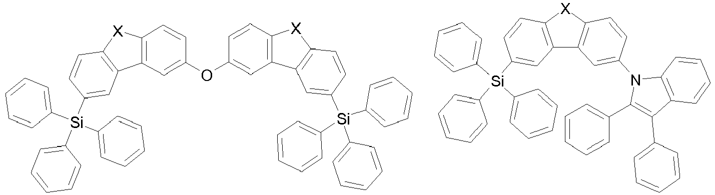 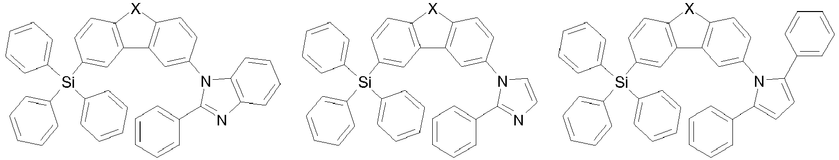 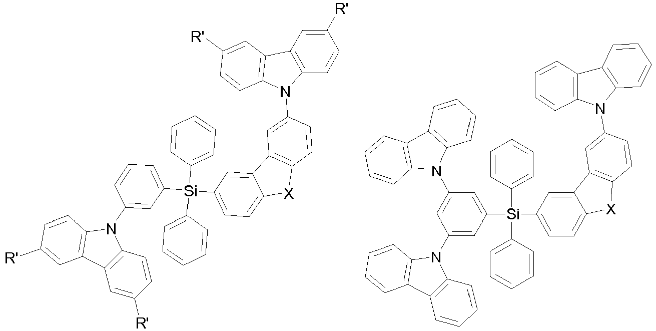 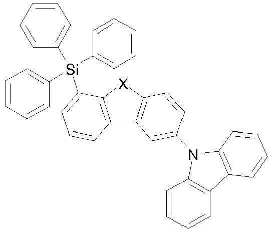 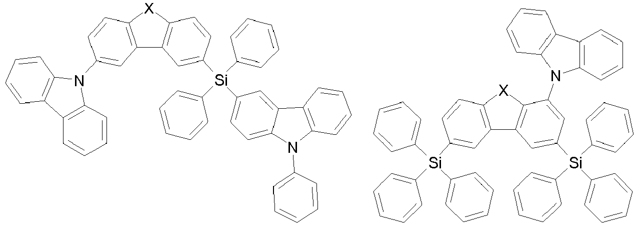 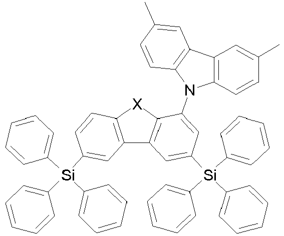 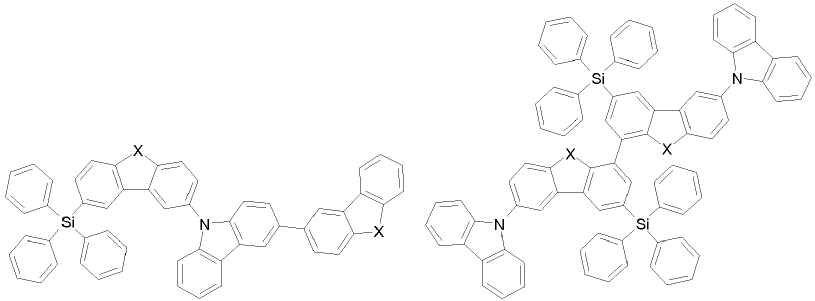 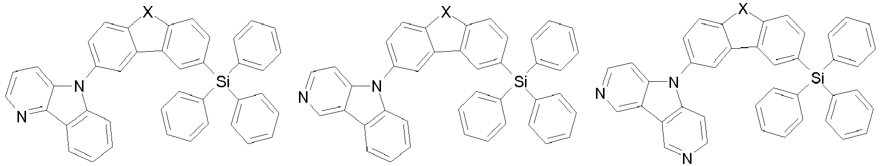 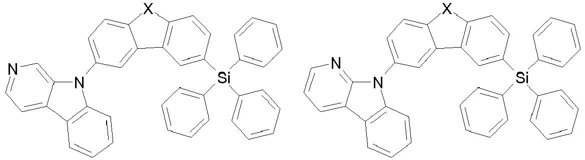 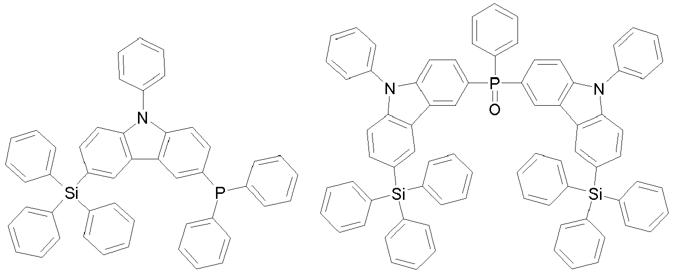 worin bedeuten:
- X: S oder O, und
- R': H oder CH₃.

Weitere besonders geeignete Verbindungen der allgemeinen Formel (I) oder (I*) sind:

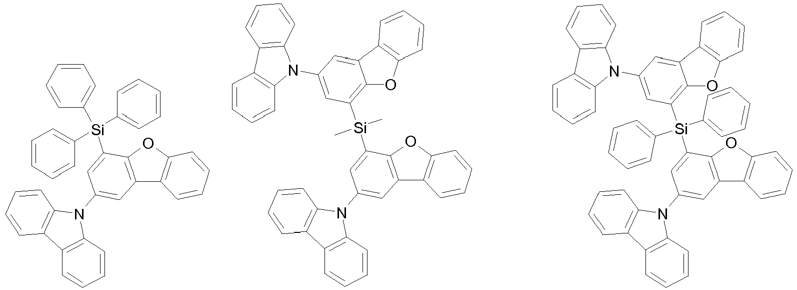

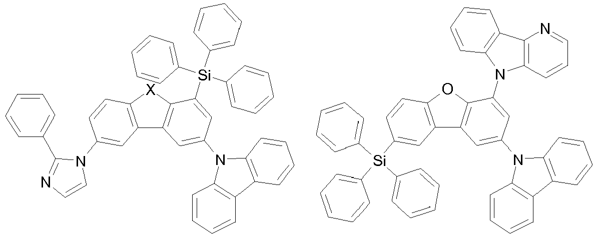

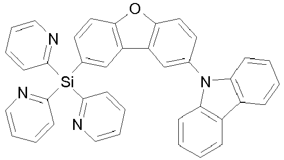

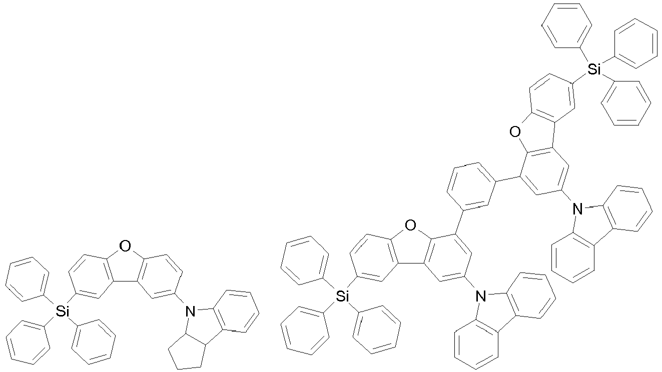

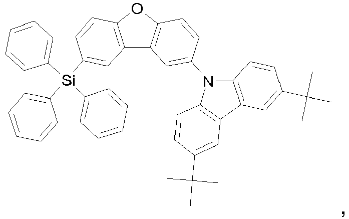

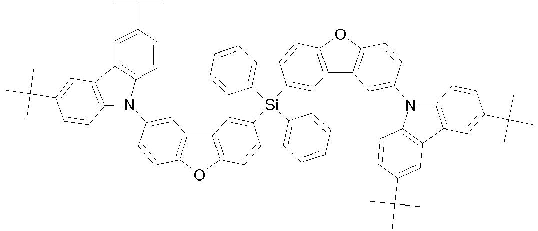

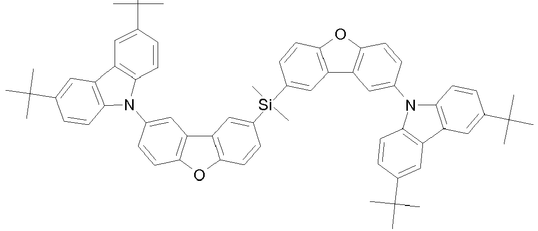

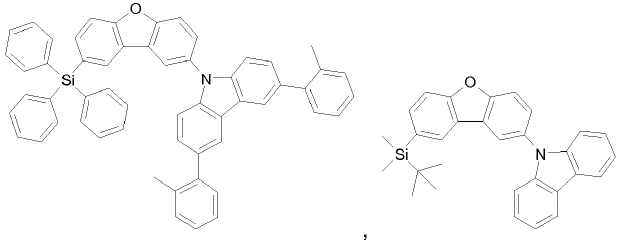

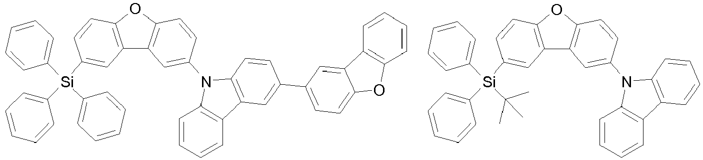

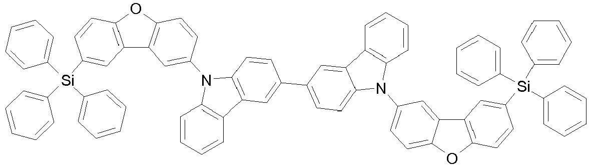

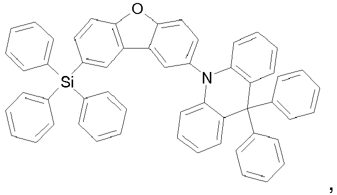

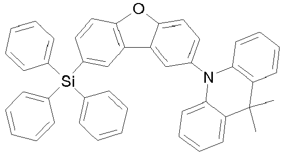

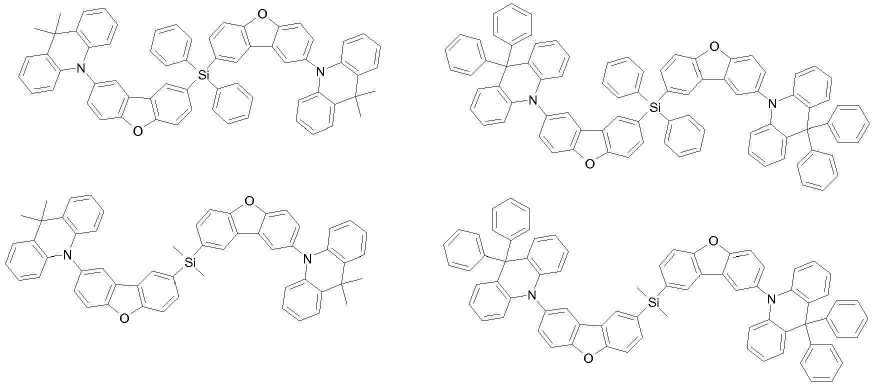

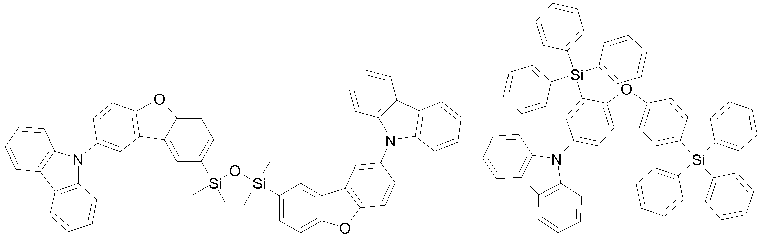

Weitere erfindungsgemäße Verbindungen der allgemeinen Formel (I) oder (I*) entsprechen der folgenden Formel (X)

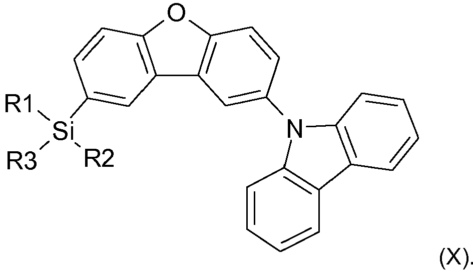

In der allgemeinen Formel (X) haben R¹, R², R³ die folgenden Bedeutungen:

| **Nr** | **R1** | **R2** | **R3** |
|---|---|---|---|
| **35** | Methyl | Methyl | Ethyl |
| **36** | Methyl | Methyl | i-Propyl |
| **37** | Methyl | Methyl | n-Propyl |
| **38** | Methyl | Methyl | n-Butyl |
| **39** | Methyl | Methyl | i-Butyl |
| **40** | Methyl | Methyl | t-Butyl |
| **41** | Methyl | Methyl | n-Pentyl |
| **42** | Methyl | Methyl | n-Hexyl |
| **43** | Methyl | Methyl | -CH₂CH₂C(CH₃)₃ |
| **44** | Methyl | Methyl | n-C₈H₁₇ |
| **45** | Methyl | Methyl | i-C₈H₁₇ |
| **46** | Methyl | Methyl | n-C₁₀H₂₁ |
| **47** | Methyl | Methyl | n-C₁₂H₂₅ |
| **48** | Methyl | Methyl | n-C₁₈H₃₇ |
| **49** | Methyl | Methyl | n-C₃₀H₆₁ |
| **50** | Methyl | Methyl | Cyclohexyl |
| **51** | Methyl | Methyl | C(CH₃)₂Ph |
| **52** | Methyl | Methyl | -C(CH₃)₂CH(CH₃)₂ |
| **53** | Methyl | Methyl | -CCH₂CH(CH₃)(C₂H₅) |
| **54** | Methyl | Methyl | -CH₂CH(C₁₀H₂₁)₂ |
| **55** | Methyl | Methyl | -CH₂CH(C₁₂H₂₅)₂ |
| **56** | Methyl | Methyl | -CH₂CH₂(C₃F₆)CF₃ |
| **57** | Methyl | Methyl | -CH₂CH₂(C₇F₁₄)CF₃ |
| **58** | Methyl | Methyl | -CH₂CH₂(C₅F₁₀)CF₃ |
| **59** | Methyl | Methyl | -CH₂CH₂CF₃ |
| **60** | Methyl | Methyl | Phenyl |
| **61** | Methyl | Methyl | 2-Biphenyl |
| **62** | Methyl | Methyl | p-Tolyl |
| **63** | Methyl | Methyl | C₆F₅ |
| **64** | Methyl | Methyl | 3,5-(CF₃)₂Phenyl |
| **65** | Methyl | Methyl | -CH₂C(CH₃)₂Phenyl |
| **66** | Methyl | Methyl | 9-Fluorenyl |
| **67** | Methyl | Methyl | 3,6-Di(tert-butyl)-9-Fluorenyl |
| **15** | Methyl | Methyl | R5 |
| **68** | Methyl | Methyl | -OMe |
| **69** | Methyl | Methyl | -OEt |
| **70** | Methyl | Methyl | 2,4,6-t-Butylphenoxy |
| **71** | Methyl | Methyl | -O-tBu (tert-Butoxy) |
| **72** | Methyl | Methyl | -OSiEt₃ |
| **73** | Methyl | Ethyl | Ethyl |
| **74** | Methyl | Ethyl | Phenyl |
| **75** | Methyl | Ethyl | R5 |
| **76** | Methyl | n-Propyl | n-Propyl |
| **77** | Methyl | n-Propyl | Phenyl |
| **78** | Methyl | n-Propyl | R5 |
| **79** | Methyl | i-Propyl | i-Propyl |
| **80** | Methyl | i-Propyl | Phenyl |
| **81** | Methyl | i-Propyl | R5 |
| **82** | Methyl | n-Butyl | n-Butyl |
| **83** | Methyl | n-Butyl | Phenyl |
| **84** | Methyl | n-Butyl | R5 |
| **85** | Methyl | i-Butyl | i-Butyl |
| **86** | Methyl | i-Butyl | Phenyl |
| **87** | Methyl | i-Butyl | R5 |
| **88** | Methyl | t-Butyl | t-Butyl |
| **89** | Methyl | t-Butyl | Phenyl |
| **90** | Methyl | t-Butyl | R5 |
| **91** | Methyl | n-Pentyl | n-Pentyl |
| **92** | Methyl | n-Pentyl | n-Hexyl |
| **93** | Methyl | n-Pentyl | Phenyl |
| **94** | Methyl | n-Pentyl | R5 |
| **95** | Methyl | n-Hexyl | Hexyl |
| **96** | Methyl | n-Hexyl | Phenyl |
| **97** | Methyl | n-Hexyl | R5 |
| **98** | Methyl | n-Heptyl | R5 |
| **99** | Methyl | n-Octyl | R5 |
| **100** | Methyl | n-Decyl | R5 |
| **101** | Methyl | n-C₁₂H₂₅ | R5 |
| **102** | Methyl | n-C₁₈H₃₇ | R5 |
| **103** | Methyl | n-C₂₂H₄₅ | R5 |
| **104** | Methyl | n-C₃₀H₆₁ | R5 |
| **105** | Methyl | Cyclopentyl | Cyclopentyl |
| **106** | Methyl | Cyclopentyl | Phenyl |
| **107** | Methyl | Cyclopentyl | R5 |
| **108** | Methyl | Cyclohexyl | Cyclohexyl |
| **109** | Methyl | Cyclohexyl | Phenyl |
| **110** | Methyl | Cyclohexyl | R5 |
| **111** | Methyl | -CF₂CHF₂ | R5 |
| **112** | Methyl | -CH₂CH₂CF₃ | R5 |
| **113** | Methyl | -CH₂CH₂(CF₂)₃CF₃ | R5 |
| **114** | Methyl | -CH₂CH₂(CF₂)₅CF₃ | R5 |
| **115** | Methyl | -CH₂CH₂(CF₂)₇CF₃ | R5 |
| **116** | Methyl | Phenyl | Phenyl |
| **117** | Methyl | Phenyl | p-Tolyl |
| **118** | Methyl | Phenyl | Mesityl |
| **119** | Methyl | Phenyl | R5 |
| **120** | Methyl | p-Tolyl | p-Tolyl |
| **121** | Methyl | p-Tolyl | R5 |
| **122** | Methyl | Mesityl | Mesityl |
| **123** | Methyl | Mesityl | R5 |
| **124** | Methyl | R5 | R5 |
| **125** | Methyl | Methoxy | Methoxy |
| **126** | Methyl | Ethoxy | Ethoxy |
| **127** | Methyl | -OSiEt₃ | -OSiEt₃ |
| **128** | Methyl | -O-SiMe₂-CH₂CH₂(CF₂)₄CF₃ | -O-SiMe₂-CH₂CH₂(CF₂)₄CF₃ |
| **129** | Ethyl | Ethyl | Ethyl |
| **130** | Ethyl | Ethyl | n-Propyl |
| **131** | Ethyl | Ethyl | i-Propyl |
| **132** | Ethyl | Ethyl | n-Butyl |
| **133** | Ethyl | Ethyl | i-Butyl |
| **134** | Ethyl | Ethyl | t-Butyl |
| **135** | Ethyl | Ethyl | Phenyl |
| **136** | Ethyl | Ethyl | R5 |
| **137** | Ethyl | Phenyl | Phenyl |
| **138** | Ethyl | Phenyl | R5 |
| **139** | Ethyl | R5 | R5 |
| **140** | Ethyl | Ethoxy | Ethoxy |
| **141** | n-Propyl | n-Propyl | n-Propyl |
| **142** | n-Propyl | n-Propyl | Phenyl |
| **143** | n-Propyl | n-Propyl | R5 |
| **144** | n-Propyl | Phenyl | Phenyl |
| **145** | n-Propyl | Phenyl | R5 |
| **146** | n-Propyl | R5 | R5 |
| **147** | i-Propyl | i-Propyl | i-Propyl |
| **148** | i-Propyl | i-Propyl | Phenyl |
| **149** | i-Propyl | i-Propyl | R5 |
| **150** | i-Propyl | i-Propyl | 2-Biphenyl |
| **151** | i-Propyl | i-Propyl | Ethoxy |
| **152** | i-Propyl | Phenyl | Phenyl |
| **153** | i-Propyl | Phenyl | R5 |
| **154** | i-Propyl | R5 | R5 |
| **155** | n-Butyl | n-Butyl | n-Butyl |
| **156** | n-Butyl | n-Butyl | Phenyl |
| **157** | n-Butyl | n-Butyl | R5 |
| **158** | n-Butyl | n-Hexyl | R5 |
| **159** | n-Butyl | Phenyl | Phenyl |
| **160** | n-Butyl | Phenyl | R5 |
| **161** | n-Butyl | R5 | R5 |
| **162** | sec-Butyl | sec-Butyl | sec-Butyl |
| **163** | sec-Butyl | sec-Butyl | Phenyl |
| **164** | sec-Butyl | sec-Butyl | R5 |
| **165** | sec-Butyl | Phenyl | Phenyl |
| **166** | sec-Butyl | Phenyl | R5 |
| **167** | sec-Butyl | R5 | R5 |
| **168** | i-Butyl | i-Butyl | i-Butyl |
| **169** | i-Butyl | i-Butyl | n-C₈H₁₇ |
| **170** | i-Butyl | i-Butyl | n-C₁₈H₃₇ |
| **171** | i-Butyl | i-Butyl | Phenyl |
| **172** | i-Butyl | i-Butyl | R5 |
| **173** | i-Butyl | Phenyl | Phenyl |
| **174** | i-Butyl | Phenyl | R5 |
| **175** | i-Butyl | R5 | R5 |
| **176** | t-Butyl | t-Butyl | t-Butyl |
| **177** | t-Butyl | t-Butyl | n-C₈H₁₇ |
| **178** | t-Butyl | t-Butyl | Phenyl |
| **179** | t-Butyl | t-Butyl | R5 |
| **180** | t-Butyl | Phenyl | Phenyl |
| **181** | t-Butyl | Phenyl | R5 |
| **182** | t-Butyl | R5 | R5 |
| **183** | n-Pentyl | n-Pentyl | n-Pentyl |
| **184** | n-Pentyl | n-Pentyl | Phenyl |
| **185** | n-Pentyl | n-Pentyl | R5 |
| **186** | n-Pentyl | Phenyl | Phenyl |
| **187** | n-Pentyl | Phenyl | R5 |
| **188** | n-Pentyl | R5 | R5 |
| **189** | Cyclopentyl | Cyclopentyl | Cyclopentyl |
| **190** | Cyclopentyl | Cyclopentyl | Phenyl |
| **191** | Cyclopentyl | Cyclopentyl | R5 |
| **192** | Cyclopentyl | Phenyl | Phenyl |
| **193** | Cyclopentyl | Phenyl | R5 |
| **194** | Cyclopentyl | R5 | R5 |
| **195** | n-Hexyl | n-Hexyl | n-Hexyl |
| **196** | n-Hexyl | n-Hexyl | Phenyl |
| **197** | n-Hexyl | n-Hexyl | R5 |
| **198** | n-Hexyl | Phenyl | Phenyl |
| **199** | n-Hexyl | Phenyl | R5 |
| **200** | n-Hexyl | R5 | R5 |
| **201** | -CH₂CH₂C(CH₃)₃ | -CH₂CH₂C(CH₃)₃ | -CH₂CH₂C(CH₃)₃ |
| **202** | -CH₂CH₂C(CH₃)₃ | -CH₂CH₂C(CH₃)₃ | R5 |
| **203** | -CH₂CH₂C(CH₃)₃ | R5 | R5 |
| **204** | t-Hexyl | t-Hexyl | t-Hexyl |
| **205** | t-Hexyl | t-Hexyl | R5 |
| **206** | t-Hexyl | R5 | R5 |
| **207** | n-Heptyl | n-Heptyl | n-Heptyl |
| **208** | n-Heptyl | n-Heptyl | R5 |
| **209** | n-Heptyl | R5 | R5 |
| **210** | n-Octyl | n-Octyl | n-Octyl |
| **211** | n-Octyl | n-Octyl | R5 |
| **212** | n-Octyl | R5 | R5 |
| **213** | i-Octyl | i-Octyl | i-Octyl |
| **214** | i-Octyl | i-Octyl | R5 |
| **215** | i-Octyl | R5 | R5 |
| **216** | n-Nonyl | n-Nonyl | n-Nonyl |
| **217** | n-Nonyl | n-Nonyl | R5 |
| **218** | n-Nonyl | R5 | R5 |
| **219** | Cyclohexyl | Cyclohexyl | Cyclohexyl |
| **220** | Cyclohexyl | Cyclohexyl | R5 |
| **221** | Cyclohexyl | R5 | R5 |
| **222** | Cyclooctyl | Cyclooctyl | Cyclooctyl |
| **223** | Cyclooctyl | Cyclooctyl | R5 |
| **224** | Cyclooctyl | R5 | R5 |
| **225** | n-C₁₀H₂₁ | n-C₁₀H₂₁ | n-C₁₀H₂₁ |
| **226** | n-C₁₀H₂₁ | n-C₁₀H₂₁ | R5 |
| **227** | n-C₁₀H₂₁ | R5 | R5 |
| **228** | n-C₁₁H₂₃ | n-C₁₁H₂₃ | n-C₁₁H₂₃ |
| **229** | n-C₁₁H₂₃ | n-C₁₁H₂₃ | R5 |
| **230** | n-C₁₁H₂₃ | R5 | R5 |
| **231** | n-C₁₂H₂₅ | n-C₁₂H₂₅ | n-C₁₂H₂₅ |
| **232** | n-C₁₂H₂₅ | n-C₁₂H₂₅ | R5 |
| **233** | n-C₁₂H₂₅ | R5 | R5 |
| **234** | n-C₁₄H₂₉ | n-C₁₄H₂₉ | n-C₁₄H₂₉ |
| **235** | n-C₁₄H₂₉ | n-C₁₄H₂₉ | R5 |
| **236** | n-C₁₄H₂₉ | R5 | R5 |
| **237** | n-C₁₆H₃₃ | n-C₁₆H₃₃ | n-C₁₆H₃₃ |
| **238** | n-C₁₆H₃₃ | n-C₁₆H₃₃ | R5 |
| **239** | n-C₁₆H₃₃ | R5 | R5 |
| **240** | n-C₁₈H₃₇ | n-C₁₈H₃₇ | R5 |
| **241** | n-C₁₈H₃₇ | R5 | R5 |
| **242** | n-C₁₈H₃₇ | OEt | OEt |
| **243** | n-C₁₈H₃₇ | R5 | OMe |
| **244** | n-C₂₀H₄₁ | n-C₂₀H₄₁ | n-C₂₀H₄₁ |
| **245** | n-C₂₀H₄₁ | n-C₂₀H₄₁ | R5 |
| **246** | n-C₂₀H₄₁ | R5 | R5 |
| **247** | n-C₂₂H₄₅ | n-C₂₂H₄₅ | n-C₂₂H₄₅ |
| **248** | n-C₂₂H₄₅ | n-C₂₂H₄₅ | R5 |
| **249** | n-C₂₂H₄₅ | R5 | R5 |
| **250** | n-C₂₆H₅₃ | n-C₂₆H₅₃ | n-C₂₆H₅₃ |
| **251** | n-C₂₆H₅₃ | n-C₂₆H₅₃ | R5 |
| **252** | n-C₂₆H₅₃ | R5 | R5 |
| **253** | n-C₃₀H₆₁ | n-C₃₀H₆₁ | n-C₃₀H₆₁ |
| **254** | n-C₃₀H₆₁ | n-C₃₀H₆₁ | R5 |
| **255** | n-C₃₀H₆₁ | R5 | R5 |
| **256** | -CH₂-Cyclohexyl | -CH₂-Cyclohexyl | R5 |
| **257** | -CH₂CH₂CF₃ | -CH₂CH₂CF₃ | -CH₂CH₂CF₃ |
| **258** | -CH₂CH₂CF₃ | -CH₂CH₂CF₃ | R5 |
| **259** | -CH₂CH₂CF₃ | R5 | R5 |
| **260** | -CH₂CH₂(CF₂)₃CF₃ | -CH₂CH₂(CF₂)₃CF₃ | -CH₂CH₂(CF₂)₃CF₃ |
| **261** | -CH₂CH₂(CF₂)₃CF₃ | -CH₂CH₂(CF₂)₃CF₃ | R5 |
| **262** | -CH₂CH₂(CF₂)₃CF₃ | R5 | R5 |
| **263** | -CH₂CH₂(CF₂)₅CF₃ | -CH₂CH₂(CF₂)₅CF₃ | -CH₂CH₂(CF₂)₅CF₃ |
| **264** | -CH₂CH₂(CF₂)₅CF₃ | -CH₂CH₂(CF₂)₅CF₃ | R5 |
| **265** | -CH₂CH₂(CF₂)₅CF₃ | R5 | R5 |
| **266** | -CH₂CH₂(CF₂)₇CF₃ | -CH₂CH₂(CF₂)₇CF₃ | -CH₂CH₂(CF₂)₇CF₃ |
| **267** | -CH₂CH₂(CF₂)₇CF₃ | -CH₂CH₂(CF₂)₇CF₃ | R5 |
| **268** | -CH₂CH₂(CF₂)₇CF₃ | R5 | R5 |
| **269** | -CH₂CH₂(CF₂)₉CF₃ | -CH₂CH₂(CF₂)₉CF₃ | -CH₂CH₂(CF₂)₉CF₃ |
| **270** | -CH₂CH₂(CF₂)₉CF₃ | -CH₂CH₂(CF₂)₉CF₃ | R5 |
| **271** | -CH₂CH₂(CF₂)₉CF₃ | R5 | R5 |
| **272** | -CH₂CH₂(CF₂)₁₁CF₃ | -CH₂CH₂(CF₂)₁₁CF₃ | -CH₂CH₂(CF₂)₁₁CF₃ |
| **273** | -CH₂CH₂(CF₂)₁₁CF₃ | -CH₂CH₂(CF₂)₁₁CF₃ | R5 |
| **274** | -CH₂CH₂(CF₂)₁₁CF₃ | R5 | R5 |
| **275** | -CF₂CHF₂ | -CF₂CHF₂ | -CF₂CHF₂ |
| **276** | -CF₂CHF₂ | -CF₂CHF₂ | R5 |
| **277** | -CF₂CHF₂ | R5 | R5 |
| **278** | -(CF₂)₃CHF₂ | -(CF₂)₃CHF₂ | -(CF₂)₃CHF₂ |
| **279** | -(CF₂)₃CHF₂ | -(CF₂)₃CHF₂ | R5 |
| **280** | -(CF₂)₃CHF₂ | R5 | R5 |
| **14** | Phenyl | Phenyl | Phenyl |
| **281** | Phenyl | Phenyl | p-Tolyl |
| **282** | Phenyl | Phenyl | m-Tolyl |
| **283** | Phenyl | Phenyl | o-Tolyl |
| **284** | Phenyl | Phenyl | 2-Xylyl |
| **285** | Phenyl | Phenyl | 5-Xylyl |
| **286** | Phenyl | Phenyl | Mesityl |
| **287** | Phenyl | Phenyl | 9-Fluorenyl |
| **18** | Phenyl | Phenyl | R5 |
| **288** | Phenyl | Phenyl | -O-tBu (tert-Butoxy) |
| **289** | Phenyl | p-Tolyl | p-Tolyl |
| **290** | Phenyl | m-Tolyl | m-Tolyl |
| **291** | Phenyl | o-Tolyl | o-Tolyl |
| **292** | Phenyl | 2-Xylyl | 2-Xylyl |
| **293** | Phenyl | 5-Xylyl | 5-Xylyl |
| **294** | Phenyl | Mesityl | Mesityl |
| **295** | Phenyl | R5 | R5 |
| **296** | Phenyl | Ethoxy | Ethoxy |
| **297** | p-Tolyl | p-Tolyl | p-Tolyl |
| **298** | p-Tolyl | p-Tolyl | R5 |
| **299** | p-Tolyl | R5 | R5 |
| **300** | m-Tolyl | m-Tolyl | m-Tolyl |
| **301** | m-Tolyl | m-Tolyl | R5 |
| **302** | o-Tolyl | o-Tolyl | o-Tolyl |
| **303** | o-Tolyl | o-Tolyl | R5 |
| **304** | 2-Xylyl | 2-Xylyl | 2-Xylyl |
| **305** | 2-Xylyl | 2-Xylyl | R5 |
| **306** | 5-Xylyl | 5-Xylyl | 5-Xylyl |
| **307** | 5-Xylyl | 5-Xylyl | R5 |
| **308** | Mesityl | Mesityl | Mesityl |
| **309** | Mesityl | Mesityl | R5 |
| **310** | C₆F₅ | C₆F₅ | C₆F₅ |
| **311** | C₆F₅ | C₆F₅ | R5 |
| **312** | C₆F₅ | R5 | R5 |
| **313** | R5 | R5 | R5 |
| **314** | R5 | Ethoxy | Ethoxy |
| **315** | R5 | n-Butoxy | n-Butoxy |
| **316** | R5 | R5 | Methoxy |
| **317** | R5 | R5 | Ethoxy |
| **318** | R5 | R5 | OSiMe₃ |
| **319** | R5 | R5 | -(CH₂)ₙO-(CH₂)₂OCH₃ |
| **320** | Methoxy | Methoxy | Methoxy |
| **321** | Ethoxy | Ethoxy | Ethoxy |
| **322** | i-Propoxy | i-Propoxy | i-Propoxy |
| **323** | t-Butoxy | t-Butoxy | t-Butoxy |
| **324** | OSiMe₃ | OSiMe₃ | OSiMe₃ |
| **325** | Cyclobutyl | | Methyl |
| **326** | Cyclobutyl | | R5 |
| **327** | Cyclobutyl | | p-Methoxyphenyl |
| **328** | Cyclopentyl | | Methyl |
| **329** | Cyclopentyl | | R5 |
| **330** | Cyclohexyl | | Methyl |
| **331** | Cyclohexyl | | R5 |

In dieser Tabelle ist:

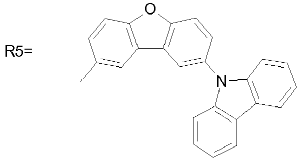

Besonders bevorzugte erfindungsgemäße Verbindungen, in denen zwei Einheiten der allgemeinen Formeln (I) und/oder (I*) über eine lineare oder verzweigte, gesättigte oder ungesättigte, gegebenenfalls durch wenigstens ein Heteroatom unterbrochene Verbrückung oder über O miteinander verbrückt sind, wobei diese Verbrückung in den allgemeinen Formeln (I) und/oder (I*) jeweils anstelle von R² an die Si-Atome angebunden ist, entsprechen der allgemeinen Formel (XI)

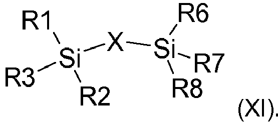

In Formel (XI) haben X R¹, R², R³, R⁵, R⁶, R⁷ und R⁸ die folgenden Bedeutungen:

| Nr. | **R1** | **R2** | **R3** | **R6** | **R7** | **R8** | **X** |
|---|---|---|---|---|---|---|---|
| 332 | Methyl | R5 | R5 | Methyl | R5 | R5 | -CH₂- |
| 333 | Methyl | Methyl | R5 | Methyl | Methyl | R5 | -CH₂- |
| 334 | R5 | R5 | R5 | R5 | R5 | R5 | -CH₂- |
| 335 | Methyl | R5 | R5 | Methyl | R5 | R5 | -C₂H₄- |
| 336 | Methyl | Methyl | R5 | Methyl | Methyl | R5 | -C₂H₄- |
| 337 | R5 | R5 | R5 | R5 | R5 | R5 | -C₂H₄- |
| 338 | Methyl | R5 | R5 | Methyl | R5 | R5 | -C₃H₆- |
| 339 | Methyl | Methyl | R5 | Methyl | Methyl | R5 | -C₃H₆- |
| 340 | R5 | R5 | R5 | R5 | R5 | R5 | -C₃H₆- |
| 341 | Methyl | R5 | R5 | Methyl | R5 | R5 | -C₄H₈- |
| 342 | Methyl | Methyl | R5 | Methyl | Methyl | R5 | -C₄H₈- |
| 343 | R5 | R5 | R5 | R5 | R5 | R5 | -C₄H₈- |
| 344 | Methyl | R5 | R5 | Methyl | R5 | R5 | -C₆H₁₂- |
| 345 | Methyl | Methyl | R5 | Methyl | Methyl | R5 | -C₆H₁₂- |
| 346 | R5 | R5 | R5 | R5 | R5 | R5 | -C₆H₁₂- |
| 347 | Methyl | R5 | R5 | Methyl | R5 | R5 | -C₈H₁₆- |
| 348 | Methyl | Methyl | R5 | Methyl | Methyl | R5 | -C₈H₁₆- |
| 349 | R5 | R5 | R5 | R5 | R5 | R5 | -C₈H₁₆- |
| 350 | Methyl | R5 | R5 | Methyl | R5 | R5 | -C₉H₁₈- |
| 351 | Methyl | Methyl | R5 | Methyl | Methyl | R5 | -C₉H₁₈- |
| 352 | R5 | R5 | R5 | R5 | R5 | R5 | -C₉H₁₈- |
| 353 | R5 | R5 | R5 | R5 | R5 | R5 | -CH(C₈H₁₇)CH₂- |
| 354 | Methyl | R5 | R5 | Methyl | R5 | R5 | -C₂H₄(CF₂)₈ C₂H₄- |
| 355 | Methyl | Methyl | R5 | Methyl | Methyl | R5 | -C₂H₄(CF₂)₈ C₂H₄- |
| 356 | R5 | R5 | R5 | R5 | R5 | R5 | -C₂H₄(CF₂)₈ C₂H₄- |
| 357 | Methyl | R5 | R5 | Methyl | R5 | R5 | -C≡C- |
| 358 | Methyl | Methyl | R5 | Methyl | Methyl | R5 | -C≡C- |
| 359 | R5 | R5 | R5 | R5 | R5 | R5 | -C≡C- |
| 360 | Methyl | R5 | R5 | Methyl | R5 | R5 | -1,4-(CH₂)₂- |
| | | | | | | | Phenyl-(CH₂)₂- |
| 361 | Methyl | Methyl | R5 | Methyl | Methyl | R5 | -1,4-(CH₂)₂-Phenyl-(CH₂)₂- |
| 362 | R5 | R5 | R5 | R5 | R5 | R5 | -1,4-(CH₂)₂-Phenyl-(CH₂)₂- |
| 363 | Methyl | R5 | R5 | Methyl | R5 | R5 | -1,3-(CH₂)₂-Phenyl-(CH₂)₂- |
| 364 | Methyl | Methyl | R5 | Methyl | Methyl | R5 | -1,3-(CH₂)₂-Phenyl-(CH₂)₂- |
| 365 | R5 | R5 | R5 | R5 | R5 | R5 | -1,3-(CH₂)₂-Phenyl-(CH₂)₂- |
| 366 | Methyl | R5 | R5 | Methyl | R5 | R5 | -1,4-(CH₂)₃-Phenyl-(CH₂)₃- |
| 367 | Methyl | Methyl | R5 | Methyl | Methyl | R5 | -1,4-(CH₂)₃-Phenyl-(CH₂)₃- |
| 368 | R5 | R5 | R5 | R5 | R5 | R5 | -1,4-(CH₂)₃-Phenyl-(CH₂)₃- |
| 369 | Methyl | R5 | R5 | Methyl | R5 | R5 | -1,3-(CH₂)₃-Phenyl-(CH₂)₃- |
| 370 | Methyl | Methyl | R5 | Methyl | Methyl | R5 | -1,3-(CH₂)₃-Phenyl-(CH₂)₃-- |
| 371 | R5 | R5 | R5 | R5 | R5 | R5 | -1,3-(CH₂)₃-Phenyl-(CH₂)₃- |
| 372 | Methyl | R5 | R5 | Methyl | R5 | R5 | -1,4-Phenyl- |
| 373 | Methyl | Methyl | R5 | Methyl | Methyl | R5 | -1,4-Phenyl- |
| 374 | R5 | R5 | R5 | R5 | R5 | R5 | -1,4-Phenyl- |
| 375 | Methyl | R5 | R5 | Methyl | R5 | R5 | -1,3-Phenyl- |
| 376 | Methyl | Methyl | R5 | Methyl | Methyl | R5 | -1,3-Phenyl- |
| 377 | R5 | R5 | R5 | R5 | R5 | R5 | -1,3-Phenyl- |
| **28** | Methyl | Methyl | R5 | Methyl | Methyl | R5 | -O- |
| 378 | Methyl | R5 | R5 | Methyl | R5 | R5 | -O- |
| 379 | Methyl | Methyl | R5 | Methyl | Methyl | R5 | -O-Si(CH₃)₂-O- |
| 380 | Methyl | Methyl | R5 | Methyl | Methyl | R5 | -O-Si(CH₃)(Ph)-O- |
| 381 | Methyl | Methyl | R5 | Methyl | Methyl | R5 | -O-Si(CH₃)₂-O-Si(CH₃)₂-O- |
| 382 | Methyl | Methyl | R5 | Methyl | Methyl | R5 | -O-Si(CH₃)₂-O-Si(CH₃)₂-O-Si(CH₃)₂-O- |
| 383 | Methyl | -OSiMe₃ | R5 | Methyl | -OSiMe₃ | R5 | -O- |
| 384 | Methyl | Phenyl | R5 | Methyl | Phenyl | R5 | -O- |
| 385 | i-Propyl | i-Propyl | R5 | i-Propyl | i-Propyl | R5 | -O- |
| 386 | Cyclopentyl | Cyclopentyl | R5 | Cyclopentyl | Cyclopentyl | R5 | -O- |
| 387 | Phenyl | Phenyl | R5 | Phenyl | Phenyl | R5 | -O- |
| 388 | Phenyl | R5 | R5 | Phenyl | R5 | R5 | -O- |
| 389 | R5 | R5 | R5 | R5 | R5 | R5 | -O- |

In dieser Tabelle ist:

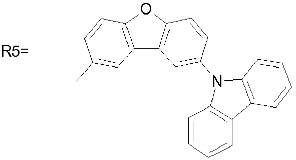

Weitere Beispiele: R sind unabhängig voneinander Me, Phenyl oder R5, wobei mindestens ein R R5 ist:

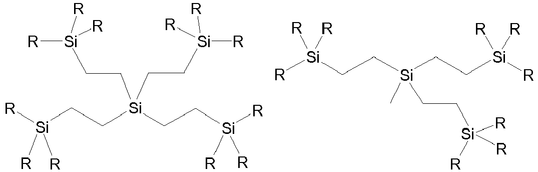

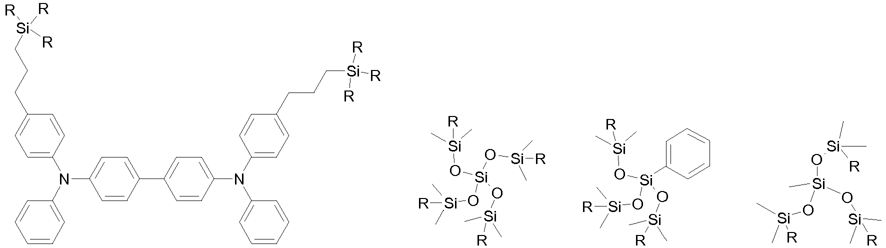

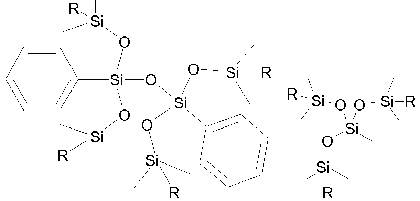

Erfindungsgemäß können in den Verbindungen der allgemeinen Formeln (I) oder (I*) R¹, R², R³, R⁴, R⁵, R⁶, R⁷, R⁸, R⁹, R¹⁰, R¹¹, R¹², R¹³, R¹⁴, R¹⁵, R²³, R²⁴ und R²⁵ unabhängig voneinander über einen Spacer angebundene vernetzbare oder polymerisierbare Gruppe bedeuten oder solche Gruppen als Substituenten enthalten.

In einer bevorzugten Ausführungsform der vorliegenden Erfindung bedeuten R¹, R², R³, R⁴ oder R⁵ unabhängig voneinander über einen Spacer angebundnene polymerisierbare oder vernetzbare Gruppe, besonders bevorzugt ausgewählt aus der Gruppe von funktionellen Gruppen, die durch Polykondensation oder Polyaddition polymerisierbar oder vernetzbar sind.

Insbesondere betrifft die vorliegende Erfindung erfindungsgemäße Verbindungen, wobei mindestens einer der Reste R¹, R², R³, R⁴, R⁵, R⁸, R⁹, R¹⁰, R¹¹, R¹², R¹³, R¹⁴, R¹⁵, R²², R²³, R²⁴ oder R²⁵ oder R²⁸ unabhängig voneinander über einen Spacer angebundene polymerisierbare oder vernetzbare Gruppe bedeutet, ausgewählt aus der Gruppe von funktionellen Gruppen, die radikalisch, kationisch oder oder durch Polyaddition oder durch Kupplungsreaktionen polymerisierbar oder vernetzbar sind.

Insbesondere betrifft die vorliegende Erfindung erfindungsgemäße Verbindungen, wobei wenigstens einer der Reste ausgewählt aus der Gruppe R¹, R² und R³ unabhängig voneinander eine über einen Spacer angebundene polymerisierbare oder vernetzbare Gruppe bedeutet.

Erfindungsgemäß bedeutet eine über einen Spacer angebundene vernetzbare oder polymerisierbare Gruppe im Allgemeinen eine Gruppe der Formel -(Sp)ₓ₁-[PG']ₓ, wobei
Sp eine verbrückende Einheit,
PG' eine vernetzbare oder polymerisierbare Gruppe,
x1 0 oder 1, und
x eine ganze Zahl von 1 bis 4
bedeuten.

Sp ist beispielsweise ausgewählt aus der Gruppe bestehend aus -Ar-, -ArY-, -YAr-, -YAᵣ(CR²⁶R²⁷)ₙ-, -(CR²⁶R²⁷)ₙ-, -(YCR²⁶R²⁷)ₙ-, oder -(CR²⁶R²⁷Y)ₙ-, wobei
Y NR⁵, O, S, C=O, C(=O)O bedeutet, wobei R⁵ H; C₆-C₁₈-Aryl, welches gegegenenfalls von wenigstens einem C₁-C₁₈-Alkyl, or C₁-C₁₈-Alkoxy substituiert ist, C₁-C₁₈-Alkyl, gegebenenfalls von -O- unterbrochen;
R²⁶ und R²⁷ sind unabhängig voneinander Wasserstoff, Fluor oder C₁-C₂₀-Alkyl,
n ist eine ganze Zahl von 1 bis 20,

Ar ist Alkyl, Cycloalkyl, Aryl oder Heteroaryl, welche gegebenenfalls substituiert sein können.

Die vernetzbare oder polymerisierbare Gruppe PG' ist bevorzugt eine Gruppe ausgewählt aus -C(R⁴⁴)=CH₂, -NHC(O)-C(R⁴⁵)=CH₂, -OCH₂CH₂OC(O)-C(R⁴⁵)=CH₂, -OC(O)-C(R⁴⁵)=CH₂, -C(O)-C(R⁴⁶)=CH₂, -C≡C-, -N≡C, -O-CH(CH₂CH₂CH₌CH₂)₂; C₅-C₈-Cycloalkenyl, Bicycloalkenyl, gegebenenfalls substuituiert oder unsubstituiert mit 5 bis 30 C-Atomen, 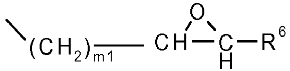 (1,2-Epoxyether), 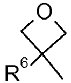 (oxetanyl), 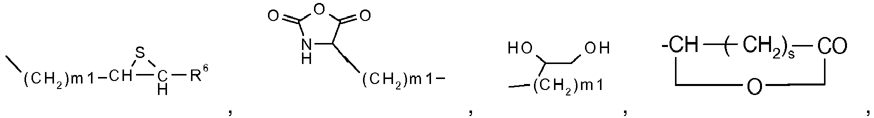 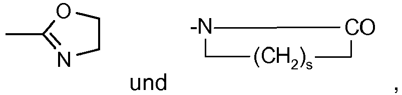 wobei s eine ganze Zahl von 1 bis 6, m1 eine ganze Zahl von 1 bis 6, und R⁶ Wasserstoff oder C₁-C₂₀-Alkyl bedeuten.

R⁴⁴ bedeutet Wasserstoff, C₁-C₄-Alkyl oder Halogen,
R⁴⁵ bedeutet Wasserstoff, C₁-C₄-Alkyl oder Halogen, und
R⁴⁶ bedeutet Wasserstoff, C₁-C₄-Alkyl oder C₆-C₁₂-Aryl, oder
PG' ist in einer weiteren Ausführungsform eine Gruppe erhältlich aus einer polymerisierbaren Gruppe 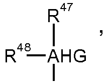 wobei AHG ein aromatischer oder heteroaromatischer Rest ist, der gegebenenfalls subsituiert sein kann, beispielsweise 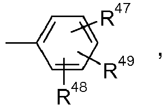 R⁴⁷ und R⁴⁸ sind unabhängig voneinander Halogen, -C=CH, Borsäure. Borsäureester, -Mg-Hal, -Zn-Hal, -Sn(R⁵²)₃, wobei Hal Halogen bedeutet, und R⁵² C₁-C₁₈-Alkyl bedeutet.

R⁴⁹ ist unabhängig voneinander Wasserstoff, C₁-C₁₈-Alkyl, gegebenenfalls unterbrochen von -O-, C₁-C₁₈-Perfluoroalkyl, C₁-C₁₈-Alkoxy, gegebenenfalls unterbrochen von - O-, oder C₇-C₂₅-Aralkyl.

Wenn PG' von der polymerisierbaren Gruppe 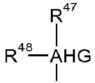 abweicht, können die Polymere zusätzlich zu den genannten Wiederholungseinheiten eine oder mehrere Wiederholungseinheiten RG^{I} und/oder RG" enthalten:
RG^{I}: Einheiten, welche die Lochinjektions- oder Lochtransporteigenschaften des Polymers verbessern;
RG": Einheiten, welche die Elektronen-Injektions- oder Elektronen-Transporteigenschaften des Polymers verbessern.

Falls PG' eine polymerisierbare Gruppe gemäß 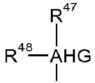 ist, können die Verbindungen der allgemeinen Formel (I) oder (I*) wie folgt polymerisiert werden.

Polymerisationsverfahren, die Dihalogen-funktionalisierte Substrate verwenden, können unter Nickel vermittelten Kupplungsbedingungen durchgeführt werden, beispielsweise gemäß Colon et al. in J. Pol. Sci., Part A, Polymer Chemistry Edition 28 (1990) 367, und Colon et al. in J. Org. Chem. 51 (1986) 2627. Die Reaktion wird im Allgemeinen in einem polaren, aprotischen Lösungsmittel, beispielsweise Dimethylacetamid, mit einer katalytischen Menge eines Nickelsalzes, Triphenylphosphin und einem großen Überschuss Zinkstaub durchgeführt. Eine Variante des Verfahrens wird in loyda et al. in Bull. Chem. Soc. Jpn, 63 (1990) 80 beschrieben, wobei ein organo-lösliches lodid als Beschleuniger verwendet wird. Eine weitere Nickel-Kupplungs-Reaktion wird in Yamamoto, Progress in Polymer Science 17 (1992) 1153 beschrieben, wobei eine Mischung einer dihaloaromatischen Verbindung mit einem Überschuss an Nickel-(1,5-cyclooctadien)-Komplex in einem inerten Lösungsmittel behandelt wird. In allen Nickel-Kupplungs-Reaktionen werden im Wesentlichen statistische Polymere erhalten, wenn Substratmischungen von zwei oder mehr aromatischen Dihalogeniden eingesetzt werden.

Solche Polymerisationsreaktionen können durch Zugabe einer kleinen Menge Wasser beendet werden. Alternativ kann auch ein monofunktionelles Arylhalogenid als Kettenabbruchreagenz verwendet warden.

Durch Nickel-Kupplungs-Polymersiationen werden im Wesentlichen statistische Polymere aus Einheiten der allgemeinen Formel (I) und/oder (I*) erhalten.

Des Weiteren können die Verbindungen der allgemeinen Formel (I) oder (I*) auch durch die dem Fachmann bekannte Suzuki-Kupplung polymerisiert werden. Diese Polymerisationsrealktion ist beispielsweise in N. Miyaua and A. Suzuki in Chemical Reviews, Vol. 95, pp. 457-2483 (1995) beschrieben. Dazu werden bevorzugt Diiodide oder Dibromide der Verbindungen der allgemeinen Formel (I) oder (I*) mit entsprechenden Diborsäuren oder Diborsäureestern umgesetzt. Die Reaktion wird bevorzugt unter Pd-Katalyse und in gegenwart von Triphenylphosphin bei 70 °C bis 180 °C in einem aromatischen Kohlenwasserstoff-Lösungsmittel wie Toluol durchgeführt. Dimethylformamid oder Tetrahydrofuran sind auch geeignet. Eine wässrige Base wie Natriumcarbonat oder -bicarbonate wird als HBr-Fänger verwendet. Entsprechende Verfahren sind beispielsweise in Leadbeater & Marco; Angew. Chem. Int. Ed. Eng. 42 (2003) 1407, T. I. Wallow und B. M. Novak in J. Org. Chem. 59 (1994) 5034-5037; und M. Remmers, M. Schulze, and G. Wegner in Macromol. Rapid Commun. 17 (1996) 239-252, beschrieben.

In einer besonders bevorzugten Ausführungsform sind R¹, R², R³, R⁴ und R⁵, insbesondere R¹, R² und R³, unabhängig voneinander funktionelle Gruppen, die radikalisch vernetzbar oder polymerisierbar sind, insbesondere Gruppen, die C-C-Doppelbindungen enthalten. In einer besonders bevorzugten Ausführungsform sind entsprechende vernetzbare oder polymerisierbare Gruppen bzw. Verbindungen der allgemeinen Formel (I) oder (I*) ausgewählt aus den folgenden:

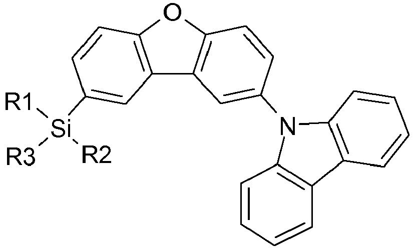

| **Nr** | **R1** | **R2** | **R3** |
|---|---|---|---|
| **390** | Methyl | Methyl | -CH=CH₂ |
| **391** | Methyl | Methyl | -CH₂-CH=CH₂ |
| **392** | Methyl | Methyl | -(CH₂)₃-CH=CH₂ |
| **393** | Methyl | Methyl | -(CH₂)₄-CH=CH₂ |
| **394** | Methyl | Methyl | -(CH₂)₅-CH=CH₂ |
| **395** | Methyl | Methyl | -(CH₂)₆-CH=CH₂ |
| **396** | Methyl | Methyl | -(CH₂)₉-CH=CH₂ |
| **397** | Methyl | Methyl | -(CH₂)₂-cyclohex-3-enyl |
| **398** | Methyl | Methyl | 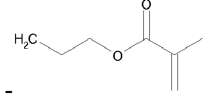 |
| **399** | Methyl | Methyl | -OSiMe₂CH=CH₂ |
| **400** | Methyl | Methyl | 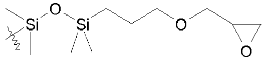 |
| **401** | Methyl | Phenyl | -CH=CH₂ |
| **402** | Methyl | R5 | -CH=CH₂ |
| **403** | Methyl | R5 | -CH₂-CH=CH₂ |
| **404** | Methyl | R5 | -CH=CH-CH₂ |
| **405** | Methyl | R5 | -(CH₂)₂-CH=CH₂ |
| **406** | Methyl | R5 | -(CH₂)₂-cyclohex-3-enyl |
| **407** | Methyl | R5 | 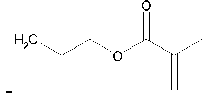 |
| **408** | Methyl | R5 | 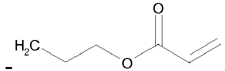 |
| **409** | Methyl | -CH=CH₂ | -O-SiMe(R5)-CH=CH₂ |
| **410** | Ethyl | R5 | -CH=CH₂ |
| **411** | n-Hexyl | R5 | -CH₂-CH=CH₂ |
| **412** | n-Octyl | R5 | -CH=CH₂ |
| **413** | Phenyl | Phenyl | -CH=CH₂ |
| **414** | Phenyl | R5 | -CH=CH₂ |
| **415** | Phenyl | R5 | -CH₂-CH=CH₂ |
| **416** | C₆F₅ | R5 | -CH=CH₂ |
| **417** | R5 | -CH=CH₂ | -CH=CH₂ |
| **418** | R5 | -CH₂-CH=CH₂ | -CH₂-CH=CH₂ |
| **419** | R5 | R5 | -CH=CH₂ |
| **420** | R5 | R5 | -CH₂-CH=CH₂ |
| **421** | R5 | R5 | -(CH₂)₄-CH=CH₂ |
| **422** | R5 | R5 | -(CH₂)₆-CH=CH₂ |
| **423** | R5 | R5 | -(CH₂)₉-CH=CH₂ |
| **424** | R5 | R5 | -(CH₂)₂-cyclohex-3-enyl |
| **425** | R5 | R5 | cyclopent-2-enyl |
| **426** | R5 | R5 | cyclohex-3-enyl |
| **427** | R5 | R5 | Z-cyclooct-4-enyl |
| **428** | R5 | R5 | 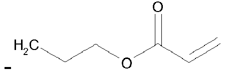 |
| **429** | R5 | R5 | 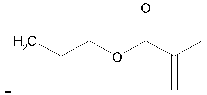 |
| **430** | R5 | R5 | 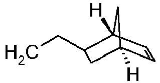 |
| **431** | R5 | R5 | 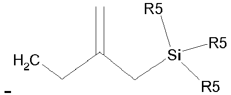 |
| **432** | R5 | R5 | -(CF₂)₈(CH₂)₂-CH=CH₂ |
| **433** | R5 | R5 | -(CH₂)₂ (CF₂)₈-CH=CH₂ |
| **434** | -CH=CH₂ | -CH=CH₂ | -CH=CH₂ |
| **435** | OMe | R5 | -CH=CH₂ |
| **436** | OMe | OMe | -CH₂-CH=CH₂ |
| **437** | 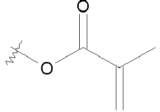 | 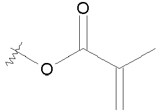 | 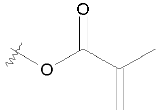 |

In dieser Tabelle ist:

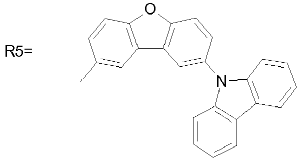

Verfahren zur radikalischen Vernetzung bzw. Polymerisation sind dem Fachmann an sich bekannt. Es können erfindungsgemäß dem Fachmann bekannte Radikalstarter, beispielsweise AIBN, oder 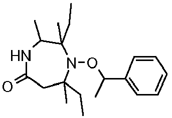 verwendet werden.

In einer bevorzugten Ausführungsform der vorliegenden Erfindung ist die wenigstens eine polymerisierbare oder vernetzbare Gruppe ausgewählt aus der Gruppe bestehend aus C-C-Doppelbindung, Acrylate, Methacrylate, oder 1,2-Epoxyether.

Wenn die Verbindungen der allgemeinen Formel (I) oder (I*) als vernetzbare oder polymerisierbare Gruppe -CH=CH₂-, Acrylate oder Methacrylate enthalten, kann die Polymerisation beispielsweise photochemisch durchgeführt werden, unter Verwendung bekannter Photoinitiatoren, beschrieben beispielsweise in "Chemistry & Technology of UV & EB Formulations for Coatings, Inks and Paints, Vol. 3: Photoinitiators for Free Radical and Cationic Polymerization" 1991, p. 1115-325). Bekannte Photoinitiatoren werden beispielsweise in einer Menge von 0,5 bis 5 Gew.-%, basierend auf der Gesamtmenge aller vorliegenden Monomere, zu der Reaktionsmischung gegeben.

Weitere geeignete Polymerisationsverfahren sind die Epoxypolymerisation, verschiedene Metathese Reaktionen, beispielsweise beschrieben in Ivin, K. J. and Mol, J. C., Olefin Metathesis and Metathesis Polymerization (Academic Press 1997), wie z. B, Ring-öffnende Methathese, ADMET (Acyclische Dien Olefin Metathese), oder Hydrosilylierung.

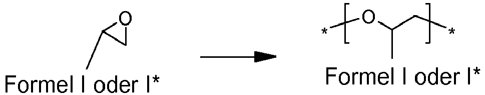

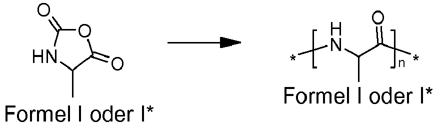

Eine Hydrosilylierung kann beispielsweise durch UV Strahlung initiiert werden, und kann von Radikalbildnern, Übergangsmetallkomplexen oder Lewis Basen, beispielsweise H₂PtCl₆, RhCl(PPh₃)₃ oder trans-IrCl(CO)(PPh₃)₂ katalysiert werden. 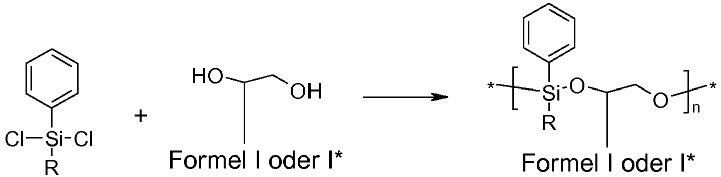 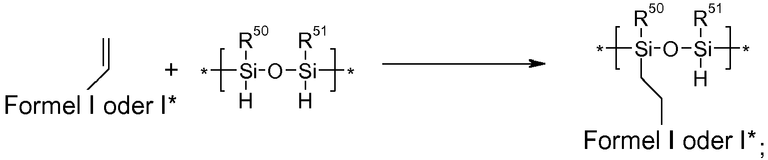 wobei R⁵⁰ und R⁵¹ unabhängig voneinander C₁-C₈-Alkyl, C₆-C₂₄-Aryl oder C₇-C₁₂-Aralkyl bedeuten.

Die aus den erfindungsgemäßen Verbindungen der allgemeinen Formel (I) oder (I*) gebildeten Polymere enthalten eine oder mehrere Verbindungen der allgemeinen Formel (I) oder (I*) in vernetzter oder polymerisierter Form. Es ist ebenfalls möglich, dass neben den Verbindungen der allgemeinen Formel (I) oder (I*) weitere Monomere mitpolymerisiert werden, so dass entsprechende Copolymere gebildet werden. Entsprechende Beispiele werden in der WO 2007/090733 genannt.

Die weiteren Monomeren können auch lochleitende wie RG^{I} und/oder elektronenleitende Einheiten wie RG" wie in WO 2007/090733 beschrieben, sein.

Die vorliegende Erfindung betrifft auch vernetzte oder polymere Materialien umfassend Wiederholungseinheiten der allgemeinen Formel (I) und (I*) in vernetzter oder polymerisierter Form und ihre Verwendung in elektronischen Bauteilen.

Vernetzte oder polymere Materialien gemäß der vorliegenden Erfindung weisen eine hervorragende Löslichkeit in organischen Lösungsmitteln, hervorragende Filmformende Eigenschaften und relativ hohe Glasübergangstemperaturen auf. Zusätzlich können hohe Ladungsträgermobilitäten, hohe Stabilitäten der Farbemission und lange Betriebszeiten der entsprechenden Bauteile beobachtet werden, wenn vernetzte oder polymere Materialien gemäß der vorliegenden Erfindung in organischen Licht-emittierenden Dioden (OLEDs) verwendet werden.

Die erfindungsgemäßen vernetzten oder polymersierten Materialien eignen sich besonders als Beschichtungen oder in dünnen Filmen, da sie thermisch und mechanisch stabil und relativ defektfrei sind.

Als Verfahren zur Herstellung dieser dünnen Filme eignen sich beispielsweise die Vakuumablagerung, das Spin-coating, die Casting-Methode, die Langmuir-Blodgett ("LB")-Methode, die Tintenstrahldruck-Methode, Dip-coating, Letterpress-Druck, Screen-Druck, Doctor-blade-printing, Roller-printing, Reverse-Roller-printing, Offset-Lithography-Druck, flexographischer Druck, Webprinting, Sprühbeschichtung, Beschichtung durch einen Pinsel oder Padprinting und ähnliche.

Unter den genannten Verfahren sind die Vakuumablagerung, das Spin-coating, die Tintenstrahldruck-Methode und die Casting-Methode bevorzugt, da sie besonders einfach und kostengünstig durchzuführen sind.

Die einzelnen Bauteilschichten, insbesondere die Lichtemissionsschicht, können aus einer Mischung der erfindungsgemäßen Verbindungen und/oder Materialien und gegebenenfalls weiteren Verbindungen gebildet werden. Die nicht-konjugierten Polymere der vorliegenden Erfindung sind besonders nützlich als Wirtsmaterialien für phosphoreszente Verbindungen (Triplett-Emitter) in organischen Licht-emittierenden Dioden (OLEDs).

Für den Fall, dass Schichten durch die Spin-Coating-Methode, die Casting-Methode oder die Tintenstrahldruckmethode erzeugt werden, kann die Beschichtung unter Verwendung einer Lösung, hergestellt durch Auflösen der Zusammensetzung in einer Konzentration von 0,0001 bis 90 Gew.-% in einem geeigneten organischen Lösungsmittel wie Benzol, Toluol, Xylol, Tetrahydrofuran, Methyltetrahydrofuran, N,N-Dimethylformamid, Aceton, Acetonitril, Anisol, Dichlormethan, Dimethylsulfoxid und Mischungen davon, erhalten werden.

Die vorliegende Erfindung betrifft insbesondere auch die Verwendung einer erfindungsgemäßen Verbindung der allgemeinen Formeln (I) oder (I*) als Bausteine in Polymerisations- und/oder Vernetzungsreaktionen.

Des Weiteren betrifft die vorliegende Erfindung ein Verfahren zur Herstellung eines vernetzten oder polymerisierten Materials enthaltend wenigstens eine erfindungsgemäße Verbindung der allgemeinen Formeln (I) oder (I*) umfassend die Schritte:
(A) Herstellen einer vernetzbaren oder polymerisierbaren Verbindung der allgemeinen Formeln (I) oder (I*), wobei wenigstens eines aus R¹, R², R³, R⁴, R⁵, R⁸, R⁹, R¹⁰, R¹¹, R¹², R¹³, R¹⁴, R¹⁵, R²², R²³, R²⁴, R²⁵ oder R²⁸ eine über einen Spacer angebundene vernetzbare oder polymerisierbare Gruppe bedeutet, und
(B) Vernetzung oder Polymerisation der aus Schritt (A) erhaltenen Verbindung der allgemeinen Formeln (I) oder (I*).

Schritt (A) umfasst das Herstellen der vernetzbaren oder polymerisierbaren Verbindungen. Dies erfolgt bevorzugt nach dem erfindungsgemäßen Verfahren.

Die Polymerisation gemäß Schritt (B) wird ebenfalls gemäß den oben beschriebenen Verfahren durchgeführt.

Die vorliegende Erfindung betrifft auch ein vernetztes oder polymerisiertes Material, welches Einheiten der allgemeinen Formel (I) oder (I*) die vernetzbare oder polymerisierbare Gruppen enthalten in vernetzter oder polymerisierter Form enthält. Dieses Material wird bevorzugt nach den genannten Polymerisationsverfahren erhalten.

Dabei kann es sich erfindungsgemäß um Homopolymere handeln, d. h. ausschließlich Einheiten der allgemeinen Formel (I) oder (I*) liegen in vernetzter oder polymerisierter Form vor. Erfindungsgemäß sind auch Copolymere umfasst, d. h. neben den Einheiten der allgemeinen Formel (I) oder (I*) liegen in vernetzter oder polymerisierter Form weitere Monomere, beispielsweise Monomere mit lochleitenden und/oder elektronenleitenden Eigenschaften, vor.

Das durch das erfindungsgemäße Verfahren erhaltene vernetzte oder polymerisierte Material, welches Einheiten der allgemeinen Formel (I) oder (I*) enthält, eignet sich besonders für den Einsatz in organisch-elektronischen Anwendungen, insbesondere in OLEDs.

Daher betrifft die vorliegende Erfindung auch die Verwendung des vernetzten oder polymersierten Material, welches Einheiten der allgemeinen Formel (I) oder (I*) enthält in organisch-elektronischen Anwendungen, insbesondere in OLEDs.

In den oben genannten Verbindungen der Formel (I) oder (I*) können Partialstrukturen wie beispielsweise Carbazol-, Triphenylsilyl- und Phosphinoxidstrukturen in einem Molekül kombiniert sein, was zu einer verbesserten Wechselwirkung mit dem Emittermolekül (wenn die Verbindungen als Matrixmaterialien eingesetzt werden) und damit hohen Quanten- und Stromeffizienzen führen kann. Durch die Asymmetrie dieser Verbindungen kann das Material weiterhin in amorpher Form aus der Gasphase abgeschieden werden. Amorphe organische Materialien weisen im Allgemeinen eine bessere Langzeitstabilität als kristalline organische Materialien auf. Eine solche Verbindung der Formel (I) oder (I*) kann beispielsweise die Verbindung (Ia) sein:

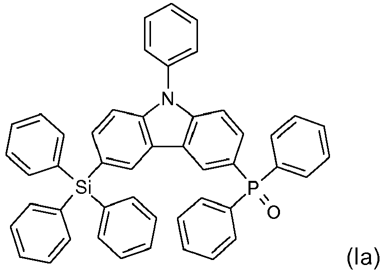

Im Vergleich zu einer Referenzverbindung mit beispielsweise einer Carbazol- und zwei Triphenylsilyl-Partialstrukturen ist in einer Verbindung der allgemeinen Formel (I) oder (I*) mit einer Carbazol-, einer Triphenylsilyl- und einer Phosphinoxideinheit, beispielsweise einer Verbindung (la), die Ladungsträgerbeweglichkeit, insbesondere die Elektronenbeweglichkeit, erhöht. Damit kann beispielsweise die Betriebsspannung einer OLED bei gleichbleibender Luminanz gesenkt werden.

Die Verbindungen der Formel (I) oder (I*) oder ein entsprechendes vernetztes oder polymerisiertes Material können als Matrixmaterialien und/oder Blockermaterialien und/oder Elektronen- und/oder Lochleiter von weißes Licht emittierenden OLEDs eingesetzt werden

### Herstellung der erfindungsgemäßen und erfingdungsgemäß eingesetzten Verbindungen der Formel (I) oder (I*)

Die Verbindungen der Formel (I) oder *(I*)* können grundsätzlich nach dem Fachmann bekannten Verfahren hergestellt werden, z. B. können Carbazole der Formel (I) oder *(I*)* (X = NR) thermisch oder photochemisch durch oxidativen Ringschluss aus Diphenylamin (oder geeignet substituierten Derivaten davon) und gegebenenfalls nachfolgende Substitution, z. B. am Stickstoff, hergestellt werden. Des Weiteren können die Carbazole der Formel (I) oder *(I*)* ausgehend von den geeignet substituierten Tetrahydrocarbazolen durch Oxidation erhalten werden. Eine typische Carbazol-Synthese ist die Borsche-Drechsel-Cyclisierung (Borsche, Ann., 359, 49 (1908); Drechsel, J. prakt. Chem., [2], 38, 69, 1888). Die vorstehend erwähnten Tetrahydrocarbozole können gemäß dem Fachmann bekannten Verfahren hergestellt werden, z. B. durch Kondensation von ggf. geeignet substituiertem Phenylhydrazin mit ggf. geeignet substituiertem Cyclohexanon, wobei das entsprechende Imin erhalten wird. In einem anschließenden Schritt erfolgt eine Säure katalysierte Umlagerungs- und Ringschlussreaktion, wobei das entsprechende Tetrahydrocarbozol erhalten wird. Es ist ebenfalls möglich, die Herstellung des Imins und die Umlagerungs- und Ringschlussreaktion in einem Schritt durchzuführen. Dieses wird - wie vorstehend erwähnt - zu dem gewünschten Carbazol oxidiert.

Die Herstellung der Verbindungen der Formel (I) oder (I*) erfolgt bevorzugt ausgehend von dem entsprechenden Grundgerüst der Formel (II): 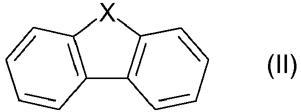 wobei X NR, S, O oder PR oder NH oder PH oder PPh bedeutet. Geeignete Grundgerüste der Formel (II) sind entweder kommerziell erhältlich (insbesondere in den Fällen, wenn X S, O, NH oder PPh bedeutet) oder nach dem Fachmann bekannten Verfahren (X= PH) herstellbar.

Die Reste R können in dem Fall, dass X NH oder PH bedeutet, vor oder nach dem Einbringen der Reste R⁴, R⁵, SiR¹R²R³ und A, soweit die Reste R⁴ und R⁵ in den Verbindungen der Formel (I) oder (I*) vorliegen, bzw. zur Einführung der Reste R⁴, R⁵, SiR¹R²R³ und A geeigneten Vorläuferverbindungen, eingebracht werden. Somit sind drei Varianten - im Fall von X = NR und PR - möglich:

### Variante a)

ia) Herstellung einer zur Einführung der Reste R⁴, R⁵, SiR¹R²R³ und A geeigneten Vorläuferverbindung,
iia) Einbringen des Rests R,
iiia) Einbringen der Reste R⁴, R⁵, soweit vorhanden, sowie der Reste SiR¹R²R³ und A.

### Variante b)

Variante b) ist insbesondere dann bevorzugt, wenn R Alkyl oder Aryl oder alkylsubstituiertes Aryl ist.
ib) Einbringen des Rests R,
iib) Herstellung einer zur Einführung der Reste R⁴, R⁵, SiR¹R²R³ und A geeigneten Vorläuferverbindung,
iiib) Einbringen der Reste R⁴, R⁵, soweit vorhanden, sowie der Reste SiR¹R²R³ und A.

### Variante c)

ic) Herstellung einer zur Einführung der Reste R⁴, R⁵, SiR¹R²R³ und A geeigneten Vorläuferverbindung,
iic) Einbringen der Reste R⁴, R⁵, soweit vorhanden, sowie der Reste SiR¹R²R³ und A,
iiic) Einbringen des Rests R.

In dem Fall, dass X in Formel (II) NR, S, O oder PR bedeutet, entfällt der Schritt "Einbringen des Rests R", so dass das Verfahren die folgenden Schritte (*Variante d*) umfasst:
id) Herstellung einer zur Einführung der Reste R⁴, R⁵, SiR¹R²R³ und A geeigneten Vorläuferverbindung,
iid) Einbringen der Reste R⁴, R⁵, soweit vorhanden, sowie der Reste SiR¹R²R³ und A.

In einer weiteren Ausführungsform betrifft die vorliegende Erfindung daher ein Verfahren zur Herstellung der erfindungsgemäßen und erfindungsgemäß eingesetzten Verbindungen der Formel (I) oder (I*),
ausgehend von einem Grundgerüst der Formel (II): 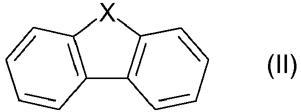 wobei X NR, S, O oder PR oder NH oder PH oder PPh bedeutet, werden die Reste R, R⁴, R⁵, SiR¹R²R³ und A, soweit die Reste R⁴ und R⁵ in den Verbindungen der Formel (I) oder (I*) vorliegen, nach einer der folgenden Varianten a), b), c) oder d) eingebracht,

### Variante a)

ia) Herstellung einer zur Einführung der Reste R⁴, R⁵, SiR¹R²R³ und A geeigneten Vorläuferverbindung,
iia) Einbringen des Rests R,
iiia) Einbringen der Reste R⁴, R⁵, soweit vorhanden, sowie der Reste SiR¹R²R³ und A;
oder

### Variante b)

ib) Einbringen des Rests R,
iib) Herstellung einer zur Einführung der Reste R⁴, R⁵, SiR¹R²R³ und A geeigneten Vorläuferverbindung,
iiib) Einbringen der Reste R⁴, R⁵, soweit vorhanden, sowie der Reste SiR¹R²R³ und A; oder

### Variante c)

ic) Herstellung einer zur Einführung der Reste R⁴, R⁵, SiR¹R²R³ und A geeigneten Vorläuferverbindung,
iic) Einbringen der Reste R⁴, R⁵, soweit vorhanden, sowie der Reste SiR¹R²R³ und A,
iiic) Einbringen des Rests R;
oder

### Variante d)

id) Herstellung einer zur Einführung der Reste R⁴, R⁵, SiR¹R²R³ und A geeigneten Vorläuferverbindung,
iid) Einbringen der Reste R⁴, R⁵, soweit vorhanden, sowie der Reste SiR¹R²R³ und A.

Die in den Verbindungen der Formel (I) oder (I*) genannten Reste und Gruppen m, n, R, R⁴, R⁵, SiR¹R²R³ und A wurden vorstehend definiert.

### Schritt ia), iib), ic) und id)

Als Vorläuferverbindungen zur Einführung der Reste R⁴, R⁵, SiR¹R²R³ und A sind insbesondere die entsprechenden halogenierten, bevorzugt bromierten Verbindungen der allgemeinen Formel (III) geeignet: 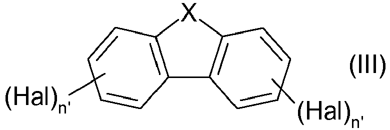 wobei Hal Halogen, bevorzugt Brom oder Iod, besonders bevorzugt Brom, bedeutet, n' jeweils 0 oder 1 (wobei mindestens ein n' in Formel (III) 1 ist) ist und X in Schritt ia) und ic) X NH oder PH bedeutet, X in Schritt ib) NR oder PR bedeutet und X in Schritt id) NR, S, O oder PR bedeutet.

Die Halogenierung kann gemäß dem Fachmann bekannten Verfahren durchgeführt werden. Bevorzugt erfolgt eine Bromierung oder lodierung in 3- und 6-Position (Dibromierung) oder in 3- oder in 6-Position (Monobromierung) des Grundgerüsts der Formel (II) 2,8-Position (Dibenzofuran und Dibenzothiophen) oder 3,6-Position (Carbazol).

Gegebenenfalls substituierte Dibenzofurane, Dibenzothiophene und Carbazole können in 2,8-Position (Dibenzofuran und Dibenzothiophen) oder 3,6-Position (Carbazol) mit Brom oder NBS in Eisessig oder in Chloroform dibromiert werden. Beispielsweise kann die Bromierung mit Br₂ in Eisessig oder Chloroform bei tiefen Temperaturen, z.B. 0°C erfolgen. Geeignete Verfahren sind z.B. für X= NPh in M. Park, J.R. Buck, C.J. Rizzo, Tetrahedron, 1998, 54, 12707-12714 und für X= S in W. Yang et al., J. Mater. Chem. 2003, 13, 1351 beschrieben. Des Weiteren sind 3,6-Dibromcarbazol, 3,6-Dibrom-9-phenylcarbazol, 2,8-Dibromdibenzothiophen, 2,8-Dibromdibenzofuran, 2-Bromcarbazol, 3-Bromdibenzothiophen, 3-Bromdibenzofuran, 3-Bromcarbazol, 2-Bromdibenzothiophen und 2-Bromdibenzofuran kommerziell erhältlich.

Eine Monobromierung in 4-Position von Dibenzofuran (und analog für Dibenzothiophen) ist z.B. beschrieben in J. Am. Chem. Soc. 1984, 106, 7150. Eine Monobromierung von Dibenzofuran (Dibenzothiophen) in 3-Position kann durch eine dem Fachmann bekannte Sequenz umfassend eine Nitrierung, Reduktion und anschliessende Sandmeyer Reaktion erfolgen.

Die Monobromierung in 2-Position von Dibenzofuran oder Dibenzothiophen und die Monobromierung in 3-Position von Carbazol erfolgt analog an der Dibromierung, mit der Ausnahme, dass nur 1 Äquivalent Brom oder NBS zusetzt wird.

Bevorzugt werden auch iodierte Dibenzofurane, Dibenzothiophene und Carbazole benutzt. Auch gemischte (einmal iodierte + einmal bromierte) Verbindungen können eingesetzt werden.

Die Herstellung wird u.a. beschrieben in Tetrahedron. Lett. 2006, 47, 6957-6960, Eur. J. Inorg. Chem. 2005, 24, 4976-4984, J. Heterocyclic Chem. 2002, 39, 933-941, J. Am. Chem. Soc. 2002, 124, 11900-11907, J. Heterocyclic Chem. 2001, 38, 77-87.

Für die nucleophile Substitution werden Cl oder F substituierten Dibenzofurane, Dibenzothiophene und Carbazole benötigt. Die Chlorierung wird u.a. beschrieben in J. Heterocyclic Chemistry, 1997, 34, 891-900, Org. Lett., 2004, 6, 3501-3504; J. Chem. Soc. [Section] C: Organic, 1971, 16, 2775-7, Tetrahedron Lett. 1984, 25, 5363-6, J. Org. Chem. 2004, 69, 8177-8182. Die Fluorierung wird beschrieben in J. Org. Chem. 1998, 63, 878-880 und J. Chem. Soc., Perkin Trans. 2 2002, 5, 953-957.

### Schritt iia), ib) und iiic)

Die Einführung des Restes R erfolgt nach dem Fachmann bekannten Verfahren.

Die Einführung des Restes erfolgt bevorzugt durch Umsetzung des Grundgerüsts der Formel (III) bzw. der Verbindung der Formel (III) mit einem Alkylhalogenid bzw. Arylhalogenid bzw. Heteroarylhalogenid der Formel R-Hal, wobei R bereits vorstehend definiert wurde und Hal F, Cl, Br oder I, bevorzugt Br, I oder F, bedeutet.

Die Einführung des Restes R wird im Allgemeinen in Anwesenheit einer Base durchgeführt. Geeignete Basen sind dem Fachmann bekannt und bevorzugt ausgewählt aus der Gruppe bestehend aus Alkali- und Erdalkalihydroxiden wie NaOH, KOH, Ca(OH)₂, Alkalihydriden wie NaH, KH, Alkaliamiden wie NaNH₂, Alkali- oder Erdalkalimetallcarbonaten wie K₂CO₃ oder Cs₂CO₃, und Alkalimetallalkoxiden wie NaOMe, NaOEt. Des Weiteren sind Gemische der vorstehend genannten Basen geeignet. Besonders bevorzugt sind NaOH, KOH, NaH, oder K₂CO₃.

Die N-Alkylierung (zum Beispiel offenbart in M. Tosa et al., Heterocycl. Communications, Vol. 7, No. 3, 2001, S. 277 - 282) bzw. N-Arylierung oder N-Heteroarylierung (zum Beispiel (N-Arylierung ) offenbart in H. Gilman und D. A. Shirley, J. Am. Chem. Soc. 66 (1944) 888; D. Li et al., Dyes and Pigments 49 (2001) 181 - 186) wird bevorzugt in einem Lösungsmittel durchgeführt. Geeignete Lösungsmittel sind z.B. polare aprotische Lösungsmittel wie Dimethylsulfoxid, Dimethylformamid oder Alkohole. Es ist ebenfalls möglich, einen Überschuss des eingesetzten Alkyl- oder (Hetero)arylhalogenids als Lösungsmittel einzusetzen. Die Umsetzung kann des Weiteren in einem unpolaren aprotischen Lösungsmittel, z.B. Toluol, durchgeführt werden, wenn ein Phasentransferkatalysator, z.B. tetra-n-Butylammoniumhydrogensulfat, anwesend ist (wie z. B. in I. Gozlan et al., J. Heterocycl. Chem. 21 (1984) 613 - 614 offenbart ist).

Die N-(Hetero)arylierung kann zum Beispiel durch Kupfer-katalysierte Kupplung der Verbindung der Formel (II) oder (III) mit einem (Hetero)arylhalogenid, z.B einem Aryliodid erfolgen (Ullmann-Reaktion).

Bevorzugt erfolgt die Einführung des Restes R durch Umsetzung der Verbindung der Formel (II) oder (III) mit einem Alkyl-, Aryl- oder Heteroarylfluorid in Anwesenheit von NaH in DMF (nucleophile Substitution) oder durch Umsetzung mit einem Alkyl-, Aryl- oder Heteroarylbromid oder-iodid unter Cu/Base (Ullmann, s.o) oder Pd Katalyse.

Das molare Verhältnis der Verbindung der Formel (II) oder (III) zu dem Alkylhalogenid bzw. (Hetero)arylhalogenid der Formel R¹-Hal beträgt im Allgemeinen 1 : 1 bis 1 : 15, bevorzugt 1 : 1 bis 1 : 6, besonders bevorzugt 1:4.

Die N-Alkylierung bzw. N-(Hetero)arylierung wird im Allgemeinen bei einer Temperatur von 0 bis 220 °C, bevorzugt 20 bis 200 °C durchgeführt. Die Reaktionsdauer beträgt im Allgemeinen 0,5 bis 48 h, bevorzugt 1 bis 24 h. Im Allgemeinen wird die N-Alkylierung bzw. N-Arylierung bei Normaldruck durchgeführt.

Das erhaltene Rohprodukt wird gemäß dem Fachmann bekannten Verfahren aufgearbeitet.

Bevorzugte Ausführungsformen des Schritts iia), ib) und iiic) sind nachstehend in allgemeiner Form am Beispiel von R = substituiertes Phenyl (R" = vorstehend genannter Substituent am Arylrest; q = 0, 1, 2, 3, 4 oder 5) dargestellt:

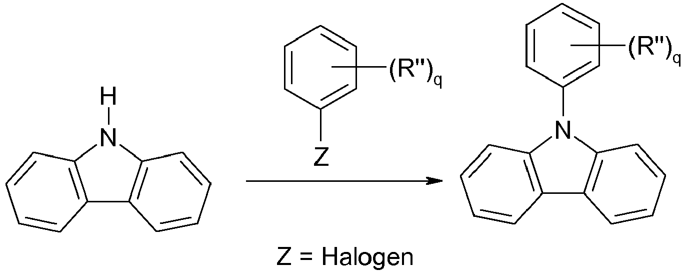

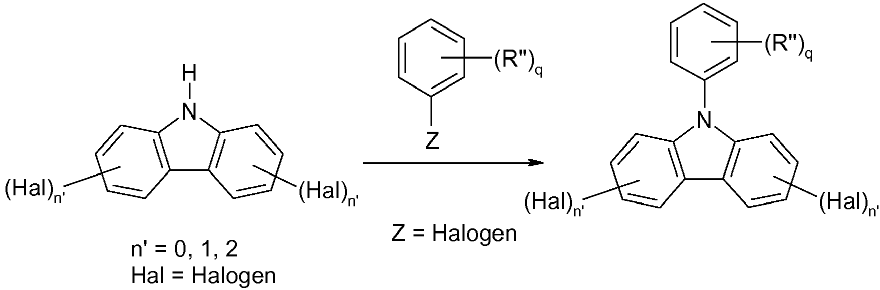

### Schritt iiia), iiib), iic) und iid)

Die Herstellung der gewünschten Verbindungen der Formel (I) oder (I*) erfolgt ausgehend von den halogenierten Vorläuferverbindungen der Formel (III) im Allgemeinen durch die folgenden Schritte:
aa) Halogen/Metallaustausch oder Metallierung, bevorzugt Lithiierung, besonders bevorzugt Ortholitiierung, und anschließende Silylierung nach dem Fachmann bekannten Verfahren, wobei eine Verbindung der Formel (IVa) erhalten wird; 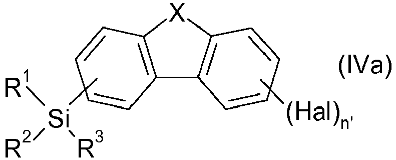
ab) Kupplungsschritt zur Einführung des Restes A, wobei die gewünschte Verbindung der Formel (I) oder (I*) erhalten wird.

Alternativ können die gewünschten Verbindungen der Formel (I) oder (I*) ausgehend von den halogenierten Vorläuferverbindungen der Formel (III) im Allgemeinen durch die folgenden Schritte hergestellt werden:
ba) Kupplungsschritt zur Einführung des Restes A, wobei die gewünschte Verbindung der Formel (IVb) erhalten wird; 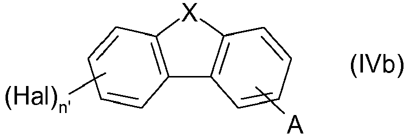
bb) Halogen/Metallaustausch und anschließende Silylierung nach dem Fachmann bekannten Verfahren, wobei die gewünschte Verbindung der Formel (I) oder (I*) erhalten wird.

### Schritt aa) bzw. Schritt bb): Halogen/Metallaustausch und anschließende Silylierung

Bevorzugt erfolgt Schritt aa) bzw. Schritt bb) in einem ersten Schritt durch Halogen/Metallaustausch durch Umsetzung der halogenierten Verbindungen der Formel (III) mit Alkyllithiumverbindungen oder Mg bei Temperaturen von Allgemeinen -80°C bis + 80 °C, bevorzugt bei -40°C bis 30°C (für Alkyllithiumverbindungen) oder 0°C bis 80°C (für Mg), besonders bevorzugt von 0°C bis 40°C (für Mg). Besonders bevorzugt werden Alkyllithiumverbindungen, insbesondere n-BuLi oder tert.-BuLi eingesetzt. Besonders bevorzugt werden zuerst das (Chlor)silan und Arylhalide, d. h. das halogenierte Grundgerüst (II), zusammen vorgelegt, dann werden n-BuLi oder tert-BuLi zugetropft.

Daher betrifft die vorliegende Erfindung insbesondere das erfindungsgemäße Verfahren, wobei das Silanedukt gleichzeitig mit dem halogenierten Grundgerüst (II) vorgelegt wird und dann das Metallreagenz zugegeben wird.

Die Umsetzung erfolgt im Allgemeinen in einem Lösungsmittel, bevorzugt in THF oder Ether, bevorzugt Diethylether. Erfindungsgemäß sind die Syntheseausbeuten besonders gut, wenn Diethylether als Lösungsmittel benutzt wird.

Daher betrifft die vorliegende Erfindung bevorzugt das erfindungsgemäße Verfahren, wobei ein Halogen-Metallaustausch am halogenierten Grundgerüst (II) in Diethylether als Lösungsmittel durchgeführt wird

In einer weiteren Ausführungsform erfolgt in Schriit aa) anstelle des Halogen/Metallaustausches eine Metallierung, bevorzugt eine Lithiierung, besonders bevorzugt eine Ortholithiierung. Eine Lithiierung, bevorzugt eine Ortholithiierung ist dem Fachmann an sich bekannt, beispielsweise bei einer Temperatur von 100 °C bis 25 °C, bevorzugt bei -78°C bis RT, besonders bevorzugt -40°C bis 0°C. Die erfindungsgemäße Metallierung wird bevorzugt in einem aprotischen Lösungsmittel durchgeführt, beispielsweise in THF. Nach erfolgter Metallierung wird anschliessend in einem zweiten Schritt das entsprechende Silanreagenz in einem Lösungsmittel, beispielsweise in THF, zugegeben. Dies ist im Folgenden näher erläutert.

In einem direkt anschließenden zweiten Schritt erfolgt eine Silylierung zu den Verbindungen der Formel (IVa), bevorzugt durch Umsetzung mit SiRₘCl₍₄₋ₘ₎ oder SiRₘH₍₄₋ₘ₋ₙ₎Clₙ, wobei m 0, 1, 2 oder 3 und n 0, 1, 2 und n+m ≤3 bedeutet. Die Benutzung von Si-H-Verbindungen wird beschrieben in H.Gilman, W.J. Trepka J. Org. Chem. 1962, 27(4), 1418-1422. Si-H Verbindungen sind im Allgemeinen stabiler als die Chlorsilanen. Die Silylierung wird im Allgemeinen in einem Lösungsmittel durchgeführt. Bevorzugte Lösungsmittel sind THF oder Ether, bevorzugt Diethylether. Im Allgemeinen erfolgt die Silylierung in direktem Anschluss an die Umsetzung im ersten Schritt, ohne Aufarbeitung oder Isolierung des nach dem ersten Schritt erhaltenen Produktes.

In dem Fall, wenn der Halogen/Metall-Austausch und die anschließende Silylierung an einer Verbindung der Formel (III) durchgeführt werden, worin X = NH oder PH bedeutet (Variante c), Schritt iic)), ist es erforderlich, die NH oder PH Gruppe durch eine Schutzgruppe zu schützen und im Anschluss an die Silylierung wieder zu entschützen.

Die Einbringung der Schutzgruppe erfolgt gemäß dem Fachmann bekannten Verfahren. Im Allgemeinen erfolgt zunächst eine Deprotonierung und anschließend die Einführung einer Schutzgruppe. Geeignete N-H und P-H Schutzgruppen sind dem Fachmann bekannt, wobei Silyl-Schutzgruppen, insbesondere SiR₃ mit R = Alkyl oder Aryl, bevorzugt Methyl, Ethyl, Phenyl, für dieses Verfahren besonders geeignet sind. Die Deprotonierung erfolgt üblicherweise mit Basen, z.B. mit NaH, nBuLi oder tert.-BuLi.

Das Entschützen erfolgt ebenfalls gemäß dem Fachmann bekannten Verfahren. Geeignete Reagenzien zum Entschützen richten sich nach den eingesetzten Schutzgruppen. Bei Einsatz von SiR₃ als Schutzgruppe erfolgt die Entschützung im Allgemeinen mit einer Säure oder TBAF (Tetrabutylammoniumfluorid).

### Schritt ab) bzw. ba): Kupplung

Die Einführung der Gruppe A kann nach den bezüglich der Einführung des Restes R genannten Verfahren durchgeführt werden. Im Allgemeinen wird die Gruppe A in Anwesenheit einer Base durchgeführt. Geeignete Basen sind dem Fachmann bekannt und bevorzugt ausgewählt aus der Gruppe bestehend aus Alkali- und Erdalkalihydroxiden wie NaOH, KOH, Ca(OH)₂, Alkalihydriden wie NaH, KH, Alkaliamiden wie NaNH₂, Alkali- oder Erdalkalimetallcarbonaten wie K₂CO₃ oder Cs₂CO₃, und Alkalimetallalkoxiden wie NaOMe, NaOEt. Des Weiteren sind Gemische der vorstehend genannten Basen geeignet. Besonders bevorzugt sind NaOH, KOH, NaH, oder K₂CO₃.

Heteroarylierung kann zum Beispiel durch Kupfer-katalysierte Kupplung des Restes A mit einer halogenierten Verbindung der Formal (III) bzw. (IVa) erfolgen (Ullmann-Reaktion).

Die N-Arylierung wurde z.B, offenbart in H. Gilman und D. A. Shirley, J. Am. Chem. Soc. 66 (1944) 888; D. Li et al., Dyes and Pigments 49 (2001) 181 - 186). Die Reaktion kann in Lösungsmittel oder in einer Schmelze durchgeführt werden. Geeignete Lösungsmittel sind z.B. (polare) aprotische Lösungsmittel wie Dimethylsulfoxid, Dimethylformamid, NMP, Tridecan oder Alkohole. Es ist ebenfalls möglich, einen Überschuss eines der eingesetzten Ausgangsprodukte (Verbindung der Formel (III) oder (IVa) oder Vorlaüferverbindung der Gruppe A) als Lösungsmittel einzusetzen.

Bevorzugt erfolgt die Einführung des Restes A durch Umsetzung der Verbindung der Formel (III) oder (IVa) in Anwesenheit von NaH in DMF (nucleophile Substitution) oder durch Umsetzung unter Cu/Base (Ullmann, s.o) oder Pd Katalysebedingungen.

Die N-Alkylierung bzw. N-(Hetero)arylierung wird im Allgemeinen bei einer Temperatur von 0 bis 220 °C, bevorzugt 20 bis 200 °C durchgeführt. Die Reaktionsdauer beträgt im Allgemeinen 0,5 bis 76 h, bevorzugt 1 bis 48 h.

Das erhaltene Rohprodukt (gewünschte Verbindung der Formel (I) oder (I*)) wird gemäß dem Fachmann bekannten Verfahren aufgearbeitet.

Alternativ können noch zusätzliche Halogenierungschritte an der gewünschten Verbindung der Formel (I) oder (I*) durchgeführt werden werden, gefolgt von Kupplungen und/oder Silylierungen, um gegebenenfalls die Reste R⁴ und R⁵ einzuführen.

Die Einführung von über Phosphor angebundenen Substituenten erfolgt über einen Halogen/Metallaustauch, wie oben beschrieben und eine anschließende Reaktion mit einer Chlorphosphinverbindung. Wenn das Zielprodukt ein Phosphinoxid ist, wird nachträglich noch oxidiert mit z.B. H₂O₂ in Wasser oder mCPBA in CH₂Cl₂.

Im Folgenden ist ein allgemeines Verfahrensschema zur Herstellung der erfindungsgemäßen Verbindungen der Formel (I) oder (I*) dargestellt: 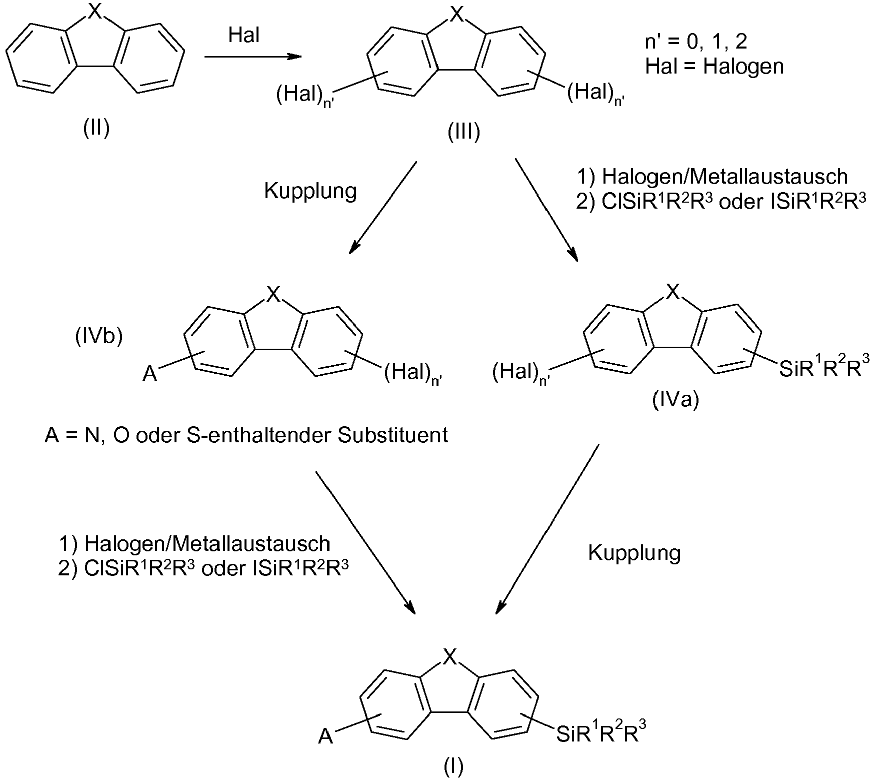 Verbindungen der allgemeinen Formel (I*) werden analog hergestellt oder via Ortholithierung und Silylierung, wie oben beschrieben.

Die erfindungsgemäßen eingesetzten Verbindungen der Formel (I) oder (I*) oder ein erfindungsgemäßes vernetztes oder polymerisiertes Material können in organisch elektronischen Anwendungen ausgewählt aus schaltenden Elementen wie organischen Transistoren, z. B. organischen FET und organischen TFT, organischen Solarzellen und organischen Leuchtdioden (OLED) eingesetzt werden, wobei die Verbindungen der Formel (I) oder (I*) bevorzugt in OLEDs eingesetzt werden.

Ein weiterer Gegenstand der vorliegenden Anmeldung ist daher die Verwendung der Verbindungen der Formel (I) oder (I*) oder ein erfindungsgemäßes vernetztes oder polymerisiertes Material in organisch-elektronischen Anwendungen, bevorzugt in O-LEDs.

Die Verbindungen der Formel (I) oder (I*) oder ein erfindungsgemäßes vernetztes oder polymerisiertes Material zeichnen sich dadurch aus, dass sie mindestens eine Silyl- und mindestens eine Heteroatomsubstitution an einem Carbazol-, Dibenzofuran-, Dibenzothiophen- oder Dibenzophosphol-Grundgerüst aufweisen. Diese speziellen Verbindungen zeichnen sich insbesondere dadurch aus, dass sie die gute Effizienzen, gute operative Lebensdauern sowie eine hohe Stabilität gegenüber Temperaturbelastung und eine niedrige Einsatz- und Betriebsspannung der organisch-elektronischen Anwendungen, insbesondere der OLEDs gewährleisten.

Die Verbindungen der Formel (I) oder (I*) oder ein erfindungsgemäßes vernetztes oder polymerisiertes Material können als Matrixmaterial und/oder Loch-/Excitonenblockermaterial und/oder Elektronen-/Excitonenblockermaterial und/oder Loch-Injektionsmaterial und/oder Elektronen-Injektionsmaterial und/oder Lochleitermaterial und/oder Elektronenleitermaterial, bevorzugt als Matrixmaterial und/oder Loch-/Excitonenblockermaterial in organisch-elektronischen Anwendungen, insbesondere in OLEDs, eingesetzt werden. Besonders bevorzugt werden die erfindungsgemäßen Verbindungen der Formel (I) oder (I*) als Matrix- und/oder Loch-/Excitonenblockermaterialien in organisch-elektronischen Anwendungen, insbesondere in OLEDs, eingesetzt.

Der Einsatz einer der Verbindungen der Formel (I) oder (I*) oder eines erfindungsgemäßen vernetzten oder polymerisierten Materials als Matrixmaterial in Kombination mit einem Emittermaterial führt zu verbesserten Effizienzwerten und einer Verringerung der Spannung in OLEDs bei gleich bleibender Luminanz im Vergleich zu OLEDs, die kein Matrixmaterial mit einer Verbindung der Formel (I) oder (I*) enthalten. Die verringerte Spannung ist dabei auf eine gute Leitfähigkeit von Ladungsträgern, beispielsweise von Elektronen, in der OLED zurückzuführen.

In der oder einer der Emissionsschichten einer OLED kann auch ein Emittermaterial mit einem Matrixmaterial der Verbindung der Formel (I) oder (I*) oder ein erfindungsgemäßes vernetztes oder polymerisiertes Material und einem weiteren Matrixmaterial, das beispielsweise eine gute Lochleitereigenschaft hat, kombiniert werden. Dadurch wird eine hohe Quanteneffizienz dieser Emissionsschicht erzielt.

Aufgrund der Transporteigenschaften und der Lage des Triplettniveaus und damit der Excitonenblockereigenschaften der Verbindungen der Formel (I) oder (I*) oder des erfindungsgemäßen vernetzten oder polymerisierten Materials können diese Verbin**dungen auch als** Loch-/Excitonenblockermaterial und/oder Elektronen-/Excitonenblockermaterial eingesetzt werden. Verbindungen der Formel (I) oder (I*) oder ein erfindungsgemäßes vernetztes oder polymerisiertes Material, die eine gute Elektronenleitereigenschaft aufweisen, können insbesondere auf der kathodennahen Seite einer OLED eingesetzt werden.

Wird eine Verbindung der Formel (I) oder (I*) oder ein erfindungsgemäßes vernetztes oder polymerisiertes Material als Matrixmaterial in einer Emissionsschicht und zusätzlich als Loch-/Excitonenblockermaterial und/oder Elektronen-/Excitonenblockermaterial eingesetzt, wird aufgrund der chemischen Gleichheit oder Ähnlichkeit der Materialien eine verbesserte Grenzfläche zwischen der Emissionsschicht und der benachbarten Loch-/Excitonenblockermaterial und/oder Elektronen-/Excitonenblockermaterial erhalten, was zu einer Verringerung der Spannung bei gleich bleibender Luminanz und zu einer Verlängerung der Lebensdauer der OLED führen kann. Weiterhin kann durch den Einsatz des gleichen Materials für ein Loch-/Excitonenblockermaterial und/oder Elektronen-/Excitonenblockermaterial und für die Matrix einer Emissionsschicht der Herstellungsprozess einer OLED vereinfacht werden, da für das Aufbringen des Materials enthaltend wenigstens eine der Verbindungen der Formel (I) oder (I*) oder ein erfindungsgemäß vernetztes oder polymerisiertes Material dieselbe Quelle verwendet werden kann.

Geeignete Aufbauten der organisch elektronischen Anwendungen sind dem Fachmann bekannt und nachstehend genannt.

Der organische Transistor beinhaltet im Allgemeinen eine Halbleiterschicht, die aus einer organischen Schicht mit einer Lochtransportfähigkeit und/oder Elektronentransportfähigkeit gebildet ist; eine aus einer leitfähigen Schicht gebildete Gate-Elektrode; und eine zwischen der Halbleiterschicht und der leitfähigen Schicht eingebrachte Isolierschicht. An diese Anordnung werden eine Source-Elektrode und eine Drain-Elektrode angebracht, um so das Transistorelement herzustellen. Daneben können in dem organischen Transistor weitere dem Fachmann bekannte Schichten vorliegen. Die Verbindung der Formel (I) oder (I*) oder ein erfindungsgemäßes vernetztes oder polymerisiertes Material kann in jeder beliebigen Schicht des organischen Transitors vorliegen.

Die organische Solarzelle (fotoelektrisches Umwandlungselement) enthält im Allgemeinen eine zwischen zwei parallel angeordneten, plattenartigen Elektroden befindliche organische Schicht. Die organische Schicht kann auf einer kammartigen Elektrode ausgebildet sein. Es besteht keine besondere Einschränkung bezüglich des Orts der organischen Schicht und es besteht keine besondere Einschränkung bezüglich des Materials der Elektroden. Wenn jedoch plattenartige, parallel angeordnete Elektroden eingesetzt werden, ist zumindest eine Elektrode bevorzugt aus einer transparenten Elektrode, wie z. B. einer ITO-Elektrode oder einer fluordotierten Zinnoxidelektrode, gebildet. Die organische Schicht ist aus zwei Subschichten gebildet, d.h. einer Schicht mit p-Typ-Halbleitereigenschaft oder Loch-Transportfähigkeit, sowie einer mit n-Typ-Halbleitereigenschaft oder Elektronen-Transportfähigkeit gebildeten Schicht. Daneben können in der organischen Solarzelle weitere, dem Fachmann bekannte Schichten vorliegen. Die Verbindung der Formel (I) oder (I*) oder ein erfindungsgemäßes vernetztes oder polymerisiertes Material kann in jeder beliebigen Schicht der organischen Solarzelle vorliegen.

In einer weiteren Ausführungsform betrifft die vorliegende Erfindung eine organische Leuchtdiode enthaltend mindestens eine Verbindung der Formel (I) oder (I*) oder ein erfindungsgemäßes vernetztes oder polymerisiertes Material. Die Verbindung der Formel (I) oder (I*) oder ein erfindungsgemäßes vernetztes oder polymerisiertes Material kann in der organischen Leuchtdiode als Matrixmaterial und/oder Loch-/Excitonenblockermaterial und/oder Elektronen-/Excitonenblockermaterial und/oder Loch-Injektionsmaterial und/oder Elektronen-Injektionsmaterial und/oder Lochleitermaterial und/oder Elektronenleitermaterial, bevorzugt als Matrixmaterial und/oder Loch-/Excitonenblockermaterial in organisch-elektronischen Anwendungen, insbesondere in OLEDs, eingesetzt werden.

In einer bevorzugten erfindungsgemäßen Ausführungsform werden Verbindungen der allgemeinen Formel I oder I* bzw. ein erfindungsgemäßes vernetztes oder polymerisiertes Material in Mischung, beispielsweise zusammen mit einem anderen Lochleiter oder Elektronenleiter in der lochleitenden oder elektronenleitenden Schicht eingesetzt. Als weitere Lochleiter oder Elektronenleiter können dabei im Allgemeinen dem Fachmann bekannte Materialien eingesetzt werden, insbesondere die weiter unten genannten Loch- bzw. Elektronenleiter.

In einer weiteren Ausführungsform betrifft die vorliegende Erfindung eine organische Leuchtdiode, worin die Verbindungen der Formel (I) oder (I*) oder ein erfindungsgemäßes vernetztes oder polymerisiertes Material als Loch/Excitonenblocker, bevorzugt in einer Blockschicht für Löcher, oder in der Licht-emittierenden Schicht, bevorzugt als Matrixmaterial, eingesetzt werden.

Es ist ebenfalls möglich, dass die Verbindungen der Formel (I) oder (I*) oder ein erfindungsgemäßes vernetztes oder polymerisiertes Material sowohl in der Licht-emittierenden Schicht (bevorzugt als als Matrixmaterial) als auch in der Blockschicht für Löcher (als Loch-/Excitonenblocker) vorliegen.

In einer besonders bevorzugten Ausführungsform betrifft die vorliegende Erfindung eine OLED, in der alle Schichten, d. h. Lochleiter, Elektronenblocker, Matrix, Lochblocker und Elektronenleiter Verbindungen der Formel (I) oder (I*) oder ein erfindungsgemäß vernetztes oder polymerisiertes Material enthalten, besonders bevorzugt daraus bestehen, wobei die Emissionsschicht zusätzlich einen Emitter enthält.

Ein weiterer Gegenstand der vorliegenden Erfindung ist eine organische Leuchtdiode enthaltend eine Anode An und eine Kathode Ka und eine zwischen der Anode An und der Kathode Ka angeordente Licht-emittierende Schicht E sowie sowie gegebenenfalls mindestens eine weitere Schicht ausgewählt aus der Gruppe bestehend aus mindestens einer Blockschicht für Löcher/Excitonen, mindestens einer Blockschicht für Elektronen/Excitonen, mindestens einer Loch-Injektionsschicht, mindestens einer Lochleiterschicht, mindestens einer Elektroneninjektionsschicht und mindestens einer Elektronenleiterschicht, wobei die mindestens eine Verbindung der Formel (I) oder (I*) oder ein erfindungsgemäßes vernetztes oder polymerisiertes Material in der Licht-emittierenden Schicht E und/oder in mindestens einer der weiteren Schichten vorliegt. Bevorzugt liegt die mindestens eine Verbindung der Formel (I) oder (I*) in der Licht-emittierenden Schicht und/oder der Blockschicht für Löcher vor.

Ein weiterer Gegenstand der vorliegenden Anmeldung betrifft eine Licht-emittierende Schicht enthaltend mindestens eine Verbindung der Formel (I) oder (I*) oder ein erfindungsgemäßes vernetztes oder polymerisiertes Material.

Ein weiterer Gegenstand der vorliegenden Erfindung ist eine OLED enthaltend eine erfindungsgemäße Licht-emittierende Schicht.

Des Weiteren betrifft die vorliegende Erfindung eine Blockschicht für Löcher/Excitonen enthaltend mindestens eine Verbindung der Formel (I) oder (I*) oder ein erfindungsgemäßes vernetztes oder polymerisiertes Material.

### Aufbau der erfindungsgemäßen OLED

Die erfindungsgemäße organische Leuchtdiode (OLED) weist somit im Allgemeinen den folgenden Aufbau auf:
eine Anode (An) und eine Kathode (Ka) und eine zwischen der Anode (An) und der Kathode (Ka) angeordnete Licht-emittierende Schicht E.

Die erfindungsgemäße OLED kann z. B. - in einer bevorzugten Ausführungsform - aus den folgenden Schichten aufgebaut sein:
1. Anode
2. Lochleiterschicht
3. Licht-emittierende Schicht
4. Blockschicht für Löcher/Excitonen
5. Elektronenleiterschicht
6. Kathode

Es sind auch von dem vorstehend genannten Aufbau verschiedene Schichtenfolgen möglich, die dem Fachmann bekannt sind. Beispielsweise ist es möglich, dass das OLED nicht alle der genannten Schichten aufweist, zum Beispiel ist eine OLED mit den Schichten (1) (Anode), (3) (Licht-emittierende Schicht) und (6) (Kathode) ebenfalls geeignet, wobei die Funktionen der Schichten (2) (Lochleiterschicht) und (4) (Blockschicht für Löcher/Excitonen) und (5) (Elektronenleiterschicht) durch die angrenzenden Schichten übernommen werden. OLEDs, die die Schichten (1), (2), (3) und (6) bzw. die Schichten (1), (3), (4), (5) und (6) aufweisen, sind ebenfalls geeignet. Des Weiteren können die OLEDs zwischen der Anode (1) und der Lochleiterschicht (2) eine Blockschicht für Elektronen/Excitonen aufweisen.

Es ist des Weiteren möglich, dass mehrere der vorstehend genannten Funktionen Elektronen-/Excitonenblocker, Loch-/Excitonenblocker, Loch-Injektion, Lochleitung, E-lektroneninjektion, Elektronenleitung) in einer Schicht vereint sind und z. B. von einem einzigen in dieser Schicht vorliegenden Material übernommen werden. Beispielsweise kann ein in der Lochleiterschicht eingesetztes Material in einer Ausführungsform gleichzeitig Excitonen und/oder Elektronen blocken.

Des Weiteren können die einzelnen der vorstehend genannten Schichten der OLED wiederum aus 2 oder mehreren Schichten aufgebaut sein. Beispielsweise kann die Lochleiterschicht aus einer Schicht aufgebaut sein, in die aus der Elektrode Löcher injiziert werden, und einer Schicht, die die Löcher von der Loch injizierenden Schicht weg in die Licht-emittierende Schicht transportiert. Die Elektronenleitungsschicht kann ebenfalls aus mehreren Schichten bestehen, zum Beispiel einer Schicht, worin Elektronen durch die Elektrode injiziert werden, und einer Schicht, die aus der Elektronen-Injektionsschicht Elektronen erhält und in die Licht-emittierende Schicht transportiert. Diese genannten Schichten werden jeweils nach Faktoren wie Energieniveau, Temperaturresistenz und Ladungsträgerbeweglichkeit, sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten organischen Verbindungen angepasst ist.

Um besonders effiziente OLEDs zu erhalten, sollte z. B. das HOMO (höchstes besetztes Molekülorbital) der Lochleiterschicht mit der Arbeitsfunktion der Anode angeglichen sein, und das LUMO (niedrigstes unbesetztes Molekülorbital) der Elektronenleiterschicht sollte mit der Arbeitsfunktion der Kathode angeglichen sei, soweit die vorstehend genannten Schichten in den erfindungsgemäßen OLEDs vorliegen.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen Metalle und Legierungen der Metalle der Hauptgruppen, Übergangsmetalle und der Lanthanoide, insbesondere die Metalle der Gruppen Ib, IVa, Va und VIa des Periodensystems der Elemente sowie die Übergangsmetalle der Gruppe VIIIa. Wenn die Anode lichtdurchlässig sein soll, werden im Allgemeinen gemischte Metalloxide der Gruppen IIb, IIIb und IVb des Periodensystems der Elemente (alte IUPAC-Version) eingesetzt, zum Beispiel Indium-Zinn-Oxid (ITO). Es ist ebenfalls möglich, dass die Anode (1) ein organisches Material, zum Beispiel Polyanilin enthält, wie beispielsweise **in** Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können. Bevorzugt wird als Material für die Anode (1) ITO eingesetzt.

Geeignete Lochleitermaterialien für die Schicht (2) der erfindungsgemäßen OLEDs sind zum Beispiel in Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus Tris-[N-(1-naphthyl)-N-(phenylamino)]triphenylamin (1-NaphDATA), 4,4'-Bis[N-(1-naphthyl)-N-phenyl-amino]biphenyl (α-NPD), N,N'-Diphenyl-N,N'-bis(3-methylphenyl)-[1,1'-biphenyl]-4,4'-di a m i n (TPD), 1,1-Bis[(di-4-tolylamino)phenyl]-cyclohexan (TAPC), N,N'-Bis(4-methylphenyl)-N,N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-Tetrakis(4-methylphenyl)-(1,1'-biphenyl)-4,4'-diamin (TTB), 4,4',4"-tris(N,N-Diphenylamino)triphenylamin (TDTA), 4,4',4"-tris(N-carbazolyl)triphenylamine (TCTA), N,N'-Bis(naphthalen-2-yl)-N,N'-bis(phenyl)-benzidin (β-NPB), N,N'-Bis(3-methylphenyl)-N,N'-bis(phenyl)-9,9-spirobifluoren (Spiro-TPD), N,N'-Bis(naphthalen-1-yl)-N,N'-bis(phenyl)-9,9-spirobifluoren (Spiro-NPB), N,N'-Bis(3-methylphenyl)-N,N'-bis(phenyl)-9,9-dimethylfluoren (DMFL-TPD), Di-[4-(N,N-ditolyl-amino)-phenyl]cyclohexan, N,N'-Bis(naphthalen-1-yl)-N,N'-bis(phenyl)-9,9-dimethylfluoren, N,N'-Bis(naphthalen-1-yl)-N,N'-bis(phenyl)-2,2-dimethylbenzidin, N,N'-Bis(naphthalen-1-yl)-N,N'-bis(phenyl)-benzidin, N,N'-Bis(3-methylphenyl)-N,N'-bis(phenyl)-benzidin, 2,3,5,6-Tetrafluoro-7,7,8,8-tetracyano-quinodimethan (F4-TCNQ), 4,4',4"-Tris(N-3-methylphenyl-N-phenyl-amino)-triphenylamin, 4,4',4"-Tris(N-(2-naphthyl)-N-phenyl-amino)-triphenylamin, Pyrazino[2,3-f][1,10]phenanthrolin-2,3-dicarbonitril (PPDN), N,N,N',N'-Tetrakis(4-methoxyphenyl)benzidin (MeO-TPD), 2,7-Bis[N,N-bis(4-methoxy-phenyl)amino]-9,9-spirobifluoren (MeO-Spiro-TPD), 2,2'-Bis[N,N-bis(4-methoxy-phenyl)amino]-9,9-spirobifluoren (2,2'-MeO-Spiro-TPD), N,N'-di-phenyl-N,N'-di-[4-(N,N-di-tolyl-amino) phenyl]benzidin (NTNPB), N,N'-di-phenyl-N,N'-di-[4-(N,N-di-phenyl-amino)phenyl]benzidin (NPNPB), N,N'-di(naphthalen-2-yl)-N,N'-diphenylbenzen-1,4-diamin (β-NPP), N,N'-Bis(3-methylphenyl)-N,N'-bis(phenyl)-9,9-diphenylfluoren (DPFL-TPD), N,N'-Bis(naphthalen-1-yl)-N,N'-bis(phenyl)-9,9-diphenylfluoren (DPFL-NPB), 2,2',7,7'-Tetrakis(N,N-diephenylamino)-9,9'-spirobifluoren (Spiro-TAD), 9,9-Bis[4-N,N-bis-biphenyl-4-yl-amino)phenyl]-9H-fluoren (BPAPF), 9,9-Bis[4-(N,N-bis-naphthalen-2-yl-amino)phenyl]-9H-fluoren (NPAPF), 9,9-Bis[4-(N,N-bis-naphthalen-2-yl-N,N'-bis-phenyl-amino)phenyl]-9H-fluoren (NPBAPF), 2,2',7,7'-Tetrakis[N-naphthalenyl(phenyl)-amino]-9,9'-spirobifluoren (Spiro-2NPB), N,N'-bis(phenanthren-9-yl)-N,N'-bis(phenyl)-benzidin (PAPB), 2,7-Bis[N,N-bis(9,9-spiro-bifluoren-2-yl)-amino]-9,9-spirobifluoren (Spiro-5), 2,2'-Bis[N,N-bis(biphenyl-4-yl)amino]-9,9-spirobifluoren (2,2'-Spiro-DBP), 2,2'-Bis(N,N-di-phenyl-amino)-9.9-spirobifluoren (Spiro-BPA), 2,2',7,7'-tetra(N,N-di-Tolyl)amino-Spiro-bifluoren (Spiro-TTB), N,N,N',N'-tetra-naphthalen-2-yl-benzidin (TNB), Porphyrinverbindungen und Phthalocyaninen wie Kupferphthalocyanine und Titanoxidphthalocyanine. Üblicherweise eingesetzte Löcher transportierende Polymere sind ausgewählt aus der Gruppe bestehend aus Polyvinylcarbazolen, (Phenylmethyl)polysilanen und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Weiterhin können - in einer Ausführungsform - Carben-Komplexe als Lochleitermaterialien eingesetzt werden, wobei die Bandlücke des mindestens einen Lochleitermaterials im Allgemeinen größer ist als die Bandlücke des eingesetzten Emittermaterials. Dabei ist unter Bandlücke im Sinne der vorliegenden Anmeldung die Triplett-Energie zu verstehen. Geeignete Carben-Komplexe sind z. B. Carben-Komplexe, wie sie in WO 2005/019373 A2, WO 2006/056418 A2, WO 2005/113704, WO 2007/115970, WO 2007/115981 und WO 2008/000727 beschrieben sind. Ein Beispiel für einen geeigneten Carbenkomplex ist Ir(dpbic)₃ mit der Formel: 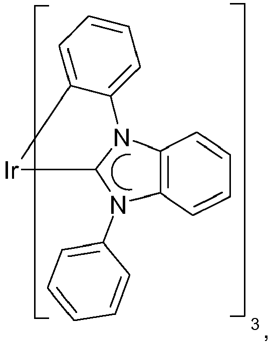 der z. B. in WO2005/019373 offenbart ist. Grundsätzlich ist es möglich, dass die Lochleiterschicht mindestens eine Verbindung der Formel (I) oder (I*) als Lochleitermaterial enthält.

Die Licht-emittierende Schicht (3) enthält mindestens ein Emittermaterial. Dabei kann es sich grundsätzlich um einen Fluoreszenz oder Phosphoreszenzemitter handeln, wobei geeignete Emittermaterialien dem Fachmann bekannt sind. Bevorzugt handelt es sich bei dem mindestens einen Emittermaterial um einen Phosphoreszenzemitter. Die bevorzugt eingesetzten Phosphoreszenzmitter-Verbindungen basieren auf Metallkomplexen, wobei insbesondere die Komplexe der Metalle Ru, Rh, Ir, Pd und Pt, vor allem die Komplexe des Ir Bedeutung erlangt haben. Die Verbindungen der Formel (I) oder (I*) oder ein erfindungsgemäßes vernetztes oder polymerisiertes Material können als Matrix in der Licht-emittierenden Schicht eingesetzt werden

Geeignete Metallkomplexe zur Verwendung in den erfindungsgemäßen OLEDs sind z. B. in den Schriften WO 02/60910 A1, US 2001/0015432 A1, US 2001/0019782 A1, US 2002/0055014 A1, US 2002/0024293 A1, US 2002/0048689 A1, EP 1 191 612 A2, EP 1 191 613 A2, EP 1 211 257 A2, US 2002/0094453 A1, WO 02/02714 A2, WO 00/70655 A2, WO 01/41512 A1, WO 02/15645 A1, WO 2005/019373 A2, WO 2005/113704 A2, WO 2006/115301 A1, WO 2006/067074 A1, WO 2006/056418, WO 2006121811 A1, WO 2007095118 A2, WO 2007/115970, WO 2007/115981 und WO 2008/000727 beschrieben.

Weitere geeignete Metallkomplexe sind die kommerziell erhältlichen Metallkomplexe Tris(2-phenylpyridin)iridium(III), Iridium(III)tris(2-(4-tolyl)pyridinato-N,C²'), Bis(2-phenylpyridin)(acetylacetonat)iridium(III), Iridium(III)tris(1-phenylisochinolin), Iridium(III)bis(2-2'-benzo-thienyl)pyridinato-N,C³')(acetylacetonat), Tris(2-phenylquinolin)iridium (III), Iridium(III)bis(2-(4,6-difluorophenyl)pyridinato-N,C²)picolinat, Iridium(III)bis(1-phenylisochinolin)(acetylacetaonat), Bis(2-phenylquinolin)(acetyl-acetonat)iridium (III), Iridium(III)bis(di-benzo[f,h]chinoxalin)(acetylacetaonat), Iridium(III)bis(2-methyldi-benzo[f,h]chinoxalin)(acetylacetonat) und Tris(3-methyl-1-phenyl-4-trimethyl-acetyl-5-pyrazolin)terbium(III), B i s [ 1-(9,9-dimethyl-9H-fluoren-2-yl)-isoquinolin](acetylacetonat)iridium(III), Bis(2-phenylbenzuthiazolato)(acetylacetonat)-iridium(III), Bis(2-(9,9-dihexylfluorenyl)-1-pyridin)(acetylacetonat)iridium (III), Bis(2-benzo[b]thiophen-2-yl-pyridin)(acetylacetonat)iridium(III).

Des Weiteren sind die folgenden kommerziell erhältlichen Materialien geeignet: Tris(dibenzoylacetonato)-mono(phenanthrolin)-europium(III), Tris(dibenzoylmethan)-mono(phenanthrolin)europium(III), Tris(dibenzoylmethan)-mono(5-aminophenanthrolin)europium(III), Tris(di-2-naphthoylmethan)-mono(phenanthrolin)-europium(III), Tris(4-bromobenzoylmethan)-mono(phenanthrolin)-europium(III), Tris(di-biphenylmethan)-mono(phenanthrolin)-europium(III), Tris(dibenzoylmethan)-mono(4,7-diphenylphenanthrolin)-europium(III), Tris(dibenzoylmethan)-mono(4,7-di-methylphenanthrolin)-europium(III), Tris(dibenzoylmethan)-mono(4,7-dimethyl-phenanthrolin-disulfonsäure)-europium(III)-dinatriumsalz, Tris[di(4-(2-(2-ethoxy-ethoxy)ethoxy)benzoylmethan)]-mono(phenanthrolin)-europium(III) und Tris[di[4-(2-(2-ethoxyethoxy)ethoxy)benzoylmethan)]mono-(5-aminophenanthrolin)-europium(III), Osmium(II)bis(3-(trifluoromethyl)-5-(4-tert-butylpyridyl)-1,2,4-triazolat)diphenylmethylphosphin, Osmium(II)bis(3-(trifluoromethyl)-5-(2-pyridyl)-1,2,4-triazol)dimethylphenylphosphin, Osmium(II)bis(3-(trifluoromethyl)-5-(4-tert-butylpyridyl)-1,2,4-triazolat)dimethylphenylphosphin, Osmium(II)-bis(3-(trifluoromethyl)-5-(2-pyridyl)-pyrazolat)dimethylphenylphosphin, Tris[4,4'-die-tert-butyl(2,2')-bipyridin]ruthenium(III), Osmium(II)bis(2-(9,9-dibutylfluorenyl)-1-isoquinolin(acetylacetonat).

Geeignete Triplett-Emitter sind z. B. Carbenkomplexe. In einer Ausführungsform der vorliegenden Erfindung werden die Verbindungen der Formel (I) oder (I*) bzw. (Ib) in der Licht-emittierenden Schicht als Matrixmaterial gemeinsam mit Carbenkomplexen als Triplett-Emitter eingesetzt. Geeignete Carbenkomplexe sind dem Fachmann bekannt und z. B. in WO 2005/019373 A2, WO 2006/056418 A2, WO 2005/113704, WO 2007/115970, WO 2007/115981 und WO 2008/000727 beschrieben.

Die Licht-emittierende Schicht kann neben dem Emittermaterial weitere Komponenten enthalten. Beispielsweise kann in der Licht-emittierenden Schicht ein fluoreszierender Farbstoff anwesend sein, um die Emissionsfarbe des Emittermaterials zu verändern. Des Weiteren kann - in einer bevorzugten Ausführungsform - ein Matrixmaterial eingesetzt werden. Dieses Matrixmaterial kann ein Polymer sein, zum Beispiel Poly(N-vnylcarbazol) oder Polysilan. Das Matrixmaterial kann jedoch ebenfalls ein kleines Molekül sein, zum Beispiel 4,4'-N,N'-Dicarbazolbiphenyl (CDP=CBP) oder tertiäre aromatische Amine wie z. B. TCTA. In einer bevorzugten Ausführungsform der vorliegenden Erfindung wird mindestens eine Verbindung der Formel (I) oder (I*) als Matrixmaterial eingesetzt.

In einer bevorzugten Ausführungsform ist die Licht-emittierende Schicht aus 2 bis 20 Gew.-%, bevorzugt 5 bis 17 Gew.-% mindstens eines der vorstehend genannten Emittermaterialien und 80 bis 98 Gew.-%, bevorzugt 83 bis 95 Gew.-% mindestens eines der vorstehend genannten Matrixmaterialien - in einer Ausführungsform mindestens einer Verbindung der Formel (I) oder (I*) oder ein erfindungsgemäßes vernetztes oder polymerisiertes Material - aufgebaut, wobei die Gesamtsumme des Emittermaterials und des Matrixmaterials 100 Gew.-% ergibt.

In einer weiteren Ausführungsform werden die Verbindungen der Formel (I) oder (I*) oder ein erfindungsgemäßes vernetztes oder polymerisiertes Material als Loch/Excitonen-Bockermaterial, bevorzugt gemeinsam mit Carbenkomplexen als Triplett-Emitter eingesetzt. Die Verbindungen der Formel (I) oder (I*) oder ein erfindungsgemäßes vernetztes oder polymerisiertes Material können des Weiteren - wie vorstehend erwähnt - als Matrixmaterialien oder sowohl als Matrixmaterialien als auch als Loch/Excitonenblockermaterialien gemeinsam mit Carbenkomplexen als Triplett-Emitter eingesetzt werden. Des Weiteren ist es möglich, dass mindestens eine Verbindung der Formal (I) oder (I*) oder ein erfindungsgemäßes vernetztes oder polymerisiertes Material in einer Blockschicht für Löcher/Excitonen, einer Blockschicht für Elektronen/Excitonen, einer Loch-Injektionsschicht, einer Lochleiterschicht, einer Elektroneninjektionsschicht und/oder einer Elektronenleiterschicht der OLED vorliegt, bevorzugt gemeinsam mit Carbenkomplexen als Triplett-Emitter.

Geeignete Metallkomplexe zur Verwendung zusammen mit den Verbindungen der Formel (I) oder (I*) oder ein erfindungsgemäßes vernetztes oder polymerisiertes Material als Matrixmaterial und/oder Loch-/Excitonenblockermaterial und/oder Elektronen-/Excitonenblockermaterial und/oder Loch-Injektionsmaterial und/oder Elektronen-Injektionsmaterial und/oder Lochleitermaterial und/oder Elektronenleitermaterial, bevorzugt als Matrixmaterial und/oder Loch-/Excitonenblockermaterial in OLEDs sind somit z. B. auch Carben-Komplexe, wie sie in WO 2005/019373 A2, WO 2006/056418 A2, WO 2005/113704, WO 2007/115970, WO 2007/115981 und WO 2008/000727 beschrieben sind. Auf die Offenbarung der genannten WO-Anmeldungen wird hierbei explizit Bezug genommen und diese Offenbarungen sollen in den Inhalt der vorliegenden Anmeldung als mit einbezogen gelten.

Falls die Blockschicht für Löcher/Excitonen (4) keine Verbindungen der Formel (I) oder (I*) oder ein erfindungsgemäßes vernetztes oder polymerisiertes Material enthält, weist die OLED - falls eine Blockschicht für Löcher vorliegt -üblicherweise in OLEDs eingesetzte Lochblockermaterialien auf wie 2,6-Bis(N-carbazolyl)pyridine (mCPy), 2,9-Dimethyl-4,7-diphenyl-1,10-phenanthrolin (Bathocuproin, (BCP)), Bis-(2-methyl-8-chinolinato)-4-phenyl-phenylato)-aluminium(III) (BAlq), Phenothiazin-*S,S*-dioxidderivate und 1,3,5-tris(N-Phenyl-2-benzylimidazol)-benzol) (TPBI), wobei TPBI auch als Elektronen-leitendes Material geeignet ist. Weitere geeignete Lochblocker und/oder Elektronenleitermaterialien sind 2,2',2"-(1,3,5-Benzintriyl)-tris(1-phenyl-1-H-benzimidazol), 2-(4-Biphenylyl)-5-(4-tert-butylphenyl)-1,3,4-oxadiazol, 8-Hydroxyquinolinolato-lithium, 4-(Naphthalen-1-yl)-3,5-diphenyl-4H-1,2,4-triazol, 1,3-Bis[2-(2,2'-bipyridin-6-yl)-1,3,4-oxadiazo-5-yl]benzen, 4,7-Diphenyl-1,10-phenanthrolin, 3-(4-Biphenylyl)-4-phenyl-5-tert-butylphenyl-1,2,4-triazol, 6,6'-Bis[5-(biphenyl-4-yl)-1,3,4-oxadiazo-2-yl]-2,2'-bipyridyl, 2-phenyl-9,10-di(naphthalen-2-yl)-anthracen, 2,7-Bis[2-(2,2'-bipyridin-6-yl)-1,3,4-oxadiazo-5-yl]-9,9-dimethylfluoren, 1,3-Bis[2-(4-tert-butylphenyl)-1,3,4-oxadiazo-5-yl]benzen, 2-(Naphthalen-2-yl)-4,7-diphenyl-1,10-phenanthrolin, Tris(2,4,6-trimethyl-3-(pyridin-3-yl)phenyl)boran, 2,9-Bis(naphthalen-2-yl)-4,7-diphenyl-1,10-phenanthrolin, 1-Methyl-2-(4-(naphthalen-2-yl)phenyl)-1H-imidazo[4,5-f][1,10]phenanthrolin. In einer weiteren Ausführungsform können Verbindungen, die aromatische oder heteroaromatische über Carbonyl-Gruppen enthaltende Gruppen verbundene Ringe enthalten, wie sie in WO2006/100298 offenbart sind, Disilylverbindungen, ausgewählt aus der Gruppe bestehend aus Disilylcarbazolen, Disilylbenzofuranen, Disilylbenzothiophenen, Disilylbenzophospholen, Disilylbenzothiophen-S-oxiden und Disilylbenzothiophen-S,S-dioxiden wie sie z. B. in den PCT-Anmeldungen mit den Aktenzeichen WO 2009/003919 und WO 2009/000872 genannt sind sowie Disilylverbindungen wie sie in WO2008/034758 offenbart sind als Blockschicht für Löcher/Excitonen (4) oder als Matrixmaterialien in der Licht-emittierenden Schicht (3) eingesetzt werden.

In einer bevorzugten Ausführungsform betrifft die vorliegende Erfindung eine erfindungsgemäße OLED umfassend die Schichten (1) Anode, (2) Lochleiterschicht, (3) Licht-emittierende Schicht, (4) Blockschicht für Löcher/Excitonen, (5) Elektronenleiterschicht und (6) Kathode, sowie gegebenenfalls weitere Schichten, wobei die Blockschicht für Löcher/Excitonen oder die Licht-emittierende Schicht mindestens eine Verbindung der Formel (I) oder (I*) bzw. (lb) enthält.

In einer weiteren bevorzugten Ausführungsform betrifft die vorliegende Erfindung eine erfindungsgemäße OLED umfassend die Schichten (1) Anode, (2) Lochleiterschicht, (3) Licht-emittierende Schicht, (4) Blockschicht für Löcher/Excitonen, (5) Elektronenleiterschicht und (6) Kathode, sowie gegebenenfalls weitere Schichten, wobei die Licht-emittierende Schicht (3) mindestens mindestens eine Verbindung der Formel (I) oder (I*) bzw. (Ib) und die Blockschicht für Löcher/Excitonen mindestens eine Verbindung der Formel (I) oder (I*) bzw. (Ib) enthält.

Geeignete Elektronenleitermaterialien für die Schicht (5) der erfindungsgemäßen OLEDs umfassen mit oxinoiden Verbindungen chelatisierte Metalle wie 2,2', 2"-(1,3,5-phenylen)tris-[1-phenyl-1H-benzimidazol] (TPBI), Tris(8-chinolinolato)aluminium (Alq₃), Verbindungen auf Phenanthrolinbasis wie 2,9-Dimethyl-4,7-diphenyl-1,10-phenanthrolin (DDPA = BCP) oder 4,7-Diphenyl-1,10-phenanthrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ), 8-Hydroxyquinolinolatolithium (Liq), 4,7-Diphenyl-1,10-phenanthrolin (BPhen), Bis-(2-methyl-8-quinolinolat)-4-(phenylphenolato)aluminium (BAlq), 1,3-Bis[2-(2,2'-bipyridin-6-yl)-1,3,4-oxadiazo-5-yl]benzen (Bpy-OXD), 6,6'-Bis[5-(biphenyl-4-yl)-1,3,4-oxadiazo-2-yl]-2,2'-bipyridyl (BP-OXD-Bpy), 4-(Naphthalen-1-yl)-3,5-diphenyl-4H-1,2,4-triazol (NTAZ), 2,9-Bis(naphthalen-2-yl)-4,7-diphenyl-1,10-phenanthrolin (NBphen), 2,7,-Bis[2-(2,2'-bipyridin-6-yl)-1,3,4-oxadiazo-5-yl]-9,9-dimethylfluoren (Bby-FOXD), 1,3-Bis[2-(4-tert-butylphenyl)-1,3,4-oxadiazo-5-yl]benzen (OXD-7), Tris(2,4,6-trimethyl-3-(pyridin-3-yl)phenyl)boran (3TPYMB), 1-methyl-2-(4-(naphthalen-2-yl)phenyl)-1 H-imidazo[4,5-f][1,10]phenanthrolin (2-NPIP), 2-phenyl-9,10,-di(naphthalen-2-yl)-anthracen (PADN), 2-(naphthalen-2-yl)-4,7-diphenyl-1,10,phenanthrolin (HNBphen). Dabei kann die Schicht (5) sowohl zur Erleichterung des Elektronentransports dienen als auch als Pufferschicht oder als Sperrschicht, um ein Quenchen des Excitons an den Grenzflächen der Schichten der OLED zu vermeiden. Vorzugsweise verbessert die Schicht (5) die Beweglichkeit der Elektronen und reduziert ein Quenchen des Excitons. In einer bevorzugten Ausführungsform wird TPBI als Elektronenleitermaterial eingesetzt. Grundsätzlich ist es möglich, dass die Elektronenleiterschicht mindestens eine Verbindung der Formel (I) oder (I*) oder ein erfindungsgemäßes vernetztes oder polymerisiertes Material als Elektronenleitermaterial enthält.

Von den vorstehend als Lochleitermaterialien und Elektronenleitermaterialien genannten Materialien können einige mehrere Funktionen erfüllen. Zum Beispiel sind einige der Elektronen leitenden Materialien gleichzeitig Löcher blockende Materialien, wenn sie ein tief liegendes HOMO aufweisen. Diese können z. B. in der Blockschicht für Löcher/Excitonen (4) eingesetzt werden. Es ist jedoch ebenfalls möglich, dass die Funktion als Loch/Excitonenblocker von der Schicht (5) mit übernommen wird, so dass die Schicht (4) entfallen kann.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Eine p-Dotierung wird durch das Hinzufügen von oxidierenden Materialien erreicht. Diese Mischungen können beispielsweise sein, Mischungen aus den oben genannten Lochtransportmaterialien mit MoO₂, MoO₃, WOₓ, ReO₃, V₂O₅, 7,7,8,8-Tetracyanoquinodimethan (TCNQ), 2,3,5,6-Tetrafluoro-7,7,8,8-tetracyano-quinodimethan (F₄-TCNQ), 2,5-Bis(2-hydroxy-ethoxy)-7,7,8,8-tetracyanoquino-dimethan**,** Bis(tetra-n-butyl-ammonium)tetracyanodipheno-quino-dimethan, 2,5-Dimethyl-7,7,8,8-tetracyanoquinodimethan, Tetracyanoethylen, 11,11,12,12-Tetracyano-naphtho-2,6-quinodimethan, 2-Fluoro-7,7,8,8-tetracyanoquino-dimethan, 2,5-Difluoro-7,7,8,8-tetracyanoquinodimethan, Dicyanomethylen-1,3,4,5,7,8-hexafluoro-6H-naphthalen-2-yliden)-malononitril (F₆-TNAP), Mo(tfd)₃ (aus Kahn et al., J. Am. Chem. Soc. 2009, 131 (35), 12530-12531), sowie mit Chinonverbindungen wie sie in EP 09153776.1 erwähnt sind.

Die Elektronenleitermaterialien können zum Beispiel mit Alkalimetallen dotiert werden, beispielsweise Alq₃ mit Lithium. Außerdem können Elektronenleiter mit Salzen wie Cs₂CO₃ dotiert werden. Die elektronische Dotierung ist dem Fachmann bekannt und zum Beispiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo. Appl. Phys. Lett., Vol. 82, No. 25, 23 June 2003 und Pfeiffer et al., Organic Electronics 2003, 4, 89 - 103 offenbart. Zum Beispiel kann die Lochleiterschicht einen neben einem Carbenkomplex, z. B. Ir(dpbic)₃, mit MoO₃ oder WO₃ dotiert werden.

Die Kathode (6) ist eine Elektrode, die zur Einführung von Elektronen oder negativen Ladungsträgern dient. Geeignete Materialien für die Kathode sind ausgewählt aus der Gruppe bestehend aus Alkalimetallen der Gruppe la, zum Beispiel Li, Cs, Erdalkalimetallen der Gruppe IIa, zum Beispiel Calcium, Barium oder Magnesium, Metallen der Gruppe IIb des Periodensystems der Elemente (alte IUPAC-Version), umfassend die Lanthaniden und Aktiniden, zum Beispiel Samarium. Des Weiteren können auch Metalle wie Aluminium oder Indium, sowie Kombinationen aller genannten Metalle eingesetzt werden. Weiterhin können Lithium enthaltende organometallische Verbindungen oder LiF zwischen der organischen Schicht und der Kathode aufgebracht werden, um die Betriebsspannung (Operating Voltage) zu vermindern.

Die OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform der erfindungsgemäßen OLED bestehen alle Schichten, d. h. Lochleiter, Elektronenblocker, Matrix, Lochblocker und Elektronenleiter aus Materialien der Formel (I) oder (I*) oder ein erfindungsgemäßes vernetztes oder polymerisiertes Material, nur die Emissionsschicht enthält zusätzlich wenigstens einen Emitter.

In einer bevorzugten Ausführungsform enthält die erfindungsgemäß OLED zusätzlich zu den Schichten (1) bis (6) mindestens eine der im Folgenden genannten weiteren Schichten:
- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Elektronen-Injektionsschicht zwischen der Elektronen-transportierenden Schicht (5) und der Kathode (6).

Materialien für eine Lochinjektionsschicht können ausgewählt sein aus Kupferphthalocyanin, 4,4',4"-Tris(N-3-methylphenyl-N-phenyl-amino)triphenylamin (m-MTDATA), 4,4',4"-Tris(N-(2-naphthyl)-N-phenyl-amino)triphenylamin (2T-NATA), 4,4',4"-Tris(N-(1naphthyl)-N-phenyl-amino)triphenylamin (1T-NATA), 4,4',4"-Tris(N,N-diphenyl-amino)triphenylamin (NATA), Titanoxidphtalocyanin, 2,3,5,6-Tetrafluoro-7,7,8,8-tetracyano-quinodimethan (F4-TCNQ), Pyrazino[2,3-f][1,10]phenanthrolin-2,3-dicarbonitril (PPDN), N,N,N',N'-Tetrakis(4-methoxyphenyl)benzidin (MeO-TPD), 2,7-Bis[N,N-bis(4-methoxy-phenyl)amino]-9,9-spirobifluoren (MeO-Spiro-TPD), 2,2'-Bis[N,N-bis(4-methoxy-phenyl)amino]-9,9-spirobifluoren (2,2'-MeO-Spiro-TPD), N,N'-di-phenyl-N,N'-di-[4-(N,N-di-tolyl-amino) phenyl]benzidin (NTNPB), N,N'-di-phenyl-N,N'-di-[4-(N,N-di-phenyl-amino) phenyl]benzidin (NPNPB), N,N'-di(naphthalen-2-yl)-N,N'-diphenylbenzen-1,4-diamin (β-NPP). Grundsätzlich ist es möglich, dass die Lochinjektionsschicht mindestens eine Verbindung der Formel (I) oder (I*) als Lochinjektionsmaterial enthält.

Als Material für die Elektroneninjektionsschicht kann beispielsweise LiF, CsF oder Cs₂CO₃ gewählt werden. Grundsätzlich ist es möglich, dass die Elektroneninjektionsschicht mindestens eine Verbindung der Formel (I) oder (I*) oder ein erfindungsgemäßes vernetztes oder polymerisiertes Material als Elektroneninjektionsmaterial enthält.

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z. B. in WO 00/70655 offenbart.

Des Weiteren ist es möglich, dass einige der in der erfindungsgemäßen OLED eingesetzten Schichten oberflächenbehandelt sind, um die Effizienz des Ladungsträgertransports zu erhöhen. Die Auswahl der Materialien für jede der genannten Schichten ist bevorzugt dadurch bestimmt, eine OLED mit einer hohen Effizienz und Lebensdauer zu erhalten.

Die Herstellung der erfindungsgemäßen OLED kann nach dem Fachmann bekannten Methoden erfolgen. Im Allgemeinen wird die erfindungsgemäße OLED durch aufeinander folgende Dampfabscheidung (Vapor deposition) der einzelnen Schichten auf ein geeignetes Substrat hergestellt. Geeignete Substrate sind zum Beispiel Glas, anorganische Halbleiter oder Polymerfilme. Zur Dampfabscheidung können übliche Techniken eingesetzt werden wie thermische Verdampfung, Chemical Vapor Deposition (CVD), Physical Vapor Deposition (PVD) und andere. In einem alternativen Verfahren können die organischen Schichten der OLED aus Lösungen oder Dispersionen in geeigneten Lösungsmitteln aufgetragen werden, wobei dem Fachmann bekannte Beschichtungstechniken angewendet werden.

Im Allgemeinen haben die verschiedenen Schichten folgende Dicken: Anode (1) 50 bis 500 nm, bevorzugt 100 bis 200 nm; Löcher-leitende Schicht (2) 5 bis 100 nm, bevorzugt 20 bis 80 nm, Licht-emittierende Schicht (3) 1 bis 100 nm, bevorzugt 10 bis 80 nm, Blockschicht für Löcher/Excitonen (4) 2 bis 100 nm, bevorzugt 5 bis 50 nm, Elektronen-leitende Schicht (5) 5 bis 100 nm, bevorzugt 20 bis 80 nm, Kathode (6) 20 bis 1000 nm, bevorzugt 30 bis 500 nm. Die relative Lage der Rekombinationszone von Löchern und Elektronen in den erfindungsgemäßen OLED in Bezug zur Kathode und somit das Emissionsspektrum der OLED können u. a. durch die relative Dicke jeder Schicht beeinflusst werden. Das bedeutet, die Dicke der Elektronentransportschicht sollte bevorzugt so gewählt werden, dass die Lage der Rekombinationszone auf die optische Resonatoreigenschaft der Diode und damit auf die Emissionswellenlänge des Emitters abgestimmt ist. Das Verhältnis der Schichtdicken der einzelnen Schichten in der OLED ist von den eingesetzten Materialien abhängig. Die Schichtdicken von gegebenenfalls eingesetzten zusätzlichen Schichten sind dem Fachmann bekannt. Es ist möglich, dass die Elektronen-leitende Schicht und/oder die Löcher leitende Schicht größere Dicken als die angegebenen Schichtdicken aufweisen, wenn sie elektrisch dotiert sind.

Durch Einsatz der Verbindungen der Formel (I) oder (I*) oder ein erfindungsgemäßes vernetztes oder polymerisiertes Material in mindestens eine Schicht der OLED, bevorzugt in der Licht-emittierenden Schicht (bevorzugt als Matrixmaterial) und/oder in der Blockschicht für Löcher/Excitonen, können OLEDs mit hoher Effizienz und mit niedriger Einsatz- und Betriebsspannung erhalten werden. Häufig weisen die durch den Einsatz der Verbindungen der Formel (I) oder (I*) erhaltenen OLEDs des Weiteren noch hohe Lebensdauern auf. Die Effizienz der OLEDs kann des Weiteren durch Optimierung der anderen Schichten der OLEDs verbessert werden. Beispielsweise können hoch effiziente Kathoden wie Ca oder Ba, gegebenenfalls in Kombination mit einer Zwischenschicht aus LiF, CsF oder Cs₂CO₃ eingesetzt werden. Geformte Substrate und neue Löcher-transportierende Materialien, die eine Reduktion der Operationsspannung oder eine Erhöhung der Quanteneffizienz bewirken, sind ebenfalls in den erfindungsgemäßen OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die OLEDs können weiterhin zumindest eine zweite Licht emittierende Schicht enthalten. Die Gesamtemission der OLEDs kann sich dabei aus der Emission der zumindest zwei Licht emittierenden Schichten zusammensetzen und kann auch weißes Licht umfassen.

Die OLEDs können in allen Vorrichtungen eingesetzt werden, worin Elektrolumineszenz nützlich ist. Geeignete Vorrichtungen sind bevorzugt ausgewählt aus stationären und mobilen Bildschirmen und Beleuchtungseinheiten. Stationäre Bildschirme sind z. B. Bildschirme von Computern, Fernsehern, Bildschirme in Druckern, Küchengeräten sowie Reklametafeln, Beleuchtungen und Hinweistafeln. Mobile Bildschirme sind z. B. Bildschirme in Handys, Laptops, Digitalkameras, MP3-Playern, Fahrzeugen sowie Zielanzeigen an Bussen und Bahnen. Weitere Vorrichtungen, worin die erfindungsgemäßen OLEDs einegesetzt werden können sind z.B. Tastaturen; Kleidungsstücken; Möbeln; Tapeten.

Weiterhin können die Verbindungen der Formel (I) oder (I*) oder ein erfindungsgemäßes vernetztes oder polymerisiertes Material in OLEDs mit inverser Struktur eingesetzt werden. Bevorzugt werden die erfindungsgemäß eingesetzten Verbindungen der Formel (I) oder (I*) oder ein erfindungsgemäßes vernetztes oder polymerisiertes Material in diesen inversen OLEDs wiederum als Loch-/Excitonenblockermaterialien eingesetzt. Der Aufbau von inversen OLEDs und die üblicherweise darin eingesetzten Materialien sind dem Fachmann bekannt.

Des Weiteren betrifft die vorliegende Erfindung eine Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, MP3-Playern, Fahrzeugen sowie Zielanzeigen an Bussen und Bahnen; Beleuchtungseinheiten; Tastaturen; Kleidungsstücken; Möbeln; Tapeten enthaltend mindestens eine erfindungsgemäße organische Leuchtdiode oder mindestens eine erfindungsgemäße Licht-emittierende Schicht.

Die nachfolgenden Beispiele erläutern die Erfindung zusätzlich.

### Synthesebeispiele:

### Synthesebeispiel 1: Synthese von 3-Bromo-9-phenyl-6-triphenylsilyl-carbazol (Verbindung 1)

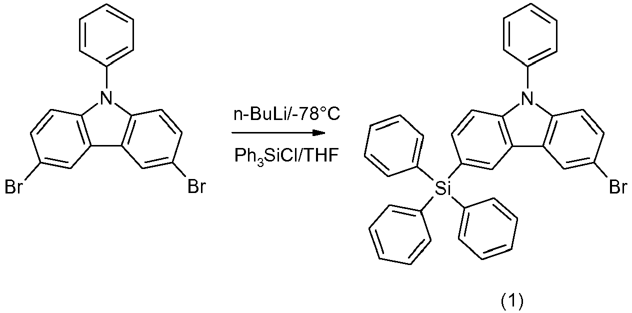

Eine Lösung von 9-(3-Methoxyphenyl)-3,6-dibrom-9H-carbazol (26 g, 1 eq) in trockenem THF (700 mL) wird bei -78 °C unter Argon langsam mit *n*-Butyllithium (1.6 M in Hexan, 41 mL, 1 eq) versetzt und 2 h bei -78 °C gerührt. Nach Zugabe einer Lösung von Chlortriphenylsilan (30 g, 1.5 eq) in trockenem THF (150 mL) bei -78 °C wird die Mischung unter Rühren über Nacht auf Raumtemperatur erwärmt. Überschüssiges Butyllithium wird mit gesättigter Ammoniumchlorid-Lösung hydrolysiert. Das ausgefallene Produkt wird abfiltriert und gründlich mit Methylenchlorid gewaschen. Die vereinigten Methylenchlorid-Filtrate werden mit Wasser extrahiert und zur Trockne eingeengt. Der Rückstand mit Aceton ausgerührt und abfiltriert. Ausbeute 74%.
¹H-NMR (CDCl₃, 400 MHz):
*δ* = 8.15 (s, 1H), 8.28 (s, 1H), 7.3-7.7 (m, 24H).

### Synthesebeispiel 2: Synthese von 3-Diphenylphosphanyl-9-phenyl-6-triphenylsilylcarbazol (Verbindung 2)

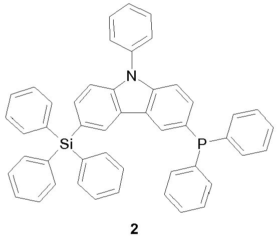

Eine Lösung von 3-Bromo-9-phenyl-6-triphenylsilyl-carbazol 1 (5.0 g, 8.6 mmol) in trockenem THF (80 mL) wird bei -78 °C unter Argon langsam mit *n*-Butyllithium (1.6 M in Hexan, 6.7 mL, 11 mmol) versetzt und 1.5 h bei -78 °C gerührt. Nach Zugabe einer Lösung von Chlordiphenylphosphin (2.85 g, 12.9 mmol) in trockenem THF (25 mL) bei -78 °C wird die Mischung unter Rühren über Nacht auf Raumtemperatur erwärmt. Zur Suspension wird EtOH (20 mL) gegeben. Das ausgefallene Produkt wird abfiltriert, mit EtOH gewaschen und getrocknet. Ausbeute 82%. Das Produkt wird ohne Aufreinigung weiter umgesetzt.

### Synthesebeispiel 3: Synthese von 3-Diphenylphosphinoyl-9-phenyl-6-triphenylsilylcarbazol (Verbindung 3)

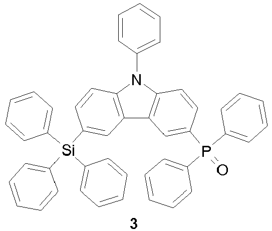

Zu einer Suspension von Verbindung 2 (3.5 g, 5.1 mmol) in Methylenchlorid (200 mL) werden 70 %ige m-Chlorperbenzoesäure (1.8 g, 7.4 mmol) portionsweise zugegeben. Die Reaktionslösung wird 48 h bei Raumtemperatur gerührt. Die organische Phase wird mit 10%iger Natronlauge (3x 50 mL), 5%iger Salzsäure (2x 50 mL) und mit gesättigter Natrium-hydrogencarbonatlösung (80 ml) gewaschen und eingeengt. Der Rückstand wird in Ethanol digeriert, filtriert und getrocknet. FC (SiO₂, CH₂Cl₂ zu CH₂Cl₂/MeOH 97:3) gibt das Produkt 3 (2.3 g, 64%).
¹H-NMR (CDCl₃, 400 MHz): *δ* = 7.3 -7.7 (m, 34H), 8.30 (s, 1 H), 8.52 (d, 1 H).

### Synthesebeispie/4: Synthese von Verbindung 4

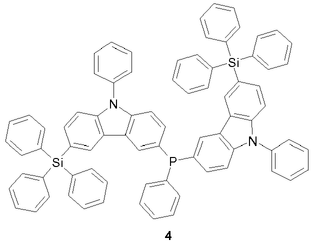

Eine Lösung von 3-Bromo-9-phenyl-6-triphenylsilyl-carbazol **1** (6.4 g, 11 mmol) in trockenem THF (100 mL) wird bei -78 °C unter Argon langsam mit *n*-Butyllithium (1.6 M in Hexan, 8.6 mL, 14 mmol) versetzt und 1 h bei -78 °C gerührt. Nach langsamer Zugabe einer Lösung von Dichlorphenylphosphin (0.92 g, 5.1 mmol) in trockenem THF (15 mL) bei -78 °C wird die Mischung unter Rühren über Nacht auf Raumtemperatur erwärmt. Die Lösung wird mit gesätt. NH₄Cl-Lösung (20 mL) versetzt und 30 min. gerührt. Der Niederschlag wird abfiltriert und gewaschen mit CH₂Cl₂. Die organische Phase wird mit Wasser (4x 75 mL) gewaschen, mit Na₂SO₄ getrocknet und eingeengt. Der Feststoff wird in EtOH suspendiert und abfiltriert. Ausbeute 3.73 g (67%). Das Produkt **4** wird ohne Aufreinigung weiter umgesetzt.
MALDI-MS: m/z: 1108 (M⁺), 1165 ([M + K + O]⁺)

### Synthesebeispiel 5: Synthese von Verbindung 5

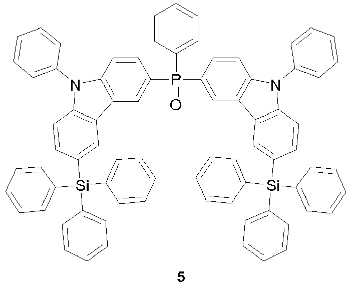

Zu einer Suspension von Produkt **4** (3.7 g, 3.4 mmol) in Methylenchlorid (100 mL) werden 70 %ige m-Chlorperbenzoesäure (0.91 g, 3.7 mmol) portionsweise zugegeben. Die Reaktionslösung wird 18 h bei Raumtemperatur gerührt. Die organische Phase wird mit 10%iger Natronlauge (4x 40 mL), 5%iger Salzsäure (3x 40 mL) und mit gesättigter Natriumhydrogencarbonatlösung (30 ml) gewaschen und eingeengt. FC (SiO₂, Essigester/Cyclohexan 2:1) und Digerierung in Aceton gibt das Produkt **5** (1.5 g, 41%).
¹H-NMR (CDCl₃, 400 MHz): *δ* = 7.45 (m, 24H), 7.6 (m, 27H), 7.68 (dd, 2H), 8.28 (s, 2H), 8.54 (d, 2H).

### Synthesebeispiel 6: Synthese von Verbindung 6

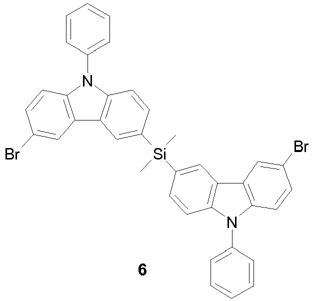

Eine Lösung von 9-Phenyl-3,6-dibrom-9H-carbazol (12 g, 1 eq) in trockenem THF (230 mL) wird bei -78 °C unter Argon langsam mit *n*-Butyllithium (1.6 M in Hexan, 18.8 mL, 1 eq) versetzt und 1,5 h bei -78 °C gerührt. Nach Zugabe einer Lösung von Dichlordimethylsilan (1.9 g, 0.5 eq) in trockenem THF (20 mL) bei -78 °C wird die Mischung unter Rühren über Nacht auf Raumtemperatur erwärmt. Überschüssiges Butyllithium wird mit gesättigter Ammoniumchlorid-Lösung hydrolysiert. Das ausgefallene Produkt wird abfiltriert und gründlich mit CH₂Cl₂ gewaschen. Säulenchromatographie (SiO₂, Hexan/EtOAc 10:1) gibt das Produkt **6.** Ausbeute 74%. ¹H-NMR (CDCl₃, 400 MHz): *δ* = 0.7 (s, 6H), 7.25 (dd, 4H), 7.40 (d, 2H), 7.42-7.50 (m, 6H), 7.55-7.65 (m, 6H) 8.22 (s, 2H), 8.30 (s, 2H).

### Synthesebeispiel 7: Synthese von Verbindung 7

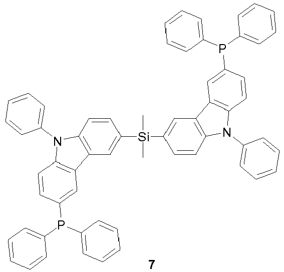

Eine Lösung von Verbindung **6** (4.2 g, 6.0 mmol) in trockenem THF (100 mL) wird bei -78 °C unter Argon langsam mit *n*-Butyllithium (1.6 M in Hexan, 9.4 mL, 15 mmol) versetzt und 1.5 h bei -78 °C gerührt. Nach Zugabe einer Lösung von Chlordiphenylphosphin (3.4 g, 15 mmol) in trockenem THF (20 mL) bei -78 °C wird die Mischung unter Rühren über Nacht auf Raumtemperatur erwärmt. Die Lösung wird mit gesätt. NH₄Cl-Lösung (25 mL) versetzt und 30 min. gerührt. Der Niederschlag wird abfiltriert und gewaschen mit CH₂Cl₂. Die organische Phase wird mit Wasser (4x 100 mL) gewaschen, mit Na₂SO₄ getrocknet und eingeengt. Der Feststoff wird in MeOH suspendiert und abfiltriert. Ausbeute: 4.4 g (80%). Das Produkt **7** wird ohne Aufreinigung weiter umgesetzt.

### Synthesebeispiel 8: Synthese von Verbindung 8

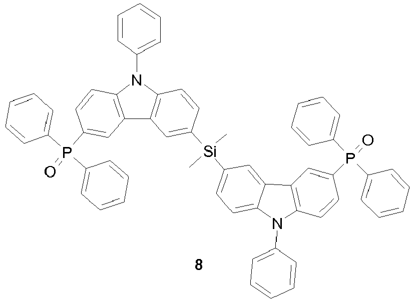

Zu einer Lösung von Produkt **7** (4.5 g, 4.9 mmol) in Methylenchlorid (120 mL) werden 70 %ige m-Chlorperbenzoesäure (3.1 g, 12 mmol) portionsweise zugegeben. Die Reaktionslösung wird 18 h bei Raumtemperatur gerührt. Die organische Phase wird mit 10%iger Natronlauge (3x 50 mL), 5%iger Salzsäure (3x 50 mL) und mit gesättigter Natriumhydrogencarbonatlösung (30 ml) gewaschen und eingeengt. FC (SiO₂, CH₂Cl₂ zu CH₂Cl₂/MeOH 99:1) gibt das Produkt **8** (2.2 g, 48%).
¹H-NMR (CDCl₃, 400 MHz): *δ* = 0.70 (s, 6H), 7.35-7.55 (m, 24H), 7.60 (m, 6H), 7.70 (m, 8H), 8.28 (s, 2H), 8.54 (d, 2H).

### Synthesebeispiel 9: Synthese von Verbindung 9

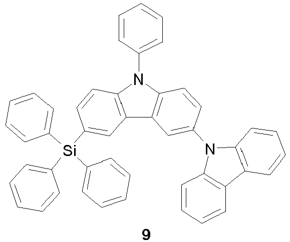

Carbazol (95%, 1.1 g, 6.0 mmol), Verbindung **1** (7.0 g, 12 mmol), Kaliumcarbonat (2.1 g, 15 mmol) und Kupferpulver (80 mg, 1.3 mmol) werden auf 180 °C erhitzt und 60 h bei dieser Temperatur gerührt. Nach dem Abkühlen auf Raumtemperatur wird mit Methylenchlorid extrahiert. FC (SiO₂, Cyclohexan/CH₂Cl₂ 8:1 zu 6:1 gibt das Produkt **9** (2.1 g, 53%).
¹H-NMR (CDCl₃, 400 MHz): *δ* = 7.2-7.4 (m, 15H), 7.5 (m, 3H), 7.6-7.7 (m, 12H), 8.15 (m, 3H), 8.30 (s, 1 H).

### Synthesebeispie/ 10: Synthese von Verbindung 10

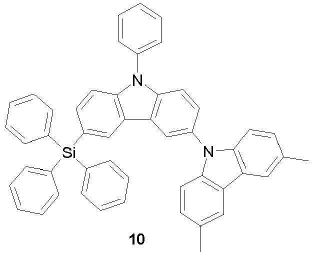

Die Synthese von 3,6-Dimethylcarbazol wird beschrieben in J. Chem. Soc., 1949, 1384-1388, J. Org. Chem., 2003, 68, 2209-2215 und in Dalton Trans., 2003, 13, 2718-2727.

3,6-Dimethylcarbazol (1.1 g, 5.7 mmol), Verbindung **1** (6.7 g, 12 mmol), Kaliumcarbonat (2.0 g, 14 mmol) und Kupferpulver (76 mg, 1.2 mmol) werden auf 180 °C erhitzt und 72 h bei dieser Temperatur gerührt. Nach dem Abkühlen auf Raumtemperatur wird mit Methylenchlorid extrahiert. FC (SiO₂, Cyclohexan/CH₂Cl₂ 8:1) gibt das Produkt **10** (1.2 g, 30%).
¹H-NMR (CDCl₃, 400 MHz): *δ* = 2.5 (s, 6H), 7.2 (m, 4H), 7.35 (m, 9H), 7.48 (m, 3H), 7.55 (d, 1 H), 7.62 (m, 11 H), 7.9 (s, 2H), 8.1 (s, 1 H), 8.3 (s, 1 H).

### Synthesebeispiel 11: Synthese von Verbindung 11

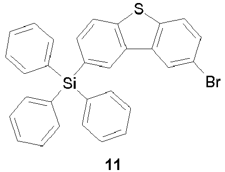

Die Synthese von 2,8-Dibromdibenzothiophen wird in W. Yang et al., J. Mater. Chem. 2003, 13, 1351 beschrieben.

Eine Lösung von 2,8-Dibromdibenzothiophen (7.3 g, 21 mmol) in trockenem THF (215 mL) wird bei -78 °C unter Argon langsam mit *n*-Butyllithium (1.6 M in Hexan, 16.6 mL, 26.6 mmol) versetzt und 1.5 h bei -78 °C gerührt. Nach langsamer Zugabe einer Lösung von Triphenylchlorsilan (9.7 g, 32 mmol) in trockenem THF (25 mL) bei -78 °C wird die Mischung unter Rühren über Nacht auf Raumtemperatur erwärmt. Die Lösung wird mit gesätt. NH₄Cl-Lösung (20 mL) versetzt und 30 min. gerührt. Der Niederschlag wird abfiltriert und gewaschen mit CH₂Cl₂. Die organische Phase wird mit Wasser (4x 100 mL) gewaschen, mit Na₂SO₄ getrocknet und eingeengt. FC (SiO₂, Cyclohexan/CH₂Cl₂ 20:1 gibt das Produkt **11** (3.4 g, 31%).
¹H-NMR (CDCl₃, 400 MHz): *δ* = 7.40 (dd, 6H), 7.48 (t, 3H), 7.54 (d, 1 H), 7.62 (d, 6H), 7.65 (d, 1H), 7.71 (d, 1H), 7.86 (d, 1H), 8.13 (s, 1H), 8.31 (s, 1H).

### Synthesebeispie/ 12: Synthese von Verbindung 12

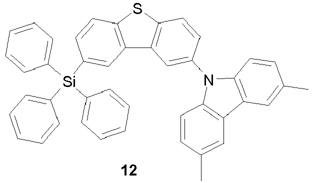

3,6-Dimethylcarbazol (0.73 g, 3.8 mmol), Verbindung **11** (2.3 g, 4.3 mmol), Kaliumcarbonat (1.3 g, 9.5 mmol) und Kupferpulver (48 mg, 0.76 mmol) werden auf 185 °C erhitzt und 48 h bei dieser Temperatur gerührt. Nach dem Abkühlen auf Raumtemperatur wird mit Methylenchlorid extrahiert. Der Rückstand wird in EtOH suspendiert, 24 h gerührt und abfiltriert. FC (SiO₂, Cyclohexan/CH₂Cl₂ 9:1) gibt das Produkt **12** (1.0 g, 43%).
MALDI-MS: m/z: 636 (M⁺).

### Synthesebeispie/ 13: Synthese von Verbindung 13

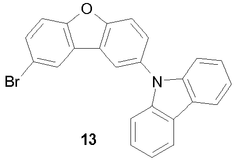

Die Synthese von 2,8-Dibromdibenzofuran wird u.a. in Org. Lett., 2006, 8, 4211-4214 und J. Med. Chem., 1985, 28, 1728-1740 beschrieben.
2,8-Dibromobenzofuran (16 g, 49 mmol), Carbazol (95%, 8.6 g, 49 mmol), Kaliumcarbonat (16.9 g, 123 mmol) und Kupferpulver (622 mg, 9.8 mmol) in Tridecan (50 mL) werden auf 185 °C erhitzt und 76 h bei dieser Temperatur gerührt. Nach dem Abkühlen auf Raumtemperatur wird mit Methylenchlorid extrahiert. Tridecan wird abdestilliert. Umkristallisation aus Cyclohexan und FC (SiO₂, Cyclohexan/CH₂Cl₂, 100:0 bis 9:1) gibt das Produkt 13 (6.9 g, 34%).
¹H-NMR (CDCl₃, 400 MHz): *δ* = 7.26-7.45 (m, 6H), 7.54 (d, 1 H), 7.60-7.68 (2x d, 2H), 7.78 (d, 1 H), 8.08 (2x s, 2H), 8.18 (d, 2H).

### Synthesebeispie/ 14: Synthese von Verbindung 14

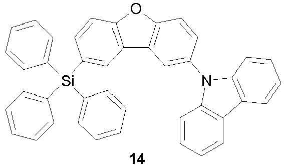

Eine Lösung von 13 (1.0 g, 2.4 mmol) in trockenem Diethylether (5 mL) wird unter Argon langsam mit *n*-Butyllithium (1.6 M in Hexan, 1.6 mL, 2.6 mmol) versetzt und 25 Min. bei Rückfluss gerührt. Unter Rückfluss wird eine Lösung von Triphenylchlorsilan (2.2 g, 7.3 mmol) in trockenem Diethylether (7.5 mL) zugetropft und 30 unter Rückfluss nachgerührt. Die Mischung wird mit MeOH (5 ml) versetzt und mit CH2Cl2 weiter verdünnt. Die organischen Phasen werden mit Wasser (3x 25 mL) gewaschen, mit Na₂SO₄ getrocknet und eingeengt. FC (RP-C18-SiO₂ MeCN/CH₂Cl₂ 7:3) gibt Produkt **14** (0.43 g, 30%).
¹H-NMR (CDCl₃, 400 MHz): *δ* = 8.16 (s, 1H), 8.13 (d, 2H), 8.00 (s, 1H), 7.77 (d, 1H), 7.73 (d, 1 H), 7.66 (d, 1 H), 7.59 (m, 7H), 7.39 (m, 11 H), 7.31 (d, 2H), 7.26 (d, 2H).

### Verbesserte Synthese von Verbindung 14:

Eine Lösung von **13** (11.0 g, 26.7 mmol) und Triphenylchlorsilan (8.12 g, 26.7 mmol) in trockenem Diethylether (85 mL) wird unter Argon langsam mit *n*-Butyllithium (1.6 M in Hexan, 18.4 mL, 29.4 mmol) versetzt und über Nacht gerührt. Die Mischung wird mit MeOH versetzt und mit CH₂Cl₂ weiter verdünnt. Die organischen Phasen werden mit Wasser gewaschen, mit Na₂SO₄ getrocknet und eingeengt. FC (RP-C18-SiO₂ MeCN/CH₂Cl₂ 7:3) oder Umkristallisation aus CH₂Cl₂/MeCN gibt Produkt **14** (10.6 g, 67%).

Als Nebenkomponente in der Synthese von **14** kann Verbindung **34** isoliert werden: 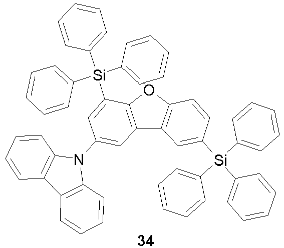 ¹H-NMR (CD₂Cl₂, 400 MHz): *δ* = 7.20-7.50 (m, 26H), 7.58 (m, 9H), 7.65 (d, 1H), 7.95 (d, 3H), 8.10 (d, 2H), 8.14 (s, 1H), 8.19 (s, 1H).

### Synthesebeispie/ 15: Synthese von Verbindung 15

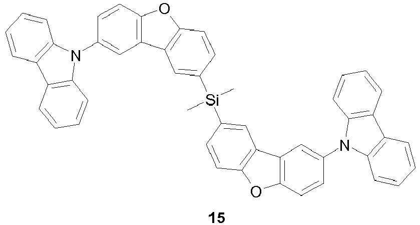

Eine Lösung von **13** (1.0 g, 2.4 mmol) und Dichlordimethylsilan (0.16 g) in trockenem Diethylether (10 mL) wird unter Argon langsam mit *tert*-Butyllithium (1.7 M in Pentan, 2.9 mL, 4.9 mmol) versetzt und übernacht gerührt. Die Mischung wird mit MeOH (5 ml) versetzt und mit CH2Cl2 weiter verdünnt. Die organischen Phasen werden mit Wasser (3x 25 mL) gewaschen mit Na₂SO₄ getrocknet und eingeengt. FC (RP-C18-SiO₂ MeCN/CH₂Cl₂ 75:25) gibt Produkt **15** (0.37 g, 42%).
¹H-NMR (CDCl₃, 400 MHz): *δ* = 8.12 (d, 4H), 8.05 (2xs, 4H), 7.73 (d, 2H), 7.67 (d, 2H), 7.61 (d, 2H), 7.56 (d, 2H), 7.30 (m, 12 H), 0.65 (s, 6H).

### Synthesebeispie/ 16: Synthese von Verbindung 16

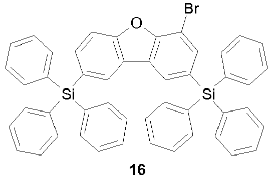

### Schritt 1:

### Synthese von 2,8-bis(triphenylsilyl)-dibenzofuran

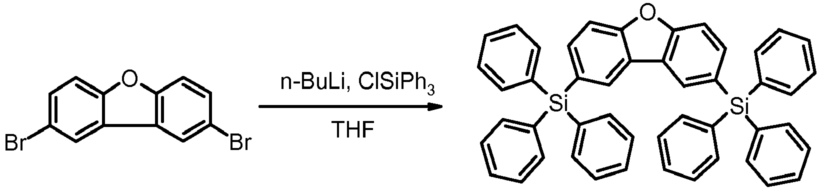

6.02 g (18.47 mmol) 2,8-Dibromdibenzofuran werden in 120 ml THF suspendiert und bei -78°C vorsichtig mit 22.9 ml (36.64 mmol) n-BuLi (1,6M in Hexan) versetzt. Im Anschluss wird 3 h bei - 78°C gerührt. Das Reaktionsgemisch wird mit einer Lösung von 10.91 g (37.00 mmol) Chlortriphenylsilan in 120 ml THF versetzt, auf Raumtemperatur aufwärmen lassen und 16 h bei Raumtemperatur gerührt. Es wird vorsichtig mit 10 ml Methanol gequencht und anschließend bis zur Trockene eingeengt. Der Rückstand wird erst in Methanol, dann in Wasser und anschließend wieder in Methanol digeriert, abfilitriert und getrocknet. Das Rohprodukt wird in Methylenchlorid gelöst, über Kieselgel filtriert und durch Überschichten mit Cyclohexan auskristallisiert. Das Kristallisat wird abfiltriert und getrocknet. Man erhält 9.28 g (73 %) weißes Pulver.
¹H-NMR: (CD₂Cl₂, 500 MHz):
*δ* = 7.35-7.38 (m, 12 H, CH_{Ar}), 7.41-7.44 (m, 6 H, CH_{Ar}), 7.56-7.57 (m, 12 H, CH_{Ar}), 7.58-7.63 (m, 4 H, CH_{Ar}), 8.09 (s, 2 H, CH_{Ar}).
Masse (El): m/e = 684 (M⁺)

### Schritt 2:

Eine Lösung von 2,8-Bis(triphenylsilyl)-dibenzofuran (10.0 g, 14.6 mmol) in trockenem THF (200 mL) wird bei -78 °C unter Argon langsam mit n-Butyllithium (1.6 M in Hexan, 11.0 mL, 17.5 mmol) versetzt und 2 h bei 0°C gerührt. Nach langsamer Zugabe einer Lösung von 1,2-Dibromethan (3.88 g, 20.4 mmol) in trockenem THF (8 mL) bei -78 °C wird die Mischung unter Rühren über Nacht auf Raumtemperatur erwärmt. Die Lösung wird mit MeOH (20 mL) versetzt und 30 min. gerührt. Methylenchlorid wird zugesetzt bis eine Lösung entsteht. Die organische Phase wird mit Wasser (3x 100 mL) gewaschen, mit Na₂SO₄ getrocknet und eingeengt. Ausbeute 11.2 g. Das Gemisch aus ~25% Edukt und ~75% Produkt wird in dem nächsten Schritt (Beispiel **17**) eingesetzt.

### Synthesebeispie/ 17: Synthese von Verbindung 17

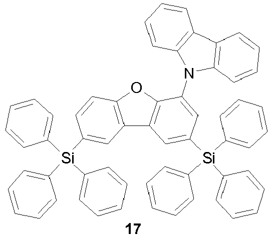

Produkt 16 (siehe Beispiel **16,** 11.0 g), Carbazol (95%, 2.53 g, 14.4 mmol), Kaliumcarbonat (4.98 g, 36.0 mmol) und Kupferpulver (183 mg, 2.88 mmol) in Tridecan (50 mL) werden auf 195 °C erhitzt und 96 h bei dieser Temperatur gerührt. Nach dem Abkühlen auf Raumtemperatur wird mit Methylenchlorid extrahiert. Tridecan wird abdestilliert. FC (SiO₂, Cyclohexan/CH₂Cl₂ 85:15) gibt das Produkt 17 (6.3 g, 51% (über zwei Schritten).
¹H-NMR (CDCl₃, 400 MHz): *δ* = 7.28 (dd, 2H), 7.33-7.48 (m, 22H), 7.57-7.66 (m, 14H), 7.83 (s, 1 H), 8.15 (m, 4H).

### Synthesebeispie/ 18: Synthese von Verbindung 18

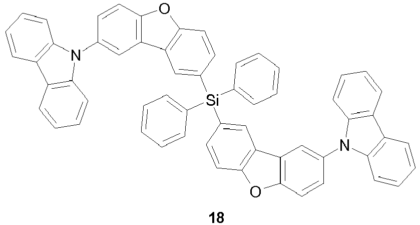

Eine Lösung von **13** (1.0 g, 2.4 mmol) und Dichlordiphenylsilan (0.32 g, 1.2 mmol) in trockenem Diethylether (10 mL) wird unter Argon langsam mit *tert*-Butyllithium (1.7 M in Pentan, 2.9 mL, 4.9 mmol) versetzt und übernacht gerührt. Die Mischung wird mit Me-OH (5 ml) versetzt und mit CH₂Cl₂ weiter verdünnt. Die organischen Phasen werden mit Wasser (3x 25 mL) gewaschen mit Na₂SO₄ getrocknet und eingeengt. FC (RP-C18-SiO₂ MeCN/CH₂Cl₂ 2:3) gibt Produkt **18** (0.50 g, 49%).
¹H-NMR (CDCl₃, 400 MHz): *δ* = 8.12 (s, 2H), 8.10 (m, 4H), 7.96 (s, 2H), 7.74 (d, 4H), 7.65 (d, 2H), 7.60 (d, 4H), 7.56 (d, 2H), 7.36 (m, 10 H), 7.26 (m, 8H).

### Synthesebeispiel 19: Synthese von Verbindung 19

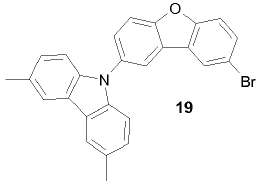

2,8-Dibromobenzofuran (18.8 g, 57.7 mmol), 3,6-Dimethylcarbazol (12.4 g, 63.4 mmol), Kaliumcarbonat (21.9 g, 159 mmol) und Kupferpulver (732 mg, 11.5 mmol) in Tridecan (200 mL) werden auf 185 °C erhitzt und 240 h bei dieser Temperatur gerührt. Nach dem Abkühlen auf Raumtemperatur wird mit Methylenchlorid extrahiert. Tridecan wird abdestilliert. Umkristallisation aus Cyclohexan und FC (SiO₂, Cyclohexan/CH₂Cl₂, 100:0 bis 9:1) gibt das Produkt **19** (8.6 g, 33%).
¹H-NMR (CDCl₃, 400 MHz): *δ* = 2.55 (s, 6H), 7.18-7.28 (m, 6H), 7.51 (d, 1H), 7.59-7.65 (2x d, 2H), 7.75 (d, 1 H), 7.92 (2x s, 2H), 8.05 (d, 2H).

### Synthesebeispiel 20: Synthese von Verbindung 20

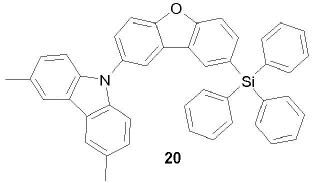

Eine Lösung von 19 (2.8 g, 6.4 mmol) und Triphenylchlorsilan (2.0 g, 6.4 mmol) in trockenem Diethylether (20 mL) wird unter Argon langsam mit *n*-Butyllithium (1.6 M in Hexan, 5.2 mL, 8.3 mmol) versetzt und übernacht gerührt. Die Mischung wird mit Me-OH (10 ml) versetzt und mit CH₂Cl₂ weiter verdünnt. Die organischen Phasen werden mit Wasser (3x 50 mL) gewaschen mit Na₂SO₄ getrocknet und eingeengt. Umkristallisation (2x) gibt Produkt **20** (2.25 g, 57%).
¹H-NMR (CDCl₃, 400 MHz): *δ* = 2.50 (s, 6H), 7.20 (m, 4H), 7.40 (m, 9H), 7.58 (m, 7H), 7.65 (d, 1H), 7.74 (dd, 2H), 7.90 (s, 2H), 7.98 (s, 1H), 8.10 (s, 1H).

### Synthesebeispiel 21: Synthese von Verbindung 21

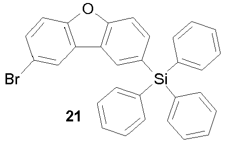

Eine kalte Lösung (-15°C) von 2,8-Dibromdibenzofuran (20.0 g, 61.3 mmol) in trockenem Diethylether (200 mL) wird unter Argon langsam mit *n*-Butyllithium (1.6 M in Hexan, 40.3 mL, 64.4 mmol) versetzt und 2 h bei -15°C gerührt, wonach eine Lösung von Triphenylchlorsilan (18.6 g, 61.3 mmol) in trockenem Diethylether (100 mL) zugetropft wird. Die Mischung rührt übernacht auf RT und wird dann mit MeOH (25 ml) versetzt und mit CH₂Cl₂ weiter verdünnt. Die organischen Phasen werden mit Wasser (3x 100 mL) gewaschen, mit Na₂SO₄ getrocknet und eingeengt. FC (SiO₂, Cyclohexan/CH₂Cl₂, 100:0 bis 9:1) gibt Produkt **21** (9.3 g, 30%).
¹H-NMR (CD₂Cl₂, 400 MHz): *δ* =, 7.38-7.50 (m, 10 H), 7.56 (d, 1H), 7.60 (m, 7H), 7.68 (d, 1H), 8.01 (s, 1 H), 8.12 (s, 1 H).

### Synthesebeispiel 22: Synthese von Verbindung 22

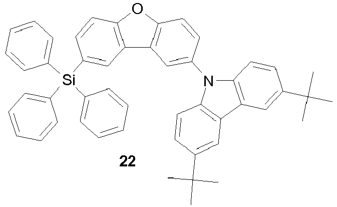

Die Synthese von 3,6-Bis(tert-Butyl)carbazol wird beschrieben in Chemistry Letters, 37(9), 986-987; 2008

Verbindung **21** (5.13 g, 10.1 mmol), 3,6-Bis(tert-Butyl)carbazol (2.91 g, 10.4 mmol), Kaliumcarbonat (3.59 g, 26.0 mmol) und Kupferpulver (133 mg, 2.1 mmol) in Tridecan (20 ml) werden auf 185 °C erhitzt und 60 h bei dieser Temperatur gerührt. Nach dem Abkühlen auf Raumtemperatur wird mit Methylenchlorid extrahiert. Die Lösung wird eingeengt und der Rückstand wird in Heptan (2 x 60 ml) suspendiert, gerührt und abfiltriert. Produkt **22** (4.69 g, 66%).
¹H-NMR (CDCl₃, 400 MHz): *δ* = 1.48 (s, 18H), 7.27 (d, 2H), 7.40 (m, 11 H), 7.58 (m, 7H), 7.70 (dd, 2H), 7.78 (d, 1 H), 8.02 (s, 1 H), 8.18 (2xs, 3H).

### Synthesebeispiel 23: Synthese von Verbindung 23

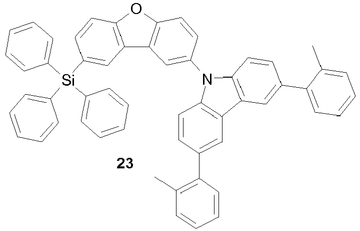

3,6-Bis(2-Tolyl)carbazol kann nach dem Verfahren beschrieben in US2005/0084711 A1 hergestellt werden.

Verbindung **21** (4.30 g, 8.50 mmol), 3,6-Bis(2-Tolyl)carbazol (2.95 g, 8.5 mmol), Kaliumcarbonat (2.94 g, 21.2 mmol) und Kupferpulver (108 mg, 1.70 mmol) in Tridecan (25 ml) werden auf 185 °C erhitzt und 96 h bei dieser Temperatur gerührt. Nach dem Abkühlen auf Raumtemperatur wird mit Methylenchlorid extrahiert. Die Lösung wird eingeengt und der Rückstand wird in Heptan (25 ml) suspendiert, gerührt und abfiltriert. FC (SiO₂, Cyclohexan/CH₂Cl₂, 100:0 bis 9:1) gibt Produkt **23** (3.14 g, 48%).
¹H-NMR (CD₂Cl₂, 400 MHz): *δ* = 2.35 (s, 6H), 7.23 - 7.47 (m, 21 H), 7.60 (d, 6H), 7.72 (m, 3H), 7.85 (d, 1 H), 8.08 (s, 2H), 8.13 (s, 1 H) 8.22 (s, 1 H).

### Synthesebeispiel 24: Synthese von Verbindung 24

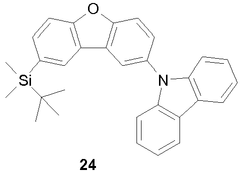

Eine Lösung von **13** (0.50 g, 0.12 mmol) und Tert-butyldimethylchlorsilan (0.28 g, 0.18 mmol) in trockenem Diethylether (9 mL) wird unter Argon langsam mit *n*-Butyllithium (1.6 M in Hexan, 0.8 mL, 0.13 mmol) versetzt und übernacht gerührt. Die Mischung wird mit gesätt. NH₄Cl-Lösung (10 ml) versetzt und mit CH₂Cl₂ extrahiert. Die organischen Phasen werden mit Na₂SO₄ getrocknet und eingeengt. FC (C18-SiO₂, MeCN) gibt Produkt **24** (0.15 g, 27%). Die Ausbeute ist niedrig wegen der kleinen Ansatzgröße.
¹H-NMR (CD₂Cl₂, 400 MHz): *δ* = 0.36 (s, 6H), 0.90 (s, 9H), 7.30 (dd, 2H), 7.42 (dd, 4H), 7.66 (m, 3H), 7.80 (d, 1H), 8.13 (s, 1H), 8.18 (s, 1H), 8.19 (d, 2H).

### Synthesebeispiel 25: Synthese von Verbindung 25

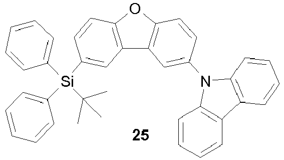

Eine Lösung von **13** (0.50 g, 0.12 mmol) und Tert-Butyldiphenylchlorsilan (0.50 g, 0.18 mmol) in trockenem Diethylether (9 mL) wird unter Argon langsam mit *n*-Butyllithium (1.6 M in Hexan, 1.14 mL, 0.18 mmol) versetzt und übernacht gerührt. Die Mischung wird mit gesätt. NH₄Cl-Lösung (10 ml) versetzt und mit CH₂Cl₂ extrahiert. Die organischen Phasen werden mit Na₂SO₄ getrocknet und eingeengt. FC (C18-SiO₂, MeCN) gibt Produkt **25** (0.12 g, 17%). Die Ausbeute ist niedrig wegen der kleinen Ansatzgröße.
¹H-NMR (CD₂Cl₂, 400 MHz): *δ* = 1.21 (s, 9H), 7.28 (dd, 2H), 7.37 (m, 10H), 7.60 (m, 5H), 7.64 (d, 1 H), 7.74 (d, 1 H), 7.81 (d, 1 H), 8.04 (s, 1 H), 8.15 (s, 1 H), 8.18 (d, 2H).

### Synthesebeispiel 26: Synthese von Verbindung 26

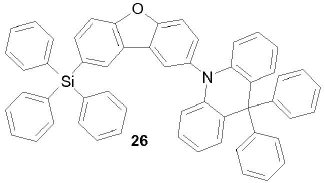

Die Synthese von 9,9-Dimethyl-9,10-dihydro-acridin wird beschrieben in Chemische Berichte; 37; 1904; 3202

Verbindung **21** (6.07 g, 12.0 mmol), 9,9-Dimethyl-9,10-dihydro-acridin (4.00 g, 12.0 mmol), Kaliumcarbonat (4.15 g, 30.0 mmol) und Kupferpulver (152 mg, 2.4 mmol) in Tridecan (30 ml) werden auf 220 °C erhitzt und 48 h bei dieser Temperatur gerührt. Nach dem Abkühlen auf Raumtemperatur wird mit Methylenchlorid extrahiert. Die Lösung wird eingeengt und der Rückstand wird in wenig Heptan suspendiert, gerührt und abfiltriert und nachher in Methylenchlorid suspendiert, gerührt und abfiltriert gibt das Produkt **26** (2.13 g, 23%).
¹H-NMR (CD₂Cl₂, 400 MHz): *δ* = 6.42 (d, 2H), 6.87 (dd, 4H), 7.00 (m, 6H), 7.18-7.28 (m, 7H), 7.40 (t, 6H), 7.45 (m, 4H), 7.60 (d, 6H), 7.65 (d, 1 H), 7.69 (d, 1 H), 7.73 (d, 1 H), 8.03 (s, 1 H).

### Synthesebeispiel 27: Synthese von Verbindung 27

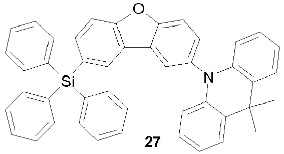

Die Synthese von 9,9-Dimethyl-9,10-dihydro-acridin wird beschrieben in Chemische Berichte, 113(1), 358-84; 1980

Verbindung **21** (3.99 g, 7.89 mmol), 9,9-Dimethyl-9,10-dihydro-acridin (1.82 g, 8.68 mmol), Kaliumcarbonat (3.00 g, 21.7 mmol) und Kupferpulver (100 mg, 1.58 mmol) in Tridecan (40 ml) werden auf 225 °C erhitzt und 92 h bei dieser Temperatur gerührt. Nach dem Abkühlen auf Raumtemperatur wird mit Methylenchlorid extrahiert. Die Lösung wird eingeengt und FC (SiO₂, Cyclohexan/CH₂Cl₂, 9:1 bis 1:1) gibt Produkt **27** (0.85 g, 17%).
¹H-NMR (CD₂Cl₂, 400 MHz): *δ* = 1.68 (s, 6H), 6.24 (d, 2H), 6.89 (dd (4H), 7.36-7.48 (m, 12H), 7.58 (d, 6H), 7.70 (dd, 2H), 7.83 (d+s, 2H), 8.13 (s, 1 H).

### Synthesebeispiel 28: Synthese von Verbindung 28

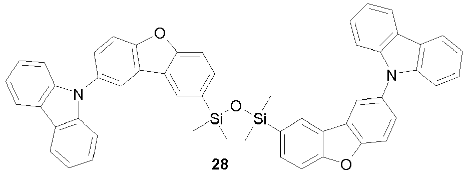

Eine Mischung von **13** (5.15 g, 12.5 mmol) und 1,3-Dichlor-1,1,3,3-tetramethyldisiloxan (1.31, 6.25 mmol) in trockenem Diethylether (150 mL) wird unter Argon langsam mit *t*-Butyllithium (1.7 M in Pentan, 14.7 mL, 25 mmol) versetzt und übernacht gerührt. Die Mischung wird mit gesätt. NH₄Cl-Lösung (30 ml) versetzt und mit CH₂Cl₂ extrahiert. Die organischen Phasen werden mit Na₂SO₄ getrocknet und eingeengt. FC (SiO₂, Cyclohexan/CH₂Cl₂, 9:1 bis 1:9) gibt Produkt **28** (2.90 g, 58%).
¹H-NMR (CD₂Cl₂, 400 MHz): *δ* = 0.40 (s, 12H), 7.28 (dd, 4H), 7.37 (d, 4H), 7.42 (dd, 4H), 7.53 (d, 2H), 7.55 (d, 2H), 7.60 (d, 2H), 7.68 (d, 2H), 7.96 (s, 2H), 8.04 (s, 2H), 8.18 (d, 4H).

### Synthesebeispiel 29: Synthese von Verbindung 29

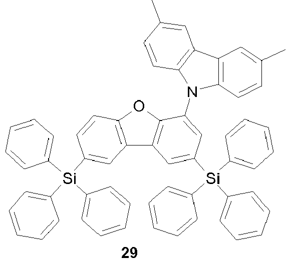

Produkt **16** (siehe Beispiel **16,** 10.0 g), 3,6-Dimethylcarbazol (2.55 g, 13.1 mmol), Kaliumcarbonat (4.61 g, 32.7 mmol) und Kupferpulver (166 mg, 2.61 mmol) in Tridecan (100 mL) werden auf 205 °C erhitzt und 72h bei dieser Temperatur gerührt. Nach dem Abkühlen auf Raumtemperatur wird mit Methylenchlorid extrahiert. Tridecan wird abdestilliert. FC (SiO₂, Cyclohexan/CH₂Cl₂ 9:1 zu 1:1) gibt das Produkt **29** (3.1 g, 26% (über zwei Schritten).
¹H-NMR (CDCl₃, 400 MHz): *δ* = 2.50 (s, 6H), 7.04 (d, 2H), 7.11 (d, 2H), 7.32-7.46 (m, 19H), 7.52-7.62 (m, 13H), 7.80 (s, 1 H), 7.88 (s, 2H), 8.12 (s, 2H).

### Synthesebeispiel 30: Synthese von Verbindung 30

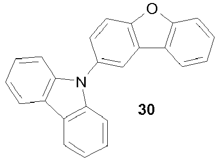

2-Bromdibenzofuran (24.7 g, 100 mmol), Carbazol (95%, 26.4 g, 150 mmol), Kaliumcarbonat (51.8 g, 375 mmol) und Kupferpulver (1.27 g, 20 mmol) in Tridecan (150 mL) werden auf 180 °C erhitzt und 72h bei dieser Temperatur gerührt. Nach dem Abkühlen auf Raumtemperatur wird mit Methylenchlorid extrahiert. Die Lösung wird eingeengt und der Rückstand wird in Heptan (25 ml) suspendiert, gerührt und abfiltriert. FC (SiO₂, Cyclohexan/CH₂Cl₂ 5:1) gibt Produkt **30** (19.6 g, 59%).
¹H-NMR (CD₂Cl₂, 400 MHz): *δ* = 7.3 (dd, 2H), 7.4 (m, 5H), 7.5 (dd, 1H), 7.6 (dd, 2H), 7.8 (d, 1 H), 8.0 (d, 1 H), 8.2 (s+d, 1+2H).

### Synthesebeispiel 31: Synthese von Verbindung 31

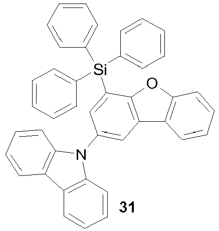

Eine Lösung von **30** (3.3 g, 10 mmol) in THF (130 ml) wird bei -78°C unter Argon langsam mit *n*-Butyllithium (1.6 M in Hexan, 7.5 mL, 12 mmol) versetzt und zwei Stunden bei 0°C gerührt. Die Lösung wird abgekühlt auf -78°C und eine Lösung von Triphenylchlorsilan (4.42 g, 15 mmol) in THF (10 ml) wird zugegeben. Die Lösung wird übernacht auf RT gerührt, mit NH₄Cl-Lösung (30 ml) versetzt und mit CH₂Cl₂ extrahiert. Die organischen Phasen werden mit Na₂SO₄ getrocknet und eingeengt. FC (C18-SiO₂, MeCN) gibt Produkt **31** (2.35 g, 40%).
¹H-NMR (CDCl₃, 400 MHz): *δ* = 7.28 (d, 1 H), 7.32-7.48 (m, 17H), 7.60 (s, 1 H), 7.70 (d, 6H), 7.95 (d, 1 H), 8.2 (d, 2H), 8.20 (s, 1 H).

### Synthesebeispiel 32: Synthese von Verbindung 32

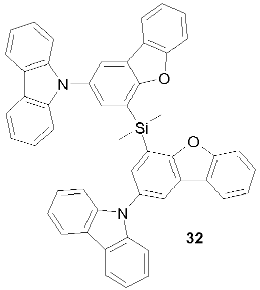

Eine Lösung von **30** (3.0 g, 9 mmol) in THF (80 ml) wird bei -40°C unter Argon langsam mit *n*-Butyllithium (1.6 M in Hexan, 9.5 mL, 15 mmol) versetzt und zwei Stunden bei 0°C gerührt. Die Lösung wird abgekühlt auf -78°C und eine Lösung von Dimethyldichlorsilan (0.59 g, 4.5 mmol) in THF (5 ml) wird zugegeben. Die Lösung wird übernacht auf RT gerührt, mit NH₄Cl-Lösung (20 ml) versetzt und mit CH₂Cl₂ extrahiert. Die organischen Phasen werden mit Na₂SO₄ getrocknet und eingeengt. FC (SiO₂, Cyclohexan:CH₂Cl₂ 9:1) gibt Produkt **32** (2.08 g, 64%).
¹H-NMR (CD₂Cl₂, 400 MHz): *δ* = 1.02 (s, 6H), 7.24 (m, 8H), 7.30 (d, 4H), 7.40 (dd, 2H), 7.55 (dd, 2H), 7.65 (d, 2H), 7.80 (s, 2H), 7.98 (d, 2H), 8.15 (d+s, 4+2H)

### Synthesebeispiel 33: Synthese von Verbindung 33

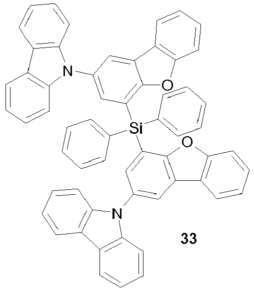

Eine Lösung von **30** (2.2 g, 6.7 mmol) in THF (60 ml) wird bei -40°C unter Argon langsam mit *n*-Butyllithium (1.6 M in Hexan, 7.3 mL, 11.7 mmol) versetzt und zwei Stunden bei 0°C gerührt. Die Lösung wird abgekühlt auf -78°C und eine Lösung von Diphenyldichlorsilan (0.86 g, 3.35 mmol) in THF (5 ml) wird zugegeben. Die Lösung wird übernacht auf RT gerührt, mit NH₄Cl-Lösung (20 ml) versetzt und mit CH₂Cl₂ extrahiert. Die organischen Phasen werden mit Na₂SO₄ getrocknet und eingeengt. FC (SiO₂, Cyclohexan:CH₂Cl₂ 9:1) gibt Produkt 33 (1.82 g, 64%).
¹H-NMR (CD₂Cl₂, 400 MHz): *δ* = 7.18 (m, 8H), 7.32 (d, 4H), 7.40 (m, 8H), 7.50 (m, 4H), 7.70 (s, 2H), 7.88 (d, 4H), 7.98 (d, 2H), 8.08 (d, 4H), 8.25 (s, 2H)

### Diodenbeispiele

### Vergleichsbeispiel:

### Herstellung einer OLED enthaltend 9-Phenyl-3,6-bis(triphenylsilyl)-carbazol als Matrixmaterial (91.5 Gew.-%) und als Loch-/Excitonenblocker

Das als Anode verwendete ITO-Substrat wird zuerst mit kommerziellen Reinigungsmitteln für die LCD-Produktion (Deconex^{®} 20NS und Neutralisationsmittel 250RGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter und Excitonenblocker wird Ir(dpbic)₃ (V1) mit einer Dicke von 45 nm auf das Substrat aufgebracht. 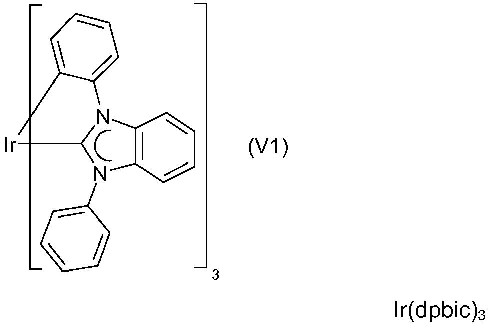 (zur Herstellung siehe Ir-Komplex (7) in der Anmeldung WO 2005/019373).

Anschließend wird eine Mischung aus 8.5 Gew.-% der Verbindung (V2) 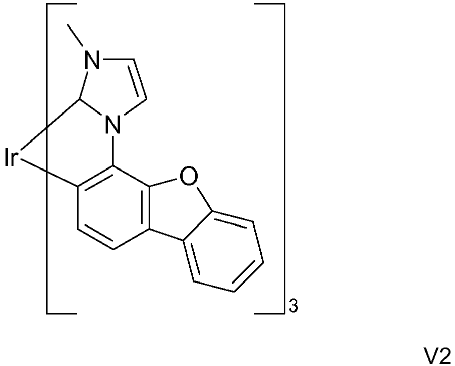 und 91.5 Gew.-% der Verbindung (V1) in einer Dicke von 10 nm aufgedampft, wobei erstere Verbindung als Emittermaterial, letztere als Matrixmaterial fungiert.

Anschließend wird eine Mischung aus 8.5 Gew.-% der Verbindung (V2) und 91.5 Gew.-% der Verbindung 9-Phenyl-3,6-bis(triphenylsilyl)-carbazol (V3) in einer Dicke von 40 nm aufgedampft, wobei erstere Verbindung als Emittermaterial, letztere als Matrixmaterial fungiert.

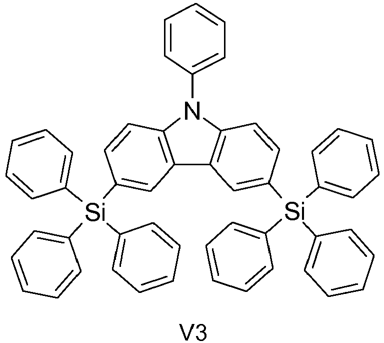

Anschließend wird das Material 9-Phenyl-3,6-bis(triphenylsilyl)-carbazol (V3) mit einer Dicke von 10 nm als Excitonen- und Lochblocker aufgedampft.

Als nächstes wird ein Elektronenleiter BCP in einer Dicke von 40 nm, eine 0,75 nm dicke Lithiumfluorid-Schicht und abschließend eine 110 nm dicke Al-Elektrode aufgedampft.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

### Diodenbeispiel 1:

Herstellung und Aufbau einer OLED wie im Vergleichsbeispiel, nur wird statt 9-Phenyl-3,6-bis(triphenylsilyl)-carbazol (V3) Verbindung **3** benutzt.

In Tabelle 1 ist ein Vergleich der elektrischen Eigenschaften der OLEDs aus dem Vergleichsbeispiel und dem Diodenbeispiel 1 gezeigt. Durch den Einsatz der Verbindung 3 anstatt der Verbindung V3 wird sowohl die Stromeffizienz als auch die Quanteneffizienz QE erhöht und die Spannung erniedrigt.

In den ersten beiden Spalten der Tabelle 1 werden die Materialien der Matrix einer Emissionsschicht und der Lochblocker-/Excitonenblockerschicht sowie deren Strukturformeln angegeben.

In der rechten Spalte der Tabelle 1 ist der Aufbau der jeweiligen OLED mit den Materialien der verschiedenen Schichten, sowie deren Dicken angegeben. Die Anode ist eine 125 nm ± 20 nm dicke ITO-Schicht, darauf werden
- eine 45 nm dicke Lochleiter-/Excitonenblocker Schicht aus dem Material (V1),
- eine erste, 10 nm dicke Emissionsschicht mit 8,5 Gew% (V2) als Emitter in einer Matrixmaterial aus (V1),
- eine zweite, 40 nm dicke Emissionsschicht mit 8,5 Gew% (V2) als Emitter und (V3) (Vergleichsbeispiel) bzw. 3 (Diodenbeispiel 1) als Matrixmaterial,
- eine 10 nm dicke Lochblocker-/Excitonenblockerschicht aus (V3) (Vergleichsbeispiel) bzw. 3 (Diodenbeispiel 1),
- eine 40 nm dicke Elektronenleiterschicht aus BCP, und
- eine Kathode aus LiF/Aluminium
   abgeschieden.

**Tabelle 1**

| **Material** | **Struktur** | **Stromeffizienz bei 300 cd/m2** | **QE bei 300 cd/m2** | **Spannung bei 300 cd/m2 [V]** | **Aufbau der OLED auf einer ITO-Anode (Dicke = 125 +/-20nm)** (Herstellung analog zum Vergleichsbeispiel) |
|---|---|---|---|---|---|
| V3 | 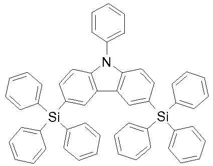 | 100 | 100 | 100 | V1 (45nm)//8,5%V2:V1 (10nm)//8,5%V2:V3 (40 nm)// V3 (10nm)//BCP (40nm)//LiF//Alu |
| **3** | 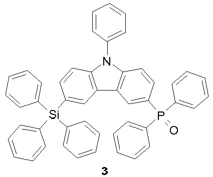 | 157 | 156 | 81 | V1 (45nm)//8,5%V2:V1 (10nm)//8,5%V2:**3** (40 nm)// **3** (10nm)//BCP (40nm)//LiF//Alu |
| **14** | 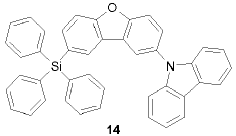 | 142 | 162 | 58 | PEDOT-PSS //V1:MoO3 (10%) (35nm)// V1 (10 nm)// 10%V2:V1 (10nm)//10%V2:**14** (30 nm)// V4 (5nm)//BCP (30nm)//LiF//Alu |

Die Stromeffizienz, Quanteneffizienz und Spannung sind jeweils relative Werte bezogen auf die OLED mit dem Material V3.

PEDOT-PSS wird als Lochinjektionsschicht benutzt (s. Diodenneispiel 16)

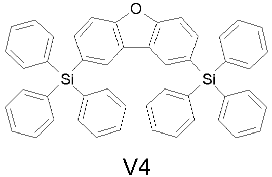

### Diodenbeispiel 2:

Wie im Vergleichsbeispiel, nur wird statt *9-Phenyl-3,6-bis(triphenylsilyl)-carbazol* V3 Verbindung 12 benutzt.

### Diodenbeispiel 3

Gemäß Diodenbeispiel 1, nur dass anstatt des hellblau emittierenden Emittermaterials (V2) ein grün emittierendes Emittermaterial eingesetzt wird, das ausgewählt ist aus Tris(2-phenylpyridin)iridium(III), Tris(2-(-p-tolyl)pyridin)iridium(III) und Bis(2-phenyl-pyridin)(acetylacetonat)iridium(III).

### Diodenbeispiel 4

Gemäß Diodenbeispiel 1, nur dass anstatt des hellblau emittierenden Emittermaterials (V2) ein rot emittierendes Emittermaterial eingesetzt wird, das ausgewählt ist aus: Iridium(III)tris(1-phenylisochinolin), Tris(2-phenylquinolin)iridium (III), Iridium(III)bis(2-2'-benzo-thienyl)pyridinato-N,C³')(acetylacetonat), Iridium(III)bis(1-phenylisochinolin)-(acetylacetonat), Bis(2-phenylquinolin)(acetylacetonat)iridium (III), Iridium(III)bis(di-benzo[f,h]chinoxalin)(acetylacetaonat), Iridium(III)bis(2-methyl-dibenzo[f,h]chinoxalin)-(acetylacetonat), Bis[1-(9,9-dimethyl-9H-fluoren-2-yl)-isoquinolin](acetylacetonat)-iridium(III), Bis(2-benzo[b]thiophen-2-yl-pyridin)(acetylacetonat)iridium(III), Bis(2-phenylbenzothiazolato)(acetylacetonat)iridium(III), Bis(2-(9,9-dihexylfluorenyl)-1-pyridin)(acetylacetonat)iridium (III), Bis[3-(9,9-dimethyl-9H-fluoren-2-yl)-isoquinolin](acetylacetonat)iridium(III), Tris(dibenzoylacetonato)-mono(phenanthrolin)-europium(III), Osmium(II)bis(3-(trifluoromethyl)-5-(4-tert-butylpyridyl)-1,2,4-triazolat)-diphenylmethylphosphin, Osmium(II)bis(3-(trifluoromethyl)-5-(2-pyridyl)-1,2,4-triazol)-dimethylphenylphosphin, Osmium(II)bis(3-(trifluoromethyl)-5-(4-tert-butylpyridyl)-1,2,4-triazolat)dimethylphenylphosphin, Osmium(II)bis(3-(trifluoromethyl)-5-(2-pyridyl)-pyrazolat)dimethylphenylphosphin, Tris[4,4'-die-tert-butyl(2,2')-bipyridin]ruthenium(III), Osmium(II)bis(2-(9,9-dibutylfluorenyl)-1-isoquinolin(acetylacetonat).

### Diodenbeispiel 5

Gemäß Diodenbeispiel 1, nur dass anstatt des Materials für die Lochleiter-/Excitonenblockerschicht (V1) ein Material eingesetzt wird, das ausgewählt ist aus: 4,4',4"-Tris(N,N-diphenylamino)triphenylamin (TDTA), N,N'-Bis(naphthalen-2-yl)-N,N'-bis(phenyl)-benzidin (β-NPB), N,N'-Bis(3-methylphenyl)-N,N'-bis(phenyl)-9,9-spirobifluoren (Spiro-TPD), N,N'-Bis(naphthalen-1-yl)-N,N'-bis(phenyl)-9,9-spirobifluoren (Spiro-NPB), N,N'-Bis(3-methylphenyl)-N,N'-bis(phenyl)-9,9-dimethylfluoren (DMFL-TPD), N,N'-Bis(naphthalen-1-yl)-N,N'-bis(phenyl)-9,9-dimethylfluoren, N,N'-Bis-(naphthalen-1-yl)-N,N'-bis(phenyl)-2,2-dimethylbenzidin, N,N'-Bis(naphthalen-1-yl)-N,N'-bis(phenyl)-benzidin, N,N'-Bis(3-methylphenyl)-N,N'-bis(phenyl)-benzidin, 2,3,5,6-Tetrafluoro-7,7,8,8-tetracyano-quinodimethan (F4-TCNQ), 4,4',4"-Tris(N-3-methylphenyl-N-phenyl-amino)-triphenylamin, 4,4',4"-Tris(N-(2-naphthyl)-N-phenyl-amino)-triphenylamin, Pyrazino[2,3-f][1,10]phenanthrolin-2,3-dicarbonitril (PPDN), N,N,N',N'-Tetrakis(4-methoxyphenyl)benzidin (MeO-TPD), 2,7-Bis[N,N-bis(4-methoxy-phenyl)amino]-9,9-spirobifluoren (MeO-Spiro-TPD), 2,2'-Bis[N,N-bis(4-methoxy-phenyl)amino]-9,9-spirobifluoren (2,2'-MeO-Spiro-TPD), N,N'-di-phenyl-N,N'-di-[4-(N,N-di-tolyl-amino) phenyl]benzidin (NTNPB), N,N'-di-phenyl-N,N'-di-[4-(N,N-diphenyl-amino) phenyl]benzidin (NPNPB), N,N'-di(naphthalen-2-yl)-N,N'-diphenylbenzen-1,4-diamin (β-NPP), N,N'-Bis(3-methylphenyl)-N,N'-bis(phenyl)-9,9-diphenylfluoren (DPFL-TPD), N,N'-Bis(naphthalen-1-yl)-N,N'-bis(phenyl)-9,9-diphenylfluoren (DPFL-NPB), 2,2',7,7'-Tetrakis(N,N-diphenylamino)-9,9'-spirobifluoren (Spiro-TAD), 9,9-Bis[4-N,N-bis-biphenyl-4-yl-amino)phenyl]-9H-fluoren (BPAPF), 9,9-Bis[4-(N,N-bis-naphthalen-2-yl-amino)phenyl]-9H-fluoren (NPAPF), 9,9-Bis[4-(N,N-bis-naphthalen-2-yl-N,N'-bis-phenyl-amino)phenyl]-9H-fluoren (NPBAPF), 2,2',7,7'-Tetrakis[N-naphthalenyl(phenyl)-amino]-9,9'-spirobifluoren (Spiro-2NPB), N,N'-bis(phenanthren-9-yl)-N,N'-bis(phenyl)-benzidin (PAPB), 2,7-Bis[N,N-bis(9,9-spirobifluoren-2-yl)-amino]-9,9-spirobifluoren (Spiro-5), 2,2'-Bis[N,N-bis(biphenyl-4-yl)-amino]-9,9-spirobifluoren (2,2'-Spiro-DBP), 2,2'-Bis(N,N-di-phenyl-amino)-9.9-spirobifluoren (Spiro-BPA), 2,2',7,7'-Tetra(N,N-di-tolyl)amino-spiro-bifluoren (Spiro-TTB), N,N,N',N'-tetra-naphthalen-2-yl-benzidin (TNB), Di-[4-(N,N-ditolyl-amino)-phenyl]cyclohexan, Kupferphthalocyanine und Titanoxidphthalocyanine.

### Diodenbeispiel 6

Gemäß Diodenbeispiele 1 und 3 bis 5, wobei als Lochblocker-/Excitonenblockermaterial und/oder Elektronenleitermaterial statt der Verbindungen (V3) oder 3 und BCP ein Material eingesetzt wird, das ausgewählt ist aus: 2,9-Dimethyl-4,7-diphenyl-1,10-phenanthrolin (Bathocuproin, (BCP)), Bis-(2-methyl-8-chinolinato)-4-phenyl-phenylato)-aluminium(III) (BAlq), 2,2',2"-(1,3,5-Benzintriyl)-tris(1-phenyl-1-H-benzimidazol), 2-(4-Biphenylyl)-5-(4-tert-butylphenyl)-1,3,4-oxadiazol, 8-Hydroxyquinolinolato-lithium, 4-(Naphthalen-1-yl)-3,5-diphenyl-4H-1,2,4-triazol, 1,3-Bis[2-(2,2'-bipyridin-6-yl)-1,3,4-oxadiazo-5-yl]benzen, 4,7-Diphenyl-1,10-phenanthrolin, 3-(4-Biphenylyl)-4-phenyl-5-tert-butylphenyl-1,2,4-triazol, 6,6'-Bis[5-(biphenyl-4-yl)-1,3,4-oxadiazo-2-yl]-2,2'-bipyridyl, 2-phenyl-9,10-di(naphthalen-2-yl)-anthracen, 2,7-Bis[2-(2,2'-bipyridin-6-yl)-1,3,4-oxadiazo-5-yl]-9,9-dimethylfluoren, 1,3-Bis[2-(4-tert-butylphenyl)-1,3,4-oxadiazo-5-yl]benzen, 2-(Naphthalen-2-yl)-4,7-diphenyl-1,10-phenanthrolin, Tris(2,4,6-trimethyl-3-(pyridin-3-yl)phenyl)Boran, 2,9-Bis(naphthalen-2-yl)-4,7-diphenyl-1,10-phenanthrolin, 1-methyl-2-(4-(naphthalen-2-yl)phenyl)-1H-imidazo[4,5-f][1,10]phenanthrolin.

### Diodenbeispiel 7

Gemäß Diodenbeispiel 1 mit einer ersten zusätzlichen Emissionsschicht, die rotes Licht emittiert und einer zweiten zusätzlichen Emissionsschicht, die grünes Licht emittiert. Die erste und zweite zusätzlichen Emissionsschichten sind zusammen mit den Emissionsschichten, die hellblaues Licht emittieren und die Materialien (V2) als Emitter und 3 und (V1) als Matrixmaterial umfassen, zwischen der Anode und der Kathode angeordnet und enthalten neben den Emittermaterialien jeweils Matrixmaterialien wie Ladungsträgertransportmaterialien und/oder Ladungsträgerblockermaterialien. Diese OLED weist eine Emission auf, die sich aus der Emission aller Emissionsschichten zusammensetzt und weißes Licht umfasst.

### Diodenbeispiel 8

Verwendung von OLEDs gemäß jeweils einem der Beispiele 1, 3, 4, 5, 6 für ein Bauteil, das weißes Licht emittiert. Hierfür werden mehrere, monochrome OLEDs, die Licht verschiedener Farben emittieren, übereinander gestapelt und mittels "Charge generation layers" (Ladungsträgergenerationsschichten, CGLs) miteinander verbunden. Die CGLs können dabei die Ladungsträger einer OLED zur darüber oder darunter angeordneten OLED transportieren. Die Verbindung **3** wird in den OLEDs als Matrixmaterial und/oder als Lochblocker-/Excitonenblockermaterial eingesetzt.

### Diodenbeispiel 9

Verwendung von OLEDs gemäß jeweils einem der Beispiele 1, 3, 4, 5 oder 6 für ein Bauteil, das weißes Licht emittiert. Hierfür werden mehrere monochrome OLEDs, die Licht verschiedener Farben emittieren, nebeneinander angeordnet, um ein weißes Licht emittierendes Bauteil zu realisieren. Durch entsprechende Ansteuerung kann auch ein farblich abstimmbares Bauteil erhalten werden.

### Diodenbeispiel 10

Gemäß Diodenbeispiel 7, wobei nur eine Emissionsschicht vorhanden ist, die einen roten, einen blauen und einen grünen Emitter sowie als Matrixmaterial die Verbindung **3** enthält. Damit wird eine weißes Licht emittierende OLED erhalten, die alle Emitter in einer Schicht aufweist.

### Diodenbeispiel 11

Wie die Diodenbeispiele 1 bis 10, wobei für die erste und/oder zweite Elektrode ein Material gewählt wird, das ausgewählt ist aus Cu, Au, Pt, Ph, Os, Al, Mg, Ca, Ba, Ag, Yb, Fe, Co, Ni, Au, ITO, AZO.

### Diodenbeispiel 12:

Wie im Vergleichsbeispiel, nur wird statt 9-Phenyl-3,6-bis(triphenylsilyl)-carbazol V3 Verbindung **10** benutzt.

### Diodenbeispiel 13:

Wie im Vergleichsbeispiel, nur wird statt 9-Phenyl-3,6-bis(triphenylsilyl)-carbazol V3 Verbindung **17** benutzt.

### Diodenbeispiel 14:

Das als Anode verwendete ITO-Substrat wird zuerst mit kommerziellen Reinigungsmitteln für die LCD-Produktion (Deconex^{®} 20NS und Neutralisationsmittel 25ORGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs. Als nächstes wird die Lochinjektionsschicht AJ20-1000 der Firma Plexcore aus Lösung (-40 nm) aufgespinnt.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter und Excitonenblocker wird Ir(dpbic)₃ (V1) mit einer Dicke von 45 nm auf das Substrat aufgebracht, wovon die ersten 35 nm zur Verbesserung der Leitfähigkeit mit MoOₓ (~50%) dotiert sind. 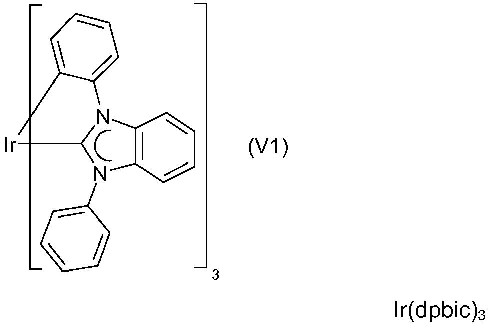 (zur Herstellung siehe Ir-Komplex (7) in der Anmeldung WO 2005/019373).

Anschließend wird eine Mischung aus 15 Gew.-% der Verbindung (V5) 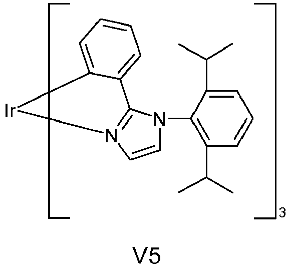 und 85 Gew.-% der Verbindung **28** in einer Dicke von 40 nm aufgedampft, wobei erstere Verbindung als Emittermaterial, letztere als Matrixmaterial fungiert.

Anschließend wird das Material **14** mit einer Dicke von 5 nm als Excitonen- und Lochblocker aufgedampft.

Als nächstes wird als Elektronentransporter eine Mischung von Liq und BCP (2,9-Dimethyl-4,7-diphenyl-1,10-phenantrolin) in einer Dicke von 40 nm, eine 1,0 nm dicke Liq-Schicht und abschließend eine 100 nm dicke Al-Elektrode aufgedampft. Alle Bauteile werden in einer inerten Stickstoffatmosphäre mit einem Glasdeckel verklebt.

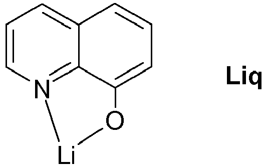

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

| CIE | **Stromeffizienz bei 300 cd/m² Cd/A** | **QE bei 300 cd/m² (%)** | **Spannung bei 300 cd/m² [V]** |
|---|---|---|---|
| 0.19;0.35 | 33.3 | 15.4 | 4.0 |

### Diodenbeispiel 15:

Wie in Beispiel 14, nur wird als Matrixmaterial Verbindung **26** statt Verbindung **28** benutzt und als Excitonen- und Lochblocker Verbindung **26** statt **14.** Die Dotierkonzentration von V5 ist 20% statt 15%.

| CIE | **Stromeffizienz bei 300 cd/m² Cd/A** | **QE bei 300 cd/m² (%)** | **Spannung bei 300 cd/m² [V]** |
|---|---|---|---|
| 0.20;0.35 | 33 | 15 | 5.9 |

### Diodenbeispiel 16:

Das als Anode verwendete ITO-Substrat wird zuerst mit kommerziellen Reinigungsmitteln für die LCD-Produktion (Deconex^{®} 20NS und Neutralisationsmittel 250RGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs. Als nächstes wird die Lochinjektionsschicht PEDOT-PSS (HC-Starck, -40 nm) aufgespinnt.

Danach werden die nachfolgend genannten organischen Materialien mit einer Rate von ca. 0.5-5 nm/min bei etwa 10⁻⁸ mbar auf das gereinigte Substrat aufgedampft. Als Lochleiter und Excitonenblocker wird Ir(dpbic)₃ (V1) mit einer Dicke von 55 nm auf das Substrat aufgebracht, wovon die ersten 35 nm zur Verbesserung der Leitfähigkeit mit MoOₓ (∼50%) dotiert sind. 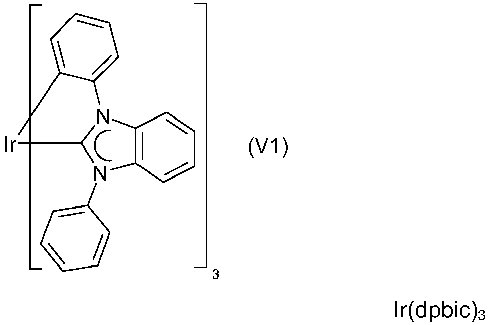 (zur Herstellung siehe Ir-Komplex (7) in der Anmeldung WO 2005/019373).

Anschließend wird eine Mischung aus 15 Gew.-% der Verbindung (V5) 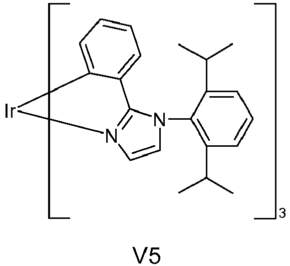 und 85 Gew.-% der Verbindung 28 in einer Dicke von 30 nm aufgedampft, wobei erstere Verbindung als Emittermaterial, letztere als Matrixmaterial fungiert.

Anschließend wird das Material V6 mit einer Dicke von 5 nm als Excitonen- und Lochblocker aufgedampft.

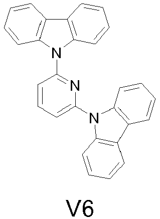

Als nächstes wird als Elektronentransporter Tris(8-chinolinolato)aluminium (Alq₃) mit einer Dicke von 50 nm, eine 1,0 nm dicke LiF-Schicht und abschließend eine 100 nm dicke Al-Elektrode aufgedampft. Alle Bauteile werden in einer inerten Stickstoffatmosphäre mit einem Glasdeckel verklebt.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibration mit einem Luminanzmeter in photometrische Größen umgerechnet werden.

| CIE | **Stromeffizienz bei 300 cd/m² (Cd/A)** | **QE bei 300 cd/m² (%)** | **Spannung bei 300 cd/m² [V]** |
|---|---|---|---|
| 0.19;0.37 | 24.7 | 11.3 | 5.7 |

## Patentansprüche

1. Verbindungen der Formel (I) oder (I*) 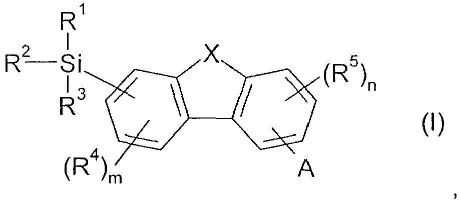 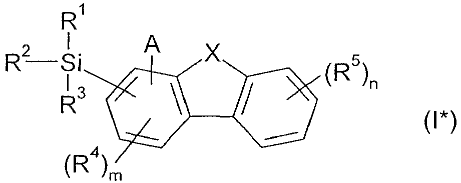 worin bedeuten
X NR, S, O oder PR;
R Aryl, Heteroaryl, Alkyl, Cycloalkyl oder Heterocycloalkyl;
A -NR⁶R⁷, -P(O)R⁸R⁹, -PR¹⁰R¹¹, -S(O)₂R¹², -S(O)R¹³, -SR¹⁴ oder-OR¹⁵;
R¹, R², R³ unabhängig voneinander Aryl, Heteroaryl, Alkyl, Cycloalkyl, Heterocycloalkyl, über einen Spacer angebundene vernetzbare oder polymerisierbare Gruppe, wobei wenigstens einer der Reste R¹, R², R³ mindestens zwei Kohlenstoffatome enthält, oder OR²²,
R⁴, R⁵ unabhängig voneinander Alkyl, Cycloalkyl, Heterocycloalkyl, Aryl, Heteroaryl, über einen Spacer angebundene vernetzbare oder polymerisierbare Gruppe, eine Gruppe A oder eine Gruppe mit Donor- oder Akzeptorwirkung;
n, m unabhängig voneinander 0, 1, 2, 3;
R⁶, R⁷ bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausneue Seite gewählt aus Alkyl, Cycloalkyl, Heterocycloalkyl, Aryl, Heteroaryl, über einen Spacer angebundene vernetzbare oder polymerisierbare Gruppe, und einer Gruppe mit Donor- oder Akzeptorwirkung substituiert sein können;
R²² unabhängig voneinander SiR²³R²⁴R²⁵, Aryl, Heteroaryl, Alkyl, Cycloalkyl oder Heterocycloalkyl, über einen Spacer angebundene vernetzbare oder polymerisierbare Gruppe, gegebenenfalls substituiert mit einer Gruppe OR²⁸
R²⁸ unabhängig voneinander SiR²³R²⁴R²⁵, Aryl, Heteroaryl, Alkyl, Cycloalkyl oder Heterocycloalkyl, über einen Spacer angebundene vernetzbare oder polymerisierbare Gruppe,
R⁸, R⁹, R¹⁰, R¹¹, R¹², R¹³, R¹⁴, R¹⁵, R²³, R²⁴, R²⁵ unabhängig voneinander Aryl, Heteroaryl, Alkyl, Cycloalkyl oder Heterocycloalkyl, über einen Spacer angebundene vernetzbare oder polymerisierbare Gruppe
oder
zwei Einheiten der allgemeinen Formeln (I) und/oder (I*) sind über eine lineare oder verzweigte, gesättigte oder ungesättigte, gegebenenfalls durch wenigstens ein Heteroatom unterbrochene Verbrückung oder über O miteinander verbrückt, wobei diese Verbrückung in den allgemeinen Formeln (I) und/oder (I*) jeweils anstelle von R² an die Si-Atome angebunden ist.

2. Verbindungen der Formel (I) 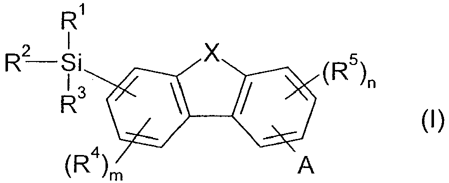 worin bedeuten
X NR, S, O oder PR;
R Aryl, Heteroaryl, Alkyl, Cycloalkyl oder Heterocycloalkyl;
A -NR⁶R⁷, -P(O)R⁸R⁹, -PR¹⁰R¹¹, -S(O)₂R¹², -S(O)R¹³, -SR¹⁴ oder-OR¹⁵;
R¹, R², R³ unabhängig voneinander Aryl, Heteroaryl, Alkyl, Cycloalkyl oder Heterocycloalkyl, wobei mindestens einer der Reste R¹, R² oder R³ Aryl oder Heteroaryl bedeutet;
R⁴, R⁵ unabhängig voneinander Alkyl, Cycloalkyl, Heterocycloalkyl, Aryl, Heteroaryl, eine Gruppe A oder eine Gruppe mit Donor- oder Akzeptorwirkung;
n, m unabhängig voneinander 0, 1, 2, 3;
R⁶, R⁷ bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können;
R⁸, R⁹, R¹⁰, R¹¹, R¹², R¹³, R¹⁴ und R¹⁵ unabhängig voneinander Aryl, Heteroaryl, Alkyl, Cycloalkyl oder Heterocycloalkyl.

3. Verbindungen nach Anspruch 1 oder 2, **dadurch gekennzeichnet, dass** R¹ und/oder R² und/oder R³ aromatische Einheiten der allgemeinen Formeln (Ii) und/oder (Ii*) bedeuten 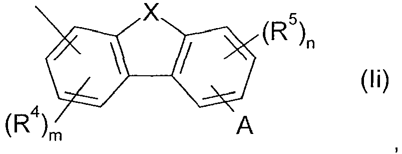 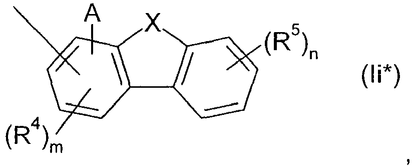 wobei R⁴, R⁵, A, X, n und m die gleichen Bedeutungen wie in Anspruch 1 haben.

4. Verbindungen nach einem der Ansprüche 1 oder 3, **dadurch gekennzeichnet, dass** mindestens einer der Reste R¹, R², R³, R⁴, R⁵, R⁸, R⁹, R¹⁰, R¹¹, R¹², R¹³, R¹⁴, R¹⁵, R²², R²³, R²⁴ oder R²⁵ oder R²⁸ unabhängig voneinander über einen Spacer angebundene polymerisierbare oder vernetzbare Gruppe bedeutet, ausgewählt aus der Gruppe von funktionellen Gruppen, die radikalisch, kationisch oder oder durch Polyaddition oder durch Kupplungsreaktionen polymerisierbar oder vernetzbar sind.

5. Verbindungen nach einem der Ansprüche 1 oder 3, **dadurch gekennzeichnet, dass** wenigstens einer der Reste ausgewählt aus der Gruppe R¹, R² und R³ unabhängig voneinander eine über einen Spacer angebundene polymerisierbare oder vernetzbare Gruppe bedeutet.

6. Verfahren zur Herstellung von Verbindungen der Formel (I) oder (I*) gemäß einem der Ansprüche 1 bis 5, wobei die Reste und Gruppen R, SiR¹R²R³, A und - soweit vorhanden- R⁴ und R⁵ - nach einer der folgenden Varianten a), b), c) oder d) in ein Grundgerüst der Formel (II) eingebracht werden 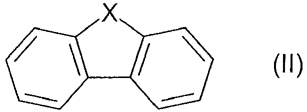 wobei X NR, S, O oder PR oder NH oder PH oder PPh bedeutet,
Variante a)
ia) Herstellung einer zur Einführung der Reste R⁴, R⁵, SiR¹R²R³ und A geeigneten Vorläuferverbindung,
iia) Einbringen des Rests R,
iiia) Einbringen der Reste R⁴, R⁵, soweit vorhanden, sowie der Reste SiR¹R²R³ und A;
oder
Variante b)
ib) Einbringen des Rests R,
iib) Herstellung einer zur Einführung der Reste R⁴, R⁵, SiR¹R²R³ und A geeigneten Vorläuferverbindung,
iiib) Einbringen der Reste R⁴, R⁵, soweit vorhanden, sowie der Reste SiR¹R²R³ und A;
oder
Variante c)
ic) Herstellung einer zur Einführung der Reste R⁴, R⁵, SiR¹R²R³ und A geeigneten Vorläuferverbindung,
iic) Einbringen der Reste R⁴, R⁵, soweit vorhanden, sowie der Reste SiR¹R²R³ und A,
iiic) Einbringen des Rests R;
oder
Variante d)
id) Herstellung einer zur Einführung der Reste R⁴, R⁵, SiR¹R²R³ und A geeigneten Vorläuferverbindung,
iid) Einbringen der Reste R⁴, R⁵, soweit vorhanden, sowie der Reste SiR¹R²R³ und A.

7. Verwendung einer Verbindung der allgemeinen Formeln (I) oder (I*) gemäß einem der Ansprüche 1 oder 3 bis 5 als Bausteine in Polymerisations- und/oder Vernetzungsreaktionen.

8. Verwendung einer Verbindung der allgemeinen Formel (I) oder (I*) gemäß einem der Ansprüche 1 bis 5 in Formulierungen für flüssigprozessierte Anwendungen in der organischen Elektronik.

9. Verfahren zur Herstellung eines vernetzten oder polymerisierten Materials enthaltend wenigstens eine Verbindung der allgemeinen Formeln (I) oder (I*) gemäß einem der Ansprüche 1 oder 3 bis 5 in vernetzer oder polymerisierter Form, umfassend die Schritte:
(A) Herstellen einer vernetzbaren oder polymerisierbaren Verbindung der allgemeinen Formeln (I) oder (I*), wobei wenigstens eines aus R¹, R², R³, R⁴, R⁵, R⁸, R⁹, R¹⁰, R¹¹, R¹², R¹³, R¹⁴, R¹⁵, R²², R²³, R²⁴, R²⁵ oder R²⁸ eine über einen Spacer angebundene vernetzbare oder polymerisierbare Gruppe bedeutet, und
(B) Vernetzung oder Polymerisation der aus Schritt (A) erhaltenen Verbindung der allgemeinen Formeln (I) oder (I*).

10. Vernetztes oder polymerisiertes Material, welches Einheiten der allgemeinen Formel (I) oder (I*) gemäß einem der Ansprüche 1 oder 3 bis 5 in vernetzter oder polymerisierter Form enthält.

11. Verwendung von Verbindungen der Formel (I) oder (I*) nach einem der Ansprüche 1 bis 5, oder eines Materials nach Anspruch 10 in organisch-elektronischen Anwendungen, bevorzugt in organischen Leuchtdioden.

12. Organische Leuchtdiode, enthaltend mindestens eine Verbindung der Formel (I) oder (I*) wie in einem der Ansprüche 1 bis 5 angegeben oder ein Material gemäß Anspruch 10.

13. Organische Leuchtdiode nach Anspruch 12, wobei die Verbindung der Formel (I) oder (I*) die Formel (3) 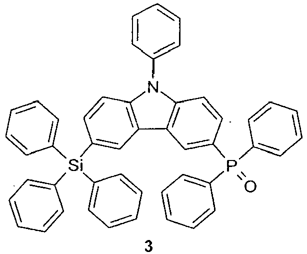 ist.

14. Licht-emittierende Schicht, enthaltend mindestens eine Verbindung der Formel (I) oder (I*) wie in einem der Ansprüche 1 bis 5 angegeben oder ein Material gemäß Anspruch 10.

15. Blockschicht für Löcher/Excitonen, enthaltend mindestens eine Verbindung der Formel (I) oder (I*) wie in einem der Ansprüche 1 bis 5 angegeben oder ein Material gemäß Anspruch 10.

16. Vorrichtung ausgewählt aus der Gruppe bestehend aus stationären Bildschirmen wie Bildschirmen von Computern, Fernsehern, Bildschirmen in Druckern, Küchengeräten sowie Reklametafeln, Beleuchtungen, Hinweistafeln und mobilen Bildschirmen wie Bildschirmen in Handys, Laptops, Digitalkameras, MP3-Playern, Fahrzeugen sowie Zielanzeigen an Bussen und Bahnen; Beleuchtungseinheiten; Tastaturen; Kleidungsstücken; Möbeln; Tapeten enthaltend mindestens eine organische Leuchtdiode gemäß einem der Ansprüche 12 und 13.

## Claims

1. A compound of the formula (I) or (I*) 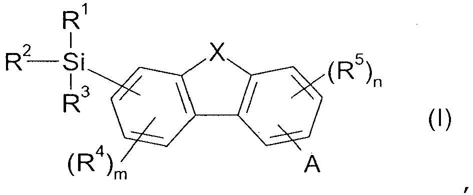 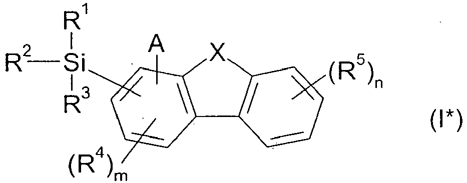 in which
X is NR, S, O or PR;
R is aryl, heteroaryl, alkyl, cycloalkyl or heterocycloalkyl;
A is -NR⁶R⁷, -P(O)R⁸R⁹, -PR¹⁰R¹¹, -S(O)₂R¹², -S(O)R¹³, -SR¹⁴ or -OR¹⁵;
R¹, R², R³ are each independently aryl, heteroaryl, alkyl, cycloalkyl, heterocycloalkyl, a crosslinkable or polymerizable group attached via a spacer, where at least one of the R¹, R², R³ radicals comprises at least two carbon atoms, or OR²²,
R⁴, R⁵ are each independently alkyl, cycloalkyl, heterocycloalkyl, aryl, heteroaryl, a crosslinkable or polymerizable group attached via a spacer, an A group or a group with donor or acceptor action;
n, m are each independently 0, 1, 2, 3;
R⁶, R⁷ together with the nitrogen atom form a cyclic radical which has 3 to 10 ring atoms, which may be unsubstituted or substituted by one or more substituents selected from alkyl, cycloalkyl, heterocycloalkyl, aryl, heteroaryl and a group with donor or acceptor action, and/or may be fused to one or more further cyclic radicals having 3 to 10 ring atoms, where the fused radicals may be unsubstituted or substituted by one or more substituents selected from alkyl, cycloalkyl, heterocycloalkyl, aryl, heteroaryl, a crosslinkable or polymerizable group attached via a spacer, and a group with donor or acceptor action;
R²² is independently SiR²³R²⁴R²⁵, aryl, heteroaryl, alkyl, cycloalkyl or heterocycloalkyl, a crosslinkable or polymerizable group attached via a spacer, optionally substituted by an OR²⁸ group,
R²⁸ is independently SiR²³R²⁴R²⁵, aryl, heteroaryl, alkyl, cycloalkyl or heterocycloalkyl, a crosslinkable or polymerizable group attached via a spacer,
R⁸, R⁹, R¹⁰, R¹¹, R¹², R¹³, R¹⁴, R¹⁵, R²³, R²⁴, R²⁵ are each independently aryl, heteroaryl, alkyl, cycloalkyl or heterocycloalkyl, a crosslinkable or polymerizable group attached via a spacer,
or
two units of the general formula (I) and/or (I*) are bridged to one another via a linear or branched, saturated or unsaturated bridge optionally interrupted by at least one heteroatom or via O, where this bridge in the general formula (I) and/or (I*) is in each case attached to the silicon atoms instead of R².

2. A compound of the formula (I) 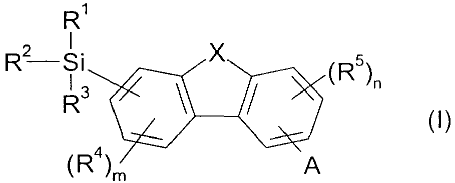 in which
X is NR, S, O or PR;
R is aryl, heteroaryl, alkyl, cycloalkyl or heterocycloalkyl;
A is -NR⁶R⁷, -P(O)R⁸R⁹, -PR¹⁰R¹¹, -S(O)₂R¹²,-S(O)R¹³, -SR¹⁴ or -OR¹⁵;
R¹, R², R³ are each independently aryl, heteroaryl, alkyl, cycloalkyl or heterocycloalkyl, where at least one of the R¹, R² and R³ radicals is aryl or heteroaryl;
R⁴, R⁵ are each independently alkyl, cycloalkyl, heterocycloalkyl, aryl, heteroaryl, an A group or a group with donor or acceptor action;
n, m are each independently 0, 1, 2, 3;
R⁶, R⁷ together with the nitrogen atom form a cyclic radical which has 3 to 10 ring atoms and may be unsubstituted or substituted by one or more substituents selected from alkyl, cycloalkyl, heterocycloalkyl, aryl, heteroaryl and a group with donor or acceptor action, and/or may be fused to one or more further cyclic radicals having 3 to 10 ring atoms, where the fused radicals may be unsubstituted or substituted by one or more substituents selected from alkyl, cycloalkyl, heterocycloalkyl, aryl, heteroaryl and a group with donor or acceptor action;
R⁸, R⁹, R¹⁰, R¹¹, R¹², R¹³, R¹⁴ and R¹⁵ are each independently aryl, heteroaryl, alkyl, cycloalkyl or heterocycloalkyl.

3. A compound according to claim 1 or 2, wherein R¹ and/or R² and/or R³ are aromatic units of the general formula (Ii) and/or (Ii*) 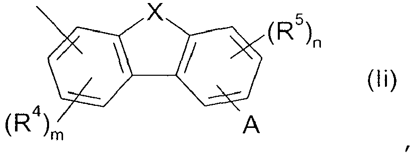 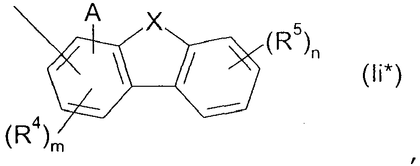 where R⁴, R⁵, A, X, n and m are each as defined in claim 1.

4. A compound according to either of claims 1 and 3, wherein at least one of the R¹, R², R³, R⁴, R⁵, R⁸, R⁹, R¹⁰, R¹¹, R¹², R¹³, R¹⁴, R¹⁵, R²², R²³, R²⁴ or R²⁵ or R²⁸ radicals is independently a polymerizable or crosslinkable group which is attached via a spacer and is selected from the group of functional groups which are polymerizable or crosslinkable free-radically, cationically or by polyaddition or by coupling reactions.

5. A compound according to either of claims 1 and 3, wherein at least one of the radicals selected from the group of R¹, R² and R³ is independently a polymerizable or crosslinkable group attached via a spacer.

6. A process for preparing compounds of the formula (I) or (I*) according to any one of claims 1 to 5, where the R, SiR¹R²R³, A and - where present - R⁴ and R⁵ radicals and groups are introduced into a base skeleton of the formula (II) according to one of the following variants a), b), c) or d) 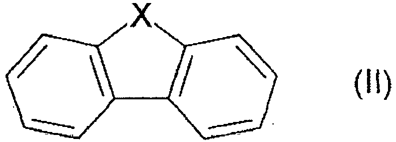 in which X is NR, S, O or PR or NH or PH or PPh,
Variant a)
ia) preparing a precursor compound suitable for introduction of the R⁴, R⁵, SiR¹R²R³ and A radicals,
iia) introducing the R radical,
iiia) introducing the R⁴, R⁵ radicals, where present, and the SiR¹R²R³ and A radicals;
or
Variant b)
ib) introducing the R radical,
iib) preparing a precursor compound suitable for introduction of the R⁴, R⁵, SiR¹R²R³ and A radicals,
iiib) introducing the R⁴, R⁵ radicals, where present, and the SiR¹R²R³ and A radicals;
or
Variant c)
ic) preparing a precursor compound suitable for introduction of the R⁴, R⁵, SiR¹R²R³ and A radicals,
iic) introducing the R⁴, R⁵ radicals, where present, and the SiR¹R²R³ and A radicals,
iiic) introducing the R radical;
or
Variant d)
id) preparing a precursor compound suitable for introduction of the R⁴, R⁵, SiR¹R²R³ and A radicals,
iid) introducing the R⁴, R⁵ radicals, where present, and the SiR¹R²R³ and A radicals.

7. The use of a compound of the general formula (I) or (I*) according to any one of claims 1 and 3 to 5 as units in polymerization and/or crosslinking reactions.

8. The use of a compound of the general formula (I) or (I*) according to any of claims 1 to 5 in formulations for liquid-processed applications in organic electronics.

9. A process for producing a crosslinked or polymerized material comprising at least one compound of the general formula (I) or (I*) according to any one of claims 1 and 3 to 5 in crosslinked or polymerized form, comprising the steps of:
(A) preparing a crosslinkable or polymerizable compound of the general formula (I) or (I*), where at least one of R¹, R², R³, R⁴, R⁵, R⁸, R⁹, R¹⁰, R¹¹, R¹², R¹³, R¹⁴, R¹⁵, R²², R²³, R²⁴, R²⁵ or R²⁸ is a crosslinkable or polymerizable group attached via a spacer, and
(B) crosslinking or polymerizing the compound of the general formula (I) or (I*) obtained from step (A).

10. A crosslinked or polymerized material which comprises units of the general formula (I) or (I*) according to any one of claims 1 and 3 to 5 in crosslinked or polymerized form.

11. The use of compounds of the formula (I) or (I*) according to any one of claims 1 to 5, or of a material according to claim 10, in organic electronics applications, preferably in organic light-emitting diodes.

12. An organic light-emitting diode comprising at least one compound of the formula (I) or (I*) as specified in any one of claims 1 to 5 or a material according to claim 10.

13. The organic light-emitting diode according to claim 12, wherein the compound of the formula (I) or (I*) is the formula (3)

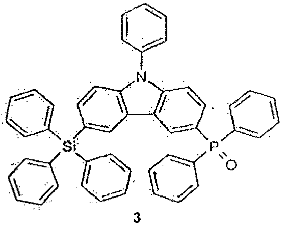

14. A light-emitting layer comprising at least one compound of the formula (I) or (I*) as specified in any one of claims 1 to 5 or a material according to claim 10.

15. A blocking layer for holes/excitons, comprising at least one compound of the formula (I) or (I*) as specified in any one of claims 1 to 5 or a material according to claim 10.

16. A device selected from the group consisting of stationary visual display units such as visual display units of computers, televisions, visual display units in printers, kitchen appliances and advertizing panels, illuminations, information panels and mobile visual display units such as visual display units in cellphones, laptops, digital cameras, MP3 players, vehicles and destination displays on buses and trains; illumination units; keyboards; items of clothing; furniture; carpets, comprising at least one organic light-emitting diode according to either of claims 12 and 13.

## Revendications

1. Composés de formule (I) ou (I*) 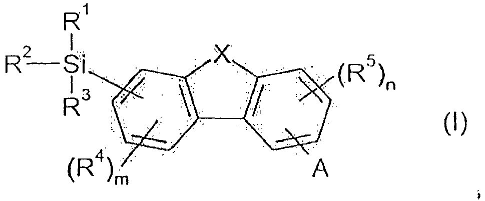 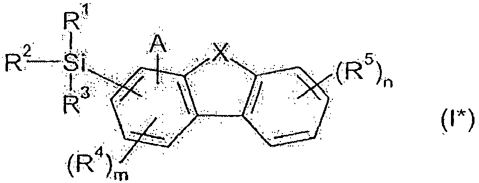 dans lesquelles
X signifie NR, S, 0 ou PR ;
R signifie aryle, hétéroaryle, alkyle, cycloalkyle ou hétérocycloalkyle ;
A signifie -NR⁶R⁷, -P(O)R⁸R⁹, -PR¹⁰R¹¹, -S(O)₂R¹²,-S(O)R¹³, -SR¹⁴ ou -OR¹⁵ ;
R¹, R², R³ signifient, indépendamment les uns des autres, aryle, hétéroaryle, alkyle, cycloalkyle, hétérocycloalkyle, un groupe réticulable ou polymérisable lié via un écarteur, au moins des radicaux R¹, R², R³ contenant au moins deux atomes de carbone, ou OR²²,
R⁴, R⁵ signifient, indépendamment l'un de l'autre, alkyle, cycloalkyle, hétérocycloalkyle, aryle, hétéroaryle, un groupe réticulable ou polymérisable lié via un écarteur, un groupe A ou un groupe doté d'un effet donneur ou accepteur ;
n, m indépendamment l'un de l'autre, valent 0, 1, 2, 3 ;
R⁶, R⁷ forment, ensemble avec l'atome N, un radical cyclique comprenant 3 à 10 atomes de cycle, qui peut être non substitué ou substitué par un ou plusieurs substituants choisis parmi alkyle, cycloalkyle, hétérocycloalkyle, aryle, hétéroaryle et un groupe doté d'un effet donneur ou accepteur et/ou qui peut être annelé avec un ou plusieurs autres radicaux cycliques comprenant 3 à 10 atomes de cycle, les radicaux annelés pouvant être non substitués ou substitués par un ou plusieurs substituants choisis parmi alkyle, cycloalkyle, hétérocycloalkyle, aryle, hétéroaryle, un groupe réticulable ou polymérisable lié via un écarter et un groupe doté d'un effet donneur ou accepteur ;
R²² signifie, indépendamment, SiR²³R²⁴R²⁵, aryle, hétéroaryle, alkyle, cycloalkyle ou hétérocycloalkyle, un groupe réticulable ou polymérisable lié via un écarteur, le cas échéant substitué par un groupe OR²⁸
R²⁸ signifie, indépendamment, SiR²³R²⁴R²⁵, aryle, hétéroaryle, alkyle, cycloalkyle ou hétérocycloalkyle, un groupe réticulable ou polymérisable lié via un écarteur,
R⁸, R⁹, R¹⁰, R¹¹, R¹², R¹³, R¹⁴, R¹⁵, R²³, R²⁴, R²⁵ signifient, indépendamment les uns des autres, aryle, hétéroaryle, alkyle, cycloalkyle ou hétérocycloalkyle, un groupe réticulable ou polymérisable lié via un écarteur ou
deux unités des formules générales (I) et/ou (I*) sont reliées l'une à l'autre via un pont linéaire ou ramifié, saturé ou insaturé, le cas échéant interrompu par au moins un hétéroatome ou reliées l'une à l'autre via O, ce pont étant lié, dans les formules générales (I) et/ou (I*), à chaque fois au lieu de R² aux atomes de Si.

2. Composés de formule (I) 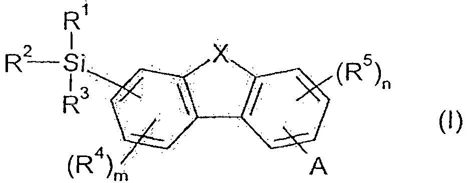 dans laquelle
X signifie NR, S, 0 ou PR ;
R signifie aryle, hétéroaryle, alkyle, cycloalkyle ou hétérocycloalkyle ;
A signifie -NR⁶R⁷, -P(O)R⁸R⁹, -PR¹⁰R¹¹, -S(O)₂R¹², -S(O) R¹³, -SR¹⁴ ou -OR¹⁵ ;
R¹, R², R³ signifient, indépendamment les uns des autres, aryle, hétéroaryle, alkyle, cycloalkyle ou hétérocycloalkyle, au moins des radicaux R¹, R², R³ signifiant aryle ou hétéroaryle ;
R⁴, R⁵ signifient, indépendamment l'un de l'autre, alkyle, cycloalkyle, hétérocycloalkyle, aryle, hétéroaryle, un groupe A ou un groupe doté d'un effet donneur ou accepteur ;
n, m indépendamment l'un de l'autre, valent 0, 1, 2, 3 ;
R⁶, R⁷ forment, ensemble avec l'atome N, un radical cyclique comprenant 3 à 10 atomes de cycle, qui peut être non substitué ou substitué par un ou plusieurs substituants choisis parmi alkyle, cycloalkyle, hétérocycloalkyle, aryle, hétéroaryle et un groupe doté d'un effet donneur ou accepteur et/ou qui peut être annelé avec un ou plusieurs autres radicaux cycliques comprenant 3 à 10 atomes de cycle, les radicaux annelés pouvant être non substitués ou substitués par un ou plusieurs substituants choisis parmi alkyle, cycloalkyle, hétérocycloalkyle, aryle, hétéroaryle et un groupe doté d'un effet donneur ou accepteur ;
R⁸, R⁹, R¹⁰, R¹¹, R¹², R¹³, R¹⁴ et R¹⁵ signifient, indépendamment les uns des autres, aryle, hétéroaryle, alkyle, cycloalkyle ou hétérocycloalkyle.

3. Composés selon la revendication 1 ou 2, **caractérisés en ce que** R¹ et/ou R² et/ou R³ signifient des unités aromatiques des formules générales (Ii) et/ou (Ii*) 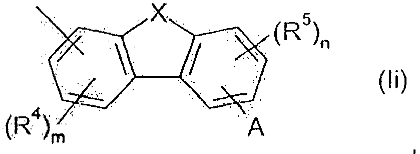 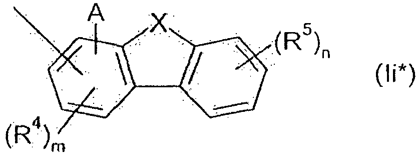 R⁴, R⁵, A, X, n et m présentant les mêmes significations que dans la revendication 1.

4. Composés selon l'une quelconque des revendications 1 ou 3, **caractérisés en ce qu'**au moins un des radicaux R¹ R², R³, R⁴, R⁵, R⁸, R⁹, R¹⁰, R¹¹, R¹², R¹³, R¹⁴, R¹⁵, R²², R²³, R²⁴ ou R²⁵ ou R²⁸ signifie, indépendamment, un groupe polymérisable ou réticulable lié via un écarteur, choisi dans le groupe formé par les groupes fonctionnels, qui sont polymérisables ou réticulables par voie radicalaire, cationique ou par polyaddition ou par des réactions de couplage.

5. Composés selon l'une quelconque des revendications 1 ou 3, **caractérisés en ce qu'**au moins un des radicaux choisis dans le groupe formé par R¹, R² et R³ signifie, indépendamment, un groupe polymérisable ou réticulable lié via un écarteur.

6. Procédé pour la préparation de composés de formule (I) ou (I*) selon l'une quelconque des revendications 1 à 5, les radicaux et les groupes R, SiR¹R²R³, A et - pour autant qu'ils soient présents - R⁴ et R⁵ étant introduits selon l'une des variantes a), b), c) ou d) suivantes dans une structure de base de formule (II) 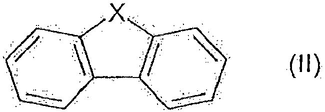 X signifiant NR, S, O ou PR ou NH ou PH ou PPh,
variante a)
ia) préparation d'un composé précurseur approprié pour l'introduction des radicaux R⁴, R⁵, SiR¹R²R³ et A,
iia) introduction du radical R,
iiia) introduction des radicaux R⁴, R⁵, pour autant qu'ils soient présents, ainsi que des radicaux SiR¹R²R³ et A ;
ou
variante b)
ib) introduction du radical R,
iib) préparation d'un composé précurseur approprié pour l'introduction des radicaux R⁴, R⁵, SiR¹R²R³ et A,
iiib) introduction des radicaux R⁴, R⁵, pour autant qu'ils soient présents, ainsi que des radicaux SiR¹R²R³ et A ;
ou
variante c)
ic) préparation d'un composé précurseur approprié pour l'introduction des radicaux R⁴, R⁵, SiR¹R²R³ et A,
iic) introduction des radicaux R⁴, R⁵, pour autant qu'ils soient présents, ainsi que des radicaux SiR¹R²R³ et A,
iiic) introduction du radical R ;
ou
variante d)
id) préparation d'un composé précurseur approprié pour l'introduction des radicaux R⁴, R⁵, SiR¹R²R³ et A,
iid) introduction des radicaux R⁴, R⁵, pour autant qu'ils soient présents, ainsi que des radicaux SiR¹R²R³ et A.

7. Utilisation d'un composé des formules générales (I) ou (I*) selon l'une quelconque des revendications 1 ou 3 à 5 comme éléments dans des réactions de polymérisation et/ou de réticulation.

8. Utilisation d'un composé des formules générales (I) ou (I*) selon l'une quelconque des revendications 1 à 5 dans des formulations pour des applications par traitement liquide dans l'électronique organique.

9. Procédé pour la préparation d'un matériau réticulé ou polymérisé contenant au moins un composé des formules générales (I) ou (I*) selon l'une quelconque des revendications 1 ou 3 à 5 sous forme réticulée ou polymérisée, comprenant les étapes consistant à :
(A) préparer un composé réticulable ou polymérisable des formules générales (I) ou (I*), au moins un des radicaux choisis parmi R¹, R², R³, R⁴, R⁵, R⁸, R⁹, R¹⁰, R¹¹, R¹², R¹³, R¹⁴, R¹⁵, R²², R²³, R²⁴, R²⁵ ou R²⁸ signifiant un groupe réticulable ou polymérisable lié via un écarteur, et
(B) réticuler ou polymériser le composé des formules générales (I) ou (I*) obtenu à partir de l'étape (A).

10. Matériau réticulé ou polymérisé, qui contient des unités des formules générales (I) ou (I*) selon l'une quelconque des revendications 1 ou 3 à 5 sous forme réticulée ou polymérisée.

11. Utilisation de composés des formules (I) ou (I*) selon l'une quelconque des revendications 1 à 5 ou d'un matériau selon la revendication 10 dans des applications organo-électroniques, de préférence dans des diodes électroluminescentes organiques.

12. Diode électroluminescente organique, contenant au moins un composé des formules (I) ou (I*) telles qu'indiquées dans l'une quelconque des revendications 1 à 5 ou un matériau selon la revendication 10.

13. Diode électroluminescente organique selon la revendication 12, le composé des formules (I) ou (I*) présentant la formule (3)

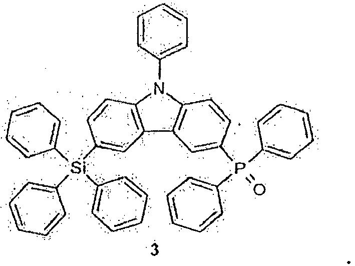

14. Couche électroluminescente, contenant au moins un composé des formules (I) ou (I*) telles qu'indiquées dans l'une quelconque des revendications 1 à 5 ou un matériau selon la revendication 10.

15. Couche de blocage pour des trous/excitons, contenant au moins un composé des formules (I) ou (I*) telles qu'indiquées dans l'une quelconque des revendications 1 à 5 ou un matériau selon la revendication 10.

16. Dispositif choisi dans le groupe constitué par les écrans stationnaires, tels que les écrans d'ordinateurs, de téléviseurs, les écrans dans les imprimantes, les appareils de cuisine ainsi que les panneaux publicitaires, les éclairages, les panneaux indicateurs et les écrans mobiles, tels que les écrans dans les téléphones portables, les ordinateurs portables, les caméras digitales, les lecteurs MP3, les véhicules ainsi que les affichages de destination sur les bus et les trains ; les unités d'éclairage ; les claviers ; les vêtements ; les meubles ; les tapis contenant au moins une diode électroluminescente organique selon l'une quelconque des revendications 12 et 13.
